# EUROPEAN PATENT APPLICATION

(11) **EP 4 836 228 A1**
(43) Date of publication of application: **04.11.2026**
(21) Application number: 24909364.2
(22) Date of filing: 01.02.2024
(51) Int. Cl.: H02J 7/00, H01M 10/44, G01R 31/389

(54) **CURRENT IMBALANCE CONTROL METHOD, CONTROL APPARATUS AND CONTROL DEVICE, AND ENERGY STORAGE SYSTEM**

(30) Priority: 26.12.2023 CN 202311811317; 26.12.2023 CN 202311814038
(71) Applicant: Contemporary Amperex Technology Co., Limited, Ningde, Fujian 352100 (CN)
(72) Inventor: ZUO, Xiyang, Ningde, Fujian 352100 (CN); LI, Zhonghong, Ningde, Fujian 352100 (CN); WU, Kai, Ningde, Fujian 352100 (CN); LI, Lihong, Ningde, Fujian 352100 (CN); HAO, Pan, Ningde, Fujian 352100 (CN); LI, Meng, Ningde, Fujian 352100 (CN); WANG, Songnan, Ningde, Fujian 352100 (CN)
(74) Representative: Ran, Handong
(86) International application number: PCT/CN2024/075287
(87) International publication number: WO 2025/138392

(57) **Abstract**

Provided in the present application are a current imbalance control method, control apparatus and control device, and an energy storage system, which can solve the problem of current imbalance among battery packs. The control method comprises: acquiring DCR of battery packs; and on the basis of the DCR of a plurality of battery packs, determining whether there is current imbalance among the plurality of battery packs. By means of acquiring the DCR of the battery packs and on the basis of the difference between the DCR of the plurality of battery packs connected in parallel, the current imbalance among the plurality of battery packs connected in parallel can be detected and prevented in a timely manner, thereby improving the charging and discharging performance of the entire energy storage system.

## Description

The present application claims priority to Chinese Patent Application No. 202311814038.8, filed with the China National Intellectual Property Administration on December 26, 2023 and entitled "OVERCURRENT CONTROL METHOD AND APPARATUS, BMS, EMS, AND ENERGY STORAGE SYSTEM", and to Chinese Patent Application No. 202311811317.9, filed with the China National Intellectual Property Administration on December 26, 2023 and entitled "OVERCURRENT CONTROL METHOD AND APPARATUS, BATTERY MANAGEMENT SYSTEM, AND ENERGY STORAGE SYSTEM", the content of which is incorporated herein by reference in its entirety.

### TECHNICAL FIELD

The present application relates to the field of batteries, and in particular, to a current imbalance control method, a control apparatus, a control device, and an energy storage system.

### BACKGROUND

Energy storage systems typically require high voltage and large capacity. Therefore, a large number of batteries need to be connected in series/parallel in the energy storage system to form a product such as an electrical cabinet or a container, and the system performs energy exchange with a power grid through a power conversion system (PCS). The battery sets in the energy storage system may be connected in parallel. If a current imbalance occurs among the plurality of battery sets, in one aspect, the current imbalance problem may lead to premature charging and discharging cutoff of the entire energy storage system, affecting the capacity and state of charge of the entire energy storage system; in another aspect, a battery set with an excessively large current may exceed the charging capability window of the battery cell, affecting the safety performance and service life of the battery cell. Therefore, the current imbalance problem of the battery sets needs to be resolved.

### SUMMARY

Embodiments of the present application provide a current imbalance control method, a control apparatus, a control device, and an energy storage system, which can solve the current imbalance problem of battery sets.

According to a first aspect, a current imbalance control method is provided. The control method includes: obtaining a DCR of a battery set; and determining, based on DCRs of a plurality of battery sets, whether a current imbalance occurs among the plurality of battery sets.

In the embodiments of the present application, by obtaining the DCR of the battery set, the current imbalance among the plurality of battery sets connected in parallel is identified and prevented in time based on the differences in the DCRs among the plurality of battery sets connected in parallel, thereby improving the charging and discharging performance of the entire battery sets.

In a possible implementation, obtaining the DCR of the battery set includes: obtaining a state parameter set of the battery set, the state parameter set including at least two state parameters of the battery set; determining a first DCR of the battery set based on the state parameter set of the battery set and a preset correspondence relationship between a plurality of state parameter sets and a plurality of DCRs; and determining a second DCR of the battery set based on the first DCR of the battery set.

In this implementation, by establishing a database including the correspondence relationship between the state parameter sets of the battery set and DCRs, the DCR of the battery set under the current state parameters is determined using the database. The state parameter set includes a plurality of state parameters that may affect the DCR of the battery set, and since the impact of different state parameters on the DCR of the battery set is fully considered, the accuracy of the DCR can be improved.

In a possible implementation, the state parameter set includes at least two of the following state parameters: a state of charge of the battery set, a temperature of the battery set, a current of the battery set, a charging and discharging direction of the battery set, a charging and discharging time of the battery set, and a state of health of the battery set. Therefore, the impact of different influencing factors on the DCR of the battery set is fully considered.

In a possible implementation, determining the second DCR of the battery set based on the first DCR of the battery set includes: determining the first DCR as the second DCR; or calibrating the first DCR based on a preset calibration coefficient to obtain a calibrated second DCR of the battery set.

In this implementation, the first DCR may be directly used as the DCR detection result, or after the DCR of the battery set is obtained, the first DCR of the battery set is calibrated by an appropriate calibration coefficient, and the obtained second DCR is used as the DCR detection result. The calibration coefficient can mitigate the inconsistency in the initial DCRs among different battery cells in the battery set, thereby improving the accuracy of the DCRs.

In a possible implementation, the method further includes: obtaining a state parameter set of the battery set at a target moment after a current moment; and determining a DCR of the battery set at the target moment based on the state parameter set of the battery set at the target moment and the correspondence relationship.

In this implementation, in the case that the state parameters of the battery set under the future operating condition are known, the DCR database can be used to predict the DCR of the battery set under the future operating condition, and risk prediction can be performed based on the DCR. For example, whether a current imbalance may occur among the battery sets is determined in advance, an appropriate strategy is determined in time, and a response is made, thereby reducing the risk caused by an excessive difference in the DCRs among the battery sets.

In a possible implementation, obtaining the DCR of the battery set includes: obtaining information of a voltage and/or a current of the battery set; and determining the DCR of the battery set based on the information of the voltage and/or the current.

In this implementation, the voltage and/or the current of the battery set may be detected, and the DCR of the battery set is determined based on the information of the voltage and/or the current, thereby achieving the dynamic detection of the DCR.

In a possible implementation, obtaining the information of the voltage and/or the current of the battery set includes: obtaining an open-circuit voltage of the battery set; and determining the DCR of the battery set based on the information of the voltage and/or the current includes: determining the DCR of the battery set based on the open-circuit voltage of the battery set, the voltage of the battery set, and the current of the battery set.

In this implementation, through the information of the current OCV, the voltage, and the current of the battery set, the detection of the DCR of the battery set is achieved. Since this detection method for the DCR uses the current voltage and current of the battery set and the current static OCV of the battery set, this method does not rely on the initial voltage of the battery set, and the detection result of the DCR is therefore unaffected by the instability of the initial voltage, resulting in high accuracy. In addition, it allows for a dynamic test on the DCR, such that the DCR of the battery set is obtained in a rapid and accurate manner.

In a possible implementation, obtaining the open-circuit voltage of the battery set includes: obtaining a state of charge of the battery set; and determining the open-circuit voltage of the battery set based on the state of charge of the battery set and a preset correspondence relationship between the open-circuit voltage and the state of charge.

In this implementation, the relationship curve between the OCV and the SOC of the battery set may be pre-built in the BMS software, thereby helping obtain the current OCV of the battery set. When the DCR of the battery set is detected, the OCV corresponding to the SOC may be determined based on the current SOC of the battery set and the relationship curve between the OCV and the SOC, and the OCV is used as the current OCV of the battery set to calculate the DCR of the battery set.

In a possible implementation, determining the DCR of the battery set based on the open-circuit voltage of the battery set, the voltage of the battery set, and the current of the battery set includes: determining a voltage difference between the voltage of the battery set and the open-circuit voltage of the battery set; determining a ratio of the voltage difference to the current of the battery set; and determining the ratio as the DCR of the battery set.

In this implementation, the difference between the current voltage of the battery set and the OCV of the battery set may be calculated, and the ratio of the difference to the current current of the battery set is calculated, such that the ratio is used as the current DCR of the battery set. Since the method for calculating the DCR only uses the current voltage and current of the battery set as well as the current static OCV of the battery set, this method does not rely on the initial voltage of the battery set, resulting in high accuracy. In addition, it allows for a dynamic test on the DCR.

In a possible implementation, obtaining the information of the voltage and/or the current of the battery set includes: controlling a PCS connected to the battery set to charge and discharge the battery set; and obtaining the information of the voltage and the current of the battery set during the charging and discharging; determining the DCR of the battery set based on the information of the voltage and/or the current includes: determining a target DCR based on the current of the battery set and a change in the voltage of the battery set within a target duration.

In this implementation, the PCS is controlled to charge and discharge the battery set, and the DCR of the battery set can be dynamically obtained using the information of the voltage and the current of the battery set during the charging and discharging.

In some possible implementations, determining the target DCR of the battery set based on the voltage information and the current information of the battery set includes: determining the target DCR based on the current of the battery set and the change in the voltage of the battery set within the target duration.

Within the target duration, by charging and discharging the battery set through the PCS, the DCR of the battery set can be effectively calculated based on the current of the battery set and the change in the voltage of the battery set within the target duration, to achieve an online test on the DCR of the battery set.

For example, determining the target DCR based on the current of the battery set and the change in the voltage of the battery set within the target duration includes: determining a ratio of the change in the voltage of the battery set within the target duration to the current of the battery set as the target DCR of the battery set.

In a possible implementation, determining, based on the differences in the DCRs among the plurality of battery sets, whether the current imbalance occurs among the plurality of battery sets includes: in a case that a ratio of a DCR of a first battery set to a DCR of a second battery set in the plurality of battery sets is greater than a preset DCR threshold, determining that the current imbalance occurs among the plurality of battery sets, where the first battery set is a battery set with a maximum DCR in the plurality of battery sets, and the second battery set is a battery set with a minimum DCR in the plurality of battery sets.

In this implementation, when a plurality of battery sets are connected in parallel to a power grid, since the voltages of the plurality of battery sets are the same, based on Ohm's law, the DCR differences among the plurality of battery sets may cause the current differences among the battery sets. As a result, a current imbalance occurs among the plurality of battery sets, thereby affecting the capacity and state of charge of the battery sets. Therefore, whether the current imbalance occurs among the plurality of battery sets may be determined by detecting the differences in the DCRs among the plurality of battery sets connected in parallel, thereby helping identify and prevent the current imbalance among the battery sets connected in parallel in time.

In a possible implementation, the control method further includes: determining, based on power demand of a power grid, a target battery set configured for charging and discharging with the power grid; and determining, based on an overcurrent state of the target battery set, an output power of a power control system connected between the power grid and the target battery set.

In this implementation, based on the power demand of the power grid, the target battery set for charging and discharging with the power grid is determined, and the output power of the corresponding PCS is determined based on the overcurrent state of the target battery set, such that the charging and discharging power of the battery set under each PCS can be dynamically adjusted from the perspective of the whole-station level, thereby reducing the probability of overcurrent in the battery set in the case that the demand of the power grid is met.

In a possible implementation, determining, based on the power demand of the power grid, the target battery set configured for the charging and discharging with the power grid includes: determining, based on the power demand of the power grid, that the target battery set includes all or a part of a plurality of battery sets, where the plurality of battery sets are connected in parallel to the power grid through a plurality of power control systems, respectively.

In this implementation, since the power demand of the power grid changes in different time periods, it is determined whether all battery sets need to participate in charging and discharging currently to meet the power demand of the power grid. In this way, in the case that the power demand of the power grid is met, power waste can be reduced, and an optimal configuration of resources can be achieved.

In a possible implementation, the control method further includes: determining whether an overcurrent occurs in the battery set; and performing current limiting on the battery set based on a degree of overcurrent of the battery set in a case that the overcurrent occurs in the battery set.

In this implementation, if the current imbalance occurs among the plurality of battery sets connected in parallel, an overcurrent may occur in a battery set with a relatively high current. In this case, performing current limiting information on the battery set based on the degree of overcurrent of the battery set can effectively improve the overcurrent condition of the battery set.

In a possible implementation, performing the current limiting on the battery set includes: determining overcurrent information of the battery set; and sending overcurrent indication information to an energy management system, where the overcurrent indication information includes the overcurrent information, and the overcurrent indication information is used to request the energy management system to determine whether to perform the current limiting on the battery set.

In this implementation, the BMS determines the overcurrent level of the battery set, and reports the overcurrent indication information carrying the overcurrent level to the EMS. The EMS determines, based on the overcurrent indication information in combination with the current operating condition, whether to perform current limiting on the battery set. In this way, the overcurrent condition of the battery set can be improved while ensuring that the current operating condition is not affected.

In a possible implementation, the overcurrent information is used to indicate an overcurrent level of the battery set, and determining the overcurrent information of the battery set includes: determining the overcurrent level of the battery set based on an overcurrent ratio of the battery set; or determining the overcurrent level based on the overcurrent ratio and an overcurrent duration of the battery set, where the overcurrent ratio is a ratio of the current of the battery set to an allowable current thereof.

In this implementation, the overcurrent level of the battery set is associated with the ratio by which the current of the battery set exceeds the allowable current thereof. Therefore, the overcurrent level of the battery set may be determined based on the overcurrent ratio of the battery set, which is relatively intuitive. Further, the overcurrent level may be determined with reference to the overcurrent duration.

For example, determining the overcurrent level of the battery set based on the overcurrent ratio and the overcurrent duration of the battery set includes: in the case that the overcurrent ratio of the battery set reaches an overcurrent ratio corresponding to a first overcurrent level and the condition lasts for a first duration, or in the case that the duration of the battery set at a second overcurrent level reaches a second duration, determining that the overcurrent level of the battery set is the first overcurrent level, the overcurrent ratio corresponding to the first overcurrent level being greater than the overcurrent ratio corresponding to the second overcurrent level. In this way, not only the degree of overcurrent but also the overcurrent duration is considered, so that the overcurrent level is determined more in line with actual situations.

In a possible implementation, performing the current limiting on the battery set includes: determining current limiting information corresponding to the overcurrent level based on the overcurrent level, where the overcurrent indication information further includes the current limiting information corresponding to the overcurrent level.

In this implementation, the BMS may determine the desired current limiting information of the battery set based on the overcurrent level of the battery set. The current limiting information may be carried in the overcurrent indication information to serve as a reference for the EMS to determine whether to reduce the power of the battery set.

In a possible implementation, the current limiting information includes a target value of the allowable current of the battery set, and determining the current limiting information corresponding to the overcurrent level based on the overcurrent level includes: determining the target value based on an initial value of the allowable current and a current adjustment ratio corresponding to the overcurrent level, where the current adjustment ratio is a ratio of the target value to the initial value of the allowable current.

In this implementation, corresponding current adjustment ratios may be set for different overcurrent levels, to determine the target value of the allowable current based on the initial value of the allowable current of the battery set and the corresponding current adjustment ratio. As a result, the current limiting on the battery set matches the overcurrent level of the battery set, thereby improving the effect of the current limiting.

In a possible implementation, performing the current limiting on the battery set includes: determining an overcurrent value of the battery set, the overcurrent value comprising a current difference between the current of the battery set and the allowable current thereof and/or a current ratio of the current of the battery set to the allowable current thereof; and adjusting the allowable current of the battery set based on the overcurrent value.

In this implementation, the allowable current of the battery set is adjusted based on the overcurrent value of the battery set, so that the allowable current of the battery set can be adaptively adjusted based on the overcurrent value, thereby improving the overcurrent condition of the battery set.

In a possible implementation, adjusting the allowable current of the battery set based on the overcurrent value includes: adjusting the allowable current of the battery set in a case that the current difference is greater than or equal to a first threshold, and/or the current ratio is greater than or equal to a second threshold.

In this implementation, when both the difference between the actual current and the allowable current of the battery set and the ratio of the actual current to the allowable current of the battery set reach the corresponding thresholds, it can be considered that an overcurrent occurs in the battery set, thereby adjusting the allowable current of the battery set.

In a possible implementation, adjusting the allowable current of the battery set includes: calculating a first product of an allowable current value of a battery set with a minimum allowable current among N battery sets connected in parallel and N, where the N battery sets include the battery set, N being a positive integer; calculating a second product of the current difference and a preset coefficient; calculating a difference between the first product and the second product; and determining an adjusted allowable current of the battery set, the adjusted allowable current being equal to a ratio of the difference to N.

In this implementation, the adjusted allowable current value *Iₐ^{'}* of the battery set is calculated based on *I*ₐ^{'} =(*I*ₘᵢₙ **N*-*D***k*)/*N*, where *I*ₘᵢₙ is the allowable current value of the battery set with the minimum allowable current among a plurality of battery sets connected in parallel including the battery set, N is the number of the plurality of battery sets connected in parallel, D is the current difference between the actual current of the battery set and the allowable current thereof, and k is a preset coefficient. Since the adjusted allowable current *Iₐ^{'}* of the battery set is calculated based on the current difference D between the actual current of a single battery set and the allowable current thereof, and the allowable current *Iₐ* of the battery set is adjusted, the current of another battery set connected in parallel with the battery set will not be affected, thereby reducing the impact on the charging and discharging process of the entire system.

In a possible implementation, determining whether the overcurrent occurs in the battery set includes: determining whether an overcurrent occurs in a plurality of batteries in the battery set; and determining whether the overcurrent occurs in the battery set in a case that the overcurrent occurs in at least one of the plurality of batteries.

In this implementation, whether an overcurrent occurs in the plurality of batteries in the battery set may be preferentially determined, and whether an overcurrent occurs in the battery set is determined in the case that an overcurrent occurs in at least one of the batteries, such that overcurrent information of the battery set is determined in the case that an overcurrent occurs in the battery set.

In a possible implementation, the control method further includes: obtaining a temperature of a first battery system and a temperature of a second battery system in a plurality of battery systems, where the first battery system includes at least one battery cluster, and the second battery system includes at least one battery cluster; and determining a target working mode of a first thermal management assembly and/or a second thermal management assembly based on the temperature of the first battery system and the temperature of the second battery system, where the first thermal management assembly is configured to control the temperature of the first battery system, and the second thermal management assembly is configured to control the temperature of the second battery system.

In this implementation, the working modes of the first thermal management assembly and the second thermal management assembly are determined based on the temperature information of the first battery system and the second battery system. As a result, the first thermal management assembly and the second thermal management assembly effectively control the temperatures of the first battery system and the second battery system respectively, thereby improving the temperature uniformity between the first battery system and the second battery system, and resolving the problem such as imbalance of impedance, current, and the like of the battery system caused by relatively poor temperature uniformity. In addition, the probability of large-current battery systems being fully charged or discharged in advance is reduced, helping improve the conversion efficiency of battery products.

In a possible implementation, the battery set is a battery cluster or an electrical cabinet, or the battery set is a container, where the container includes a plurality of electrical cabinets connected in series and/or in parallel, the battery cluster or the electrical cabinet includes a plurality of electrical boxes connected in series and/or in parallel, and the electrical box includes a plurality of battery cells connected in series and/or in parallel.

According to a second aspect, a current imbalance control apparatus is provided. The control apparatus includes: a detection module, configured to obtain a DCR of a battery set; and a processing module, configured to determine, based on DCRs of a plurality of battery sets, whether a current imbalance occurs among the plurality of battery sets.

According to a third aspect, a current imbalance control device is provided. The control device includes a processor and a memory, where the memory is configured to store instructions, and the processor is configured to execute the instructions to implement the current imbalance control method according to the first aspect or any one of the possible implementations of the first aspect.

According to a fourth aspect, an energy storage system is provided. The energy storage system includes: a plurality of battery sets, where the plurality of battery sets are connected in parallel; and the battery management system according to the third aspect or any one of the possible implementations of the third aspect.

### BRIEF DESCRIPTION OF THE DRAWINGS

To more clearly illustrate the technical solutions according to embodiments of the present application, the drawings required for illustrating the embodiments of the present application are briefly described below. Apparently, the drawings in the following description illustrate merely some embodiments of the present application, and those of ordinary skill in the art may still derive other drawings from these drawings without creative efforts.
FIG. 1 is a schematic diagram of a possible energy storage system according to an embodiment of the present application;
FIG. 2 is a schematic diagram of a possible battery cluster according to an embodiment of the present application;
FIG. 3 is a schematic diagram of a possible electrical box according to an embodiment of the present application;
FIG. 4 is a schematic diagram of a possible energy storage system according to an embodiment of the present application;
FIG. 5 is a schematic flowchart of a current imbalance control method according to an embodiment of the present application;
FIG. 6 is a schematic flowchart of a method for detecting a DCR according to an embodiment of the present application;
FIG. 7 is a schematic diagram of a DCR calculation principle;
FIG. 8 is a schematic diagram of a possible specific implementation of the method shown in FIG. 6;
FIG. 9 is a schematic diagram of a possible test method for an initial DCR of a battery cell;
FIG. 10 is a schematic diagram of a possible specific implementation of the method shown in FIG. 6;
FIG. 11 is a schematic diagram of a possible specific implementation of the method shown in FIG. 6;
FIG. 12 is a schematic flowchart of a method for detecting a DCR according to another embodiment of the present application;
FIG. 13 is a schematic diagram of a relationship curve between the OCV and the SOC of a battery set;
FIG. 14 is a schematic diagram of a possible specific implementation of the method shown in FIG. 12;
FIGs. 15 and 16 are schematic flowcharts of a method for detecting a DCR according to still another embodiment of the present application;
FIG. 17 is a schematic diagram of the architecture of an energy storage system according to an embodiment of the present application;
FIG. 18 is a flowchart of interaction of a possible specific implementation of the method shown in FIGs. 15 and 16;
FIG. 19 is a schematic diagram of a possible specific implementation of the method shown in FIGs. 15 and 16;
FIG. 20 is a schematic flowchart of a power control method according to an embodiment of the present application;
FIG. 21 is a schematic diagram of an energy storage system according to an embodiment of the present application;
FIG. 22 is a schematic diagram of power demand of a power grid in different time periods;
FIG. 23 is a schematic diagram of a possible specific implementation of the method shown in FIG. 20;
FIG. 24 is a schematic flowchart of a method for determining an overcurrent according to an embodiment of the present application;
FIG. 25 is a schematic diagram of a possible specific implementation of the method shown in FIG. 24;
FIG. 26 is a schematic flowchart of an endpoint current limiting method according to an embodiment of the present application;
FIG. 27 is a flowchart of interaction of a possible implementation of the method shown in FIG. 26;
FIG. 28 is a schematic flowchart of an adaptive current limiting method according to an embodiment of the present application;
FIG. 29 is a flowchart of interaction of a possible implementation of the method shown in FIG. 28;
FIG. 30 is a schematic flowchart of a temperature control method according to an embodiment of the present application;
FIGs. 31 and 32 are schematic diagrams of the architecture of a thermal management assembly according to an embodiment of the present application;
FIG. 33 is a flowchart of interaction of a possible implementation of the method shown in FIG. 30;
FIG. 34 is a schematic block diagram of a DCR control apparatus according to an embodiment of the present application; and
FIG. 35 is a schematic block diagram of a DCR control device according to an embodiment of the present application.

### DETAILED DESCRIPTION

Implementations of the present application will be described in further detail with reference to the drawings and embodiments. The following detailed description of the embodiments and the drawings are used for the exemplary illustration of the principles of the present application, but are not intended to limit the scope of the present application. That is, the present application is not limited to the described embodiments.

Energy storage systems typically require high voltage and large capacity. Therefore, a large number of batteries need to be connected in series/parallel in the energy storage system to form a product such as an electrical cabinet or a container, and the system performs energy exchange with a power grid through a power conversion system (PCS). The PCS is configured to achieve the conversion between alternating current signals of the power grid and direct current signals of the energy storage system.

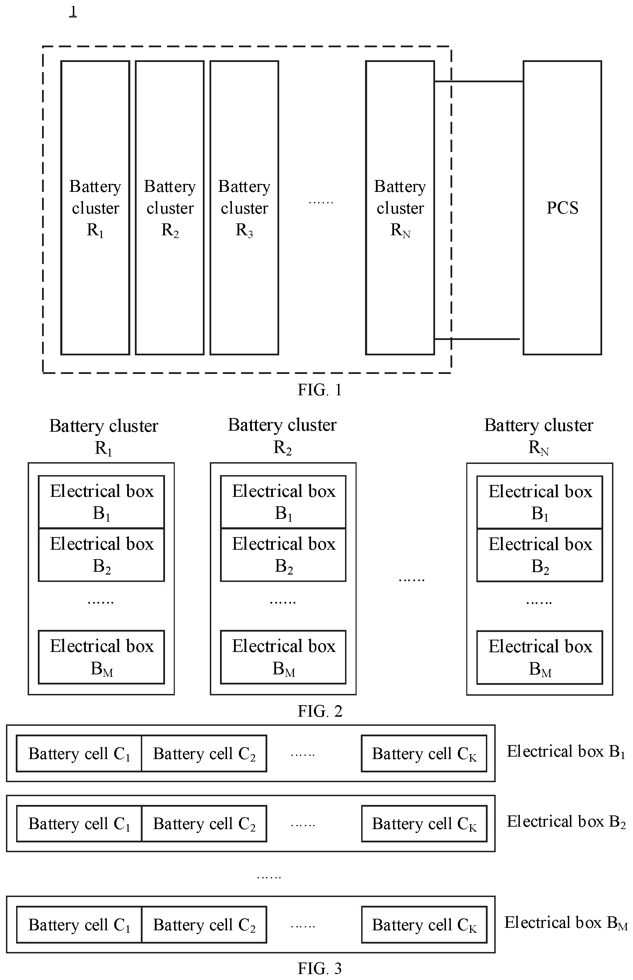

As an example, as shown in FIG. 1, a battery set 1 includes N battery clusters, i.e., a battery cluster R1 to a battery cluster RN, N being a positive integer. The battery cluster R1 to the battery cluster RN are connected in parallel to each other, and perform charging or discharging with the power grid through the PCS. Each battery cluster includes a plurality of electrical boxes. For example, as shown in FIG. 2, each battery cluster from the battery cluster R1 to the battery cluster RN includes M electrical boxes, i.e., an electrical box B1 to an electrical box BM, M being a positive integer. The M electrical boxes are connected in series; or several of the M electrical boxes are first connected in parallel to form a parallel unit, and then a plurality of parallel units are connected in series to form a battery cluster. Each electrical box is formed by assembling K battery cells. For example, as shown in FIG. 3, each electrical box from the electrical box B1 to the electrical box BM includes K battery cells connected in series and/or in parallel, i.e., a battery cell C1 to a battery cell CK.

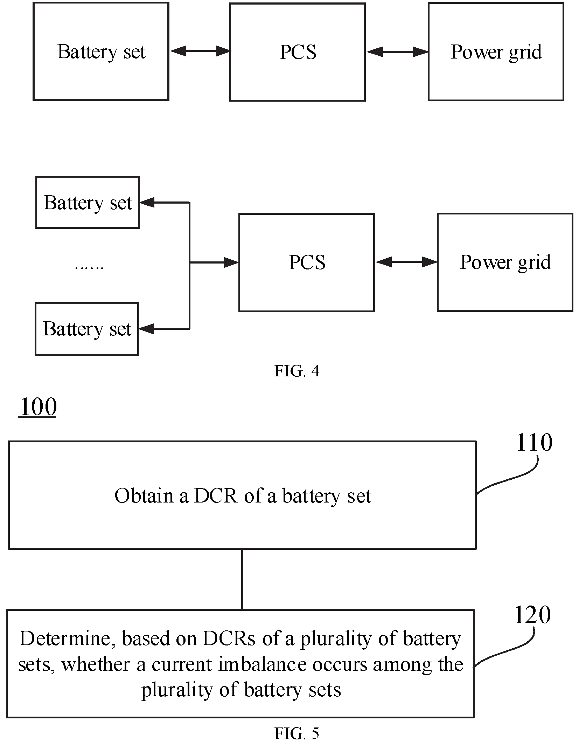

As an example, as shown in FIG. 4, each PCS may be connected to one or a plurality of battery sets, and the plurality of battery sets are connected in parallel to a power grid through the PCS, thereby performing charging or discharging with the power grid. The battery set may be, for example, a battery product such as an electrical cabinet or a container. The electrical cabinet may be considered as a battery product formed by a battery cluster. Therefore, the battery cluster shown in FIG. 1 may also be referred to as an electrical cabinet, and a plurality of electrical cabinets may be assembled to form a battery product such as a container. For example, the electrical cabinet R1 to the electrical cabinet RN shown in FIG. 1 may be connected in parallel to form a container, and a plurality of containers may be connected in parallel to the power grid through the PCS.

A direct current resistance (DCR) of a battery cell in a production process is affected by a plurality of factors, resulting in differences in the DCRs among different battery cells. Consequently, battery sets formed by assembling the battery cells, for example, products such as electrical cabinets or containers, have relatively large differences in DCRs. After the battery sets are connected in parallel to the power grid through the PCS, current differences among branches are caused by differences in the DCRs among the battery sets in the parallel branches, thereby causing a current imbalance among a plurality of battery sets connected in parallel.

Therefore, the present application provides a solution to the current imbalance, aiming to detect the DCR of a battery set and identify and prevent the current imbalance among the plurality of battery sets connected in parallel in time based on the differences in the DCRs among the plurality of battery sets connected in parallel, thereby improving the charging and discharging performance of the entire battery sets.

FIG. 5 shows a schematic flowchart of a current imbalance control method according to an embodiment of the present application. The control method may be executed by, for example, a battery management system (BMS) and/or an energy management system (EMS), and the BMS includes, for example, a master battery management unit (MBMU) and/or a sub-battery management unit (SBMU). As shown in FIG. 5, the method 100 may include some or all of the following steps.

In step 110, the DCR of a battery set is obtained.

In step 120, based on DCRs of a plurality of battery sets, whether a current imbalance occurs among the plurality of battery sets is determined.

By detecting the DCR of the battery set, the current imbalance among the plurality of battery sets connected in parallel can be identified and prevented in time based on the differences in the DCRs among the plurality of battery sets connected in parallel, thereby improving the charging and discharging performance of the entire battery sets.

The battery set according to the embodiments of the present application may be, for example, a battery cluster or an electrical cabinet, or may be a container. The container includes a plurality of electrical cabinets connected in series and/or in parallel, the battery cluster or the electrical cabinet includes a plurality of electrical boxes connected in series and/or in parallel, and each electrical box includes a plurality of battery cells connected in series and/or in parallel. Certainly, a current imbalance may also occur among other units that need to be connected in parallel in the energy storage system, and the current imbalance problem of these units connected in parallel may also be solved by the method 100 according to the embodiments of the present application.

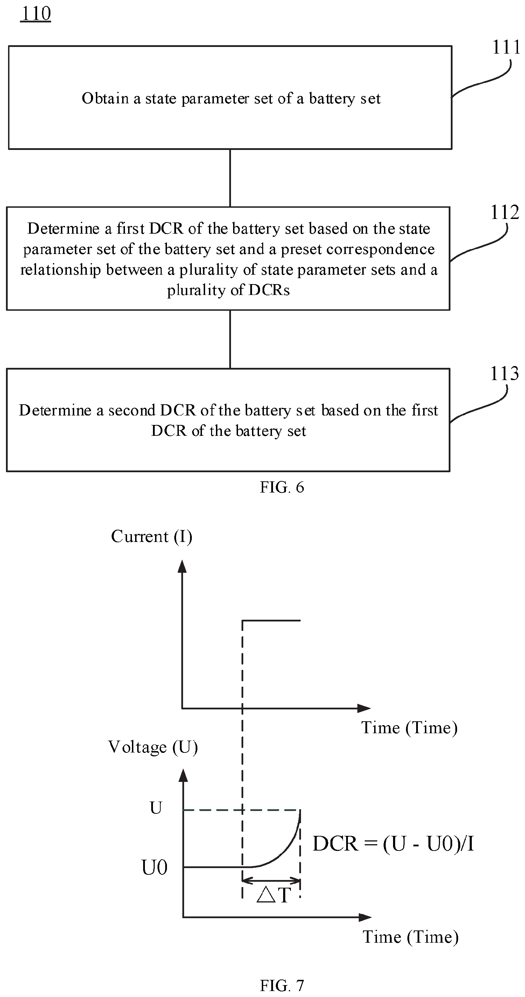

First, how to obtain the DCR of the battery set in step 110 is described with reference to FIGs. 6 to 19. The present application provides two methods for detecting the DCR of the battery set, which are described below.

### Approach 1

In approach 1, by establishing a database including a correspondence relationship between the state parameter sets of the battery set and DCRs, the DCR of the battery set under the current state parameters is determined using the database. The state parameter set includes a plurality of state parameters that may affect the DCR of the battery set, and since the impact of different state parameters on the DCR of the battery set is fully considered, the accuracy of the DCR detection can be improved.

In some embodiments, as shown in FIG. 6, step 110 may include step 111 and step 112.

In step 111, the state parameter set of the battery set is obtained.

In step 112, a first DCR of the battery set is determined based on the state parameter set of the battery set and a preset correspondence relationship between a plurality of state parameter sets and a plurality of DCRs.

In step 113, a second DCR of the battery set is determined based on the first DCR of the battery set.

The state parameter set includes at least one state parameter of the battery set, for example, includes at least one of the following state parameters: a state of charge (SOC) of the battery set, a temperature of the battery set, a current of the battery set, a charging and discharging direction of the battery set, a charging and discharging time of the battery set, a state of health (SOH) of the battery set, and a plurality of state parameters that may affect the DCR of the battery set.

The SOC may represent, for example, the percentage of the remaining capacity of the battery, i.e., the ratio of the current remaining capacity of the battery to the maximum capacity or the rated capacity of the battery; the SOH may represent, for example, the percentage between the capacity of the battery and the factory capacity, which is used to measure the aging state of the battery, i.e., the degree of performance degradation of the battery during use; the charging and discharging direction of the battery set includes charging and discharging, i.e., the polarity of the current; and the charging and discharging time may refer to, for example, the duration of the current.

Due to the electrochemical characteristics of the battery, the internal resistance may be affected by a plurality of factors. To more accurately detect the DCR of the battery set, first, the influencing factors associated with the DCR of the battery set need to be identified. The embodiments of the present application provide a plurality of influencing factors that may affect the DCR of the battery set, which includes the SOC of the battery set, the temperature T of the battery set, the current I of the battery set, the charging and discharging direction of the battery set, the charging and discharging time Time of the battery set, and the SOH of the battery set. For the charging state or the discharging state, the DCR of the battery set is defined as DCR = f (SOC, SOH, I, Time, T, charging and discharging direction), and f is the relationship between these state parameters and DCRs, i.e., the above correspondence relationship between the plurality of state parameter sets and the plurality of DCRs.

The process of establishing the correspondence relationship between the plurality of state parameter sets and the plurality of DCRs is described in detail below.

After the plurality of state parameters that may affect the DCR of the battery are determined, the value of each state parameter in the DCR test process may be designed. For example, as shown in Table 1, for the plurality of state parameters that may affect the DCR, which include the SOC, the temperature, the current, the charging and discharging direction, the charging and discharging time, and the SOH, a reasonable value range matching the actual operating conditions of the battery is set. Here, an example is used in which the charging time is in a range of 5 s to 60 s and the charging current is in a range of 120 A to 180 A. In actual applications, a longer charging time range and/or a larger current range may be set.

**Table 1**

| No. | State parameter | Value of the state parameter |
|---|---|---|
| 1 | SOC | Value taken at every 5% SOC interval |
| 2 | Temperature T | Value taken at every 5% interval within the operating temperature range of the battery |
| 3 | Current I | Value taken at every 5 A interval within the range of 120 A to 180 A |
| 4 | Charging and discharging time T | Value taken at every 5 s interval within the range of 5 s to 60 s |
| 5 | Charging and discharging direction | Charging or discharging |
| 6 | Aging state | Value taken at every 5% SOH interval |

During the test process, the control variable method is used, and according to the value requirements described in Table 1, the value of each of the six state parameters in Table 1 is separately changed to perform a DCR test on a series of values of the state parameter.

For example, a fresh battery cell is taken as a test object with 100% SOH, the test ambient temperature is 25 °C, and the charging current is constant at 140 A in the charging state. Under these conditions, the DCR of the battery cell at different SOCs is tested, and the SOC values include 0%, 5%, 10%, 15%, ..., 95%, and 100%.

First, for the DCR test in the case that the SOC is 0%, the SOC of the battery cell is adjusted to 0%, the battery cell is allowed to rest fully for a duration, such as 2 hours, the battery cell is charged with a current of 140 A for 60 s, and the voltage of the battery cell at a plurality of moments is recorded. For example, as shown in Table 2, in the case that the SOC is 0%, the voltage of the battery cell is recorded at a time interval of 5 s within the charging time of 5 s to 60 s.

**Table 2**

| | | | | | | | | |
|---|---|---|---|---|---|---|---|---|
| Charging and discharging time T/s | 0 | 5 | 10 | 15 | 20 | ...... | 55 | 60 |
| Voltage/V | U₀ | U₅ | U₁₀ | U₁₅ | U₂₀ | ...... | U₅₅ | U₆₀ |

According to Table 2, the DCR of the battery cell under different charging durations can be calculated. As an example, the DCR of the battery cell may be calculated using the DCR test principle shown in FIG. 7. As shown in FIG. 7, after the battery cell is charged with the constant current I for a duration ΔT, the DCR of the battery cell can be determined based on the voltage U and the current I of the battery cell at the moment after the duration ΔT, and the initial voltage U₀ of the battery cell. DCR = (U - U₀)/I.

In Table 2, U₀ is the initial voltage, i.e., the static voltage, then the DCR of the battery cell is DCR₀₁ when the battery cell is charged for 0 s, DCR₀₂ = (U₅ - U₀)/I when the battery cell is charged for 5 s, DCR₀₃ = (U₁₀ - U₀)/I when the battery cell is charged for 10 s, DCR₀₄ = (U₁₅ - U₀)/I when the battery cell is charged for 15 s, DCR₀₅ = (U₂₀ - U₀)/I, when the battery cell is charged for 20 s, ..., DCR₀₆ = (U₅₅ - U₀)/I when the battery cell is charged for 55 s, and DCR₀₇ = (U₆₀ - U₀)/I when the battery cell is charged for 60 s, where I = 140 A.

In this way, the correspondence relationship between the charging times and the DCRs can be obtained under the conditions of 100% SOH, a test ambient temperature of 25 °C, a constant charging current of 140 A in the charging state, and 0% SOC, as shown in Table 3.

**Table 3**

| | | | | | | | | |
|---|---|---|---|---|---|---|---|---|
| Charging and | 0 | 5 | 10 | 15 | 20 | ...... | 55 | 60 |
| discharging time T/s | | | | | | | | |
| DCR | DCR₀₁ | DCR₀₂ | DCR₀₃ | DCR₀₄ | DCR₀₅ | ...... | DCR₀₆ | DCR₀₇ |

Second, the SOC of the battery cell is adjusted to 5%, and the test is performed according to the above operations. Similarly, the correspondence relationship between the charging times and the DCRs can be obtained under the conditions of 100% SOH, a test ambient temperature of 25 °C, a constant charging current of 140 A in the charging state, and 5% SOC, as shown in Table 3.

Sequentially, the SOC of the battery cell is adjusted according to the 5% SOC interval, and the DCR test is performed according to the above operations. A DCR mapping table can be obtained under the conditions of 100% SOH, a test ambient temperature of 25 °C, a constant charging current of 140 A in the charging state, SOCs of 0%, 5%, 10%, 15%, ..., 95%, and 100%, and charging times of 0 s, 5 s, 15 s, ..., and 60 s. For example, Table 4 shows the correspondence relationship between the state parameter sets and the DCRs, the state parameter sets being composed of the charging time and the SOC.

**Table 4**

| DCR | SOC | | | | | | | | |
|---|---|---|---|---|---|---|---|---|---|
| | | 0% | 5% | 10% | 15% | 20% | ...... | 95% | 100% |
| | 0 | DCR₀₁ | DCR₁₁ | DCR₂₁ | DCR₃₁ | DCR₄₁ | ...... | DCR₅₁ | DCR₆₁ |
| Charging and discharging time | 5 | DCR₀₂ | DCR₁₂ | DCR₂₂ | DCR₃₂ | DCR₄₂ | ...... | DCR₅₂ | DCR₆₂ |
| | 15 | DCR₀₃ | DCR₁₃ | DCR₂₃ | DCR₃₃ | DCR₄₃ | ...... | DCR₅₃ | DCR₆₃ |
| | 20 | DCR₀₄ | DCR₁₄ | DCR₂₄ | DCR₃₄ | DCR₄₄ | ...... | DCR₅₄ | DCR₆₄ |
| T/s | ... ... | ...... | ...... | ...... | ...... | ...... | ...... | ...... | ...... |
| | 55 | DCR₀₅ | DCR₁₅ | DCR₂₅ | DCR₃₅ | DCR₄₅ | ...... | DCR₅₅ | DCR₆₅ |
| | 60 | DCR₀₆ | DCR₁₆ | DCR₂₆ | DCR₃₆ | DCR₄₆ | ...... | DCR₅₆ | DCR₆₆ |

With the same approach, values of remaining state parameters such as the temperature, the current, and the SOH are sequentially changed, and the DCR test on a series of values of other state parameters is completed using the single-factor control variable method. DCR data for all state parameters at different values is summarized to obtain the correspondence relationship between the state parameter sets and the DCRs, the state parameter sets being composed of the SOC, the temperature, the current, the charging and discharging direction, the charging and discharging time, and the SOH, thereby establishing a multi-dimensional full-lifecycle DCR database of the battery.

The DCR database includes the correspondence relationship between a plurality of state parameter sets and the DCRs, and the DCR database may be written into BMS software, for example. In an actual application process, the state parameter set of the battery set may be collected. The state parameter set includes parameters such as the SOC, the temperature, the current, the charging and discharging direction, the charging and discharging time, and the SOH of the battery set. In addition, a DCR corresponding to the parameter value of each state parameter in the state parameter set of the battery set is retrieved from the DCR database stored in the BMS.

The correspondence relationship between each state parameter in the state parameter set and the DCR may be achieved in various forms. For example, the correspondence relationship between each state parameter in the state parameter set and the DCR may be a table of a mapping relationship between the value of each state parameter and the DCR, or may be a curve or a formula used to indicate the correspondence relationship between each state parameter in the state parameter set and the DCR, for example, DCR = *f* (SOC, SOH, I, Time, T, charging and discharging direction), or may be another form that can indicate the correspondence relationship between each state parameter in the state parameter set and the DCR. In Tables 1 to 4, the form of a mapping table is used as an example, and the mapping relationship between each state parameter in the state parameter set and the DCR is stored in the BMS in the form of the mapping table.

In an implementation, in step 112, the DCR corresponding to the state parameter set of the battery set among the plurality of DCRs in the DCR database may be directly determined as the first DCR of the battery set, thereby simply and quickly obtaining the DCR of the battery set.

In another implementation, in step 112, for a parameter value between adjacent values in the DCR database, a DCR corresponding to the parameter value may be calculated using an interpolation algorithm, for example, a linear interpolation algorithm. It is assumed that the state parameter set includes a first state parameter, and the DCR database includes a plurality of values of the first state parameter corresponding to a plurality of DCRs. If the parameter value of the first state parameter in the state parameter set of the battery set is not equal to any one of the plurality of values of the first state parameter in the DCR database, a first value and a second value that are closest to the parameter value of the first state parameter of the battery set may be searched from the plurality of values of the first state parameter in the correspondence relationship, and DCRs corresponding to the first value and the second value are determined, so as to obtain the first DCR corresponding to the parameter value of the first state parameter of the battery set using the interpolation algorithm.

Specifically, in step 112, the first value and the second value that are closest to the parameter value of the first state parameter of the battery set may be determined from the plurality of values of the first state parameter in the DCR database; a DCR corresponding to the first value and a DCR corresponding to the second value are determined based on the first value, the second value, and a correspondence relationship between the first parameter value and DCRs in the DCR database; a DCR corresponding to the parameter value of the first state parameter of the battery set is determined based on the DCR corresponding to the first value and the DCR corresponding to the second value as well as the interpolation algorithm; and the DCR corresponding to the parameter value of the first state parameter of the battery set is determined as the first DCR of the battery set.

Taking the SOC as an example, it is assumed that the parameter values of the state parameters in the current state parameter set of the battery set are as follows: SOH is 100%, the test ambient temperature is 25 °C, the charging current is constant at 140 A in the charging state, the charging duration is 60 s, and the SOC is 8%. If SOCs in the DCR database are at intervals of 5%, DCRs corresponding to 0%, 5%, 10%, 15%, ..., 95%, and 100% SOCs are included. In this case, SOC values closest to 8% SOC are 5% and 10%. The DCR under the conditions of 100% SOH, a test ambient temperature of 25 °C, a constant charging current of 140 A in the charging state, a charging duration of 60 s, and 5% SOC and the DCR under the conditions of 100% SOH, a test ambient temperature of 25 °C, a constant charging current of 140 A in the charging state, a charging duration of 60 s, and 10% SOC may be retrieved, respectively.

Assuming that the values of DCRs corresponding to 5% SOC and 10% SOC are DCR₁₆ and DCR₂₆, respectively, then according to the linear interpolation algorithm, DCR = DCR₁₆ + (DCR₂₆ - DCR₁₆) * (8% - 5%)/(10% - 5%) = DCR₁₆ + 3(DCR₂₆ - DCR₁₆)/20 under the conditions of 100% SOH, a test ambient temperature of 25 °C, a constant charging current of 140 A in the charging state, a charging duration of 60 s, and 8% SOC.

When a plurality of battery sets are connected in parallel to a power grid, since the voltages of the plurality of battery sets are the same, based on Ohm's law, the DCR differences among the plurality of battery sets may cause the current differences among the battery sets. As a result, a current imbalance occurs among the plurality of battery sets, thereby affecting the capacity and state of charge of the entire battery sets. Therefore, in some embodiments, the method 100 may further include: determining, based on the DCRs of the plurality of battery sets connected in parallel, whether the current imbalance occurs among the plurality of battery sets. That is, whether the current imbalance occurs among the plurality of battery sets is determined by detecting the DCRs of the plurality of battery sets connected in parallel, thereby helping identify and prevent the current imbalance among the battery sets connected in parallel in time.

Optionally, whether the current imbalance occurs among the plurality of battery sets may be determined based on the differences in the DCRs among the plurality of battery sets connected in parallel, for example, based on the difference between the DCR of the first battery set in the battery sets and the DCR of the second battery set in the battery sets. The first battery set is a battery set with the maximum DCR in the plurality of battery sets, and the second battery set is a battery set with the minimum DCR in the plurality of battery sets.

For example, the current imbalance among the plurality of battery sets may be determined in the case that the ratio of the DCR of the first battery set in the plurality of battery sets to the DCR of the second battery set in the plurality of battery sets is greater than a corresponding DCR threshold. For another example, the current imbalance among the plurality of battery sets may be determined in the case that the difference between the DCR of the first battery set and the DCR of the second battery set is greater than the corresponding DCR threshold.

In this way, based on the DCR difference between the battery set with the maximum DCR and the battery set with the minimum DCR in the plurality of battery sets, the current imbalance among the plurality of battery sets can be identified in time.

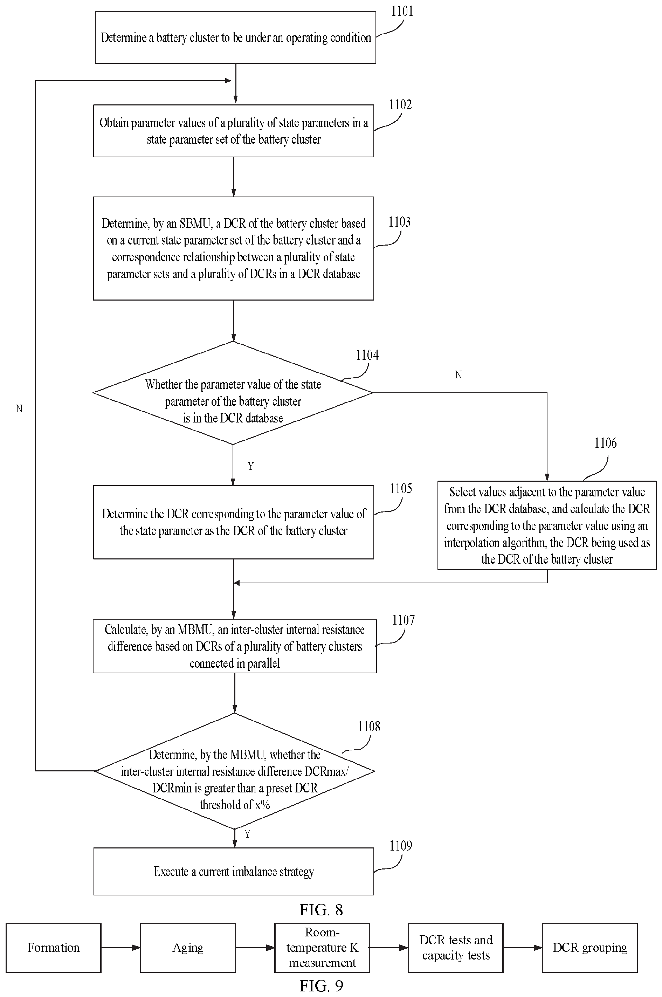

As an example, in the detection process of a DCR shown in FIG. 8, the battery set is exemplified by battery clusters. SBMUs of the battery clusters are responsible for managing the corresponding battery clusters, and uploading related data to an MBMU. The MBMU is responsible for the operation management of an entire system composed of a plurality of battery clusters, and may interact with an external device.

As shown in FIG. 8, in step 1101, a battery cluster is determined to be under an operating condition; that is, the battery cluster is currently being charged or discharged.

In step 1102, parameter values of a plurality of state parameters in the state parameter set of the battery cluster are obtained.

For example, the state parameter set includes parameters such as the SOC, the temperature, the current, the charging and discharging direction, the charging and discharging time, and the SOH.

In step 1103, an SBMU determines a DCR of the battery cluster based on the current state parameter set of the battery cluster and a correspondence relationship between a plurality of state parameter sets and a plurality of DCRs in a DCR database.

In step 1104, the SBMU determines whether the parameter value of the state parameter in the current state parameter set of the battery cluster is in the DCR database.

In the case that the parameter value of the state parameter is included in the DCR database, step 1105 is executed. In the case that the parameter value of the state parameter is not included in the DCR database, step 1106 is executed.

In step 1105, the SBMU determines the DCR corresponding to the parameter value of the state parameter as the first DCR of the battery cluster.

In step 1106, the SBMU selects values adjacent to the parameter value from the DCR database, and calculates the DCR corresponding to the parameter value using an interpolation algorithm, and the DCR is used as the first DCR of the battery cluster.

The SBMU may report the first DCR of a corresponding battery cluster to an MBMU.

In step 1107, the MBMU calculates an inter-cluster internal resistance difference based on first DCRs of a plurality of battery clusters connected in parallel.

For example, the internal resistance difference may be represented by DCRmax/DCRmin, where DCRmax and DCRmin represent the maximum DCR and the minimum DCR in the first DCRs of the plurality of battery clusters, respectively.

In step 1108, the MBMU determines whether the inter-cluster internal resistance difference DCRmax/DCRmin is greater than a preset DCR threshold. The DCR threshold is, for example, denoted as x%, where x is a preset value.

In the case that the inter-cluster internal resistance difference DCRmax/DCRmin is greater than the DCR threshold of x%, that is, in the case that DCRmax/DCRmin > x%, step 1109 is executed. In the case that the inter-cluster internal resistance difference DCRmax/DCRmin is less than or equal to the DCR threshold of x%, that is, in the case that DCRmax/DCRmin ≤ x%, the first DCR of the battery cluster continues to be detected.

In step 1109, a current imbalance strategy is executed.

The current imbalance strategy may be, for example, built into BMS software, and is used to reduce a degree of current imbalance among a plurality of battery clusters connected in parallel. For example, currents of some or all battery clusters may be reduced based on a certain strategy.

In some embodiments, in step 113, the first DCR may be determined as a second DCR; or the first DCR is calibrated based on a preset calibration coefficient to obtain a calibrated second DCR of the battery set.

That is, the first DCR may be directly used as the DCR detection result, thereby reducing complexity of the DCR detection; or after the DCR of the battery set is obtained, the first DCR of the battery set is calibrated by an appropriate calibration coefficient, and the obtained second DCR is used as the DCR detection result.

Since the establishment of the DCR database is based on the DCR test results of a few standard battery cells, and in fact, there is a certain distribution pattern in the initial DCRs among different battery cells, the DCR database established based on some of the battery cells cannot be accurately applied to the DCR detection of other battery sets. The first DCR obtained based on the DCR database is processed by the calibration coefficient to obtain the calibrated second DCR, which can mitigate the inconsistency in the initial DCRs among different battery cells in the battery set, thereby improving the accuracy of the DCRs.

As an example, FIG. 9 shows a possible test method for the initial DCR of a battery cell. The initial DCR of the battery cell may generally refer to the DCR obtained after the battery cell is subjected to the test on the production line. As shown in FIG. 9, the battery cell on the production line generally undergoes procedures such as formation, aging, room-temperature coefficient K measurement, DCR tests, capacity tests, and DCR grouping. During the procedure of the DCR test, a battery cell with a certain SOC may be charged for a certain duration. For example, the battery cell may be charged with a constant current for 30 s in the case that the battery cell has an SOC of 20%, and based on the DCR test principle shown in FIG. 6, the DCR of the battery cell is calculated, which may be used as the initial DCR of the battery cell.

Certainly, the ambient temperature during the execution of the DCR testing procedure shown in FIG. 9 may vary. Therefore, optionally, the DCR of the battery cell may be temperature-corrected based on the current temperature of the battery cell to correct the DCR of the battery cell at 25 °C. For example, the initial DCR of the battery cell may be corrected using a relationship between the temperature and the DCR, such as f(T) = 0.007T² - 0.0627T + 1.8401, to obtain a corrected initial DCR, where DCR = [f(25)/f(T)] * the DCR before correction.

In this embodiment, the initial DCR of the battery cell may refer to the initial DCR after temperature correction. The initial DCR of the battery cell may be stored, for example, the initial DCR of the battery cell is uploaded to the system of a manufacturing execution system (MES).

Due to the differences in the initial DCRs among different battery cells, the initial DCRs of the battery cells vary, and the data in the DCR standard library obtained from tests on only some of the battery cells cannot be directly called. Therefore, an appropriate calibration coefficient needs to be set to reduce or eliminate the differences in the initial DCRs among different battery cells to a certain extent.

In some embodiments, the method 100 further includes: obtaining the initial DCRs of the plurality of battery cells in the battery set; obtaining an initial DCR of a standard battery cell; and determining the calibration coefficient based on the initial DCRs of the plurality of battery cells in the battery set and the initial DCR of the standard battery cell.

The standard battery cell is a battery cell for establishing a correspondence relationship, and the initial DCRs of the plurality of battery cells in the battery set and the initial DCR of the standard battery cell are obtained from tests under the same state parameters.

The same state parameters refer to state parameters used during the tests of the initial DCRs of the battery cells on the production line, for example, by charging at a constant current for 30 s under the above 20% SOC condition.

The calibration coefficient may be a calibration coefficient for the battery set, and calibration coefficients corresponding to different battery sets may be the same or different.

The calibration coefficient is determined using the initial DCRs of the plurality of battery cells in the battery set and the initial DCR of the standard battery cell, such that the calibration coefficient can effectively mitigate the inconsistency in the initial DCRs among different battery cells in the battery set.

Optionally, the calibration coefficient may be equal to the ratio of a mean value of the initial DCRs of the plurality of battery cells in the battery set to the initial DCR of the standard battery cell.

In this case, in some embodiments, in step 113, the product of the first DCR and the calibration coefficient may be determined as the second DCR, thereby enabling the first DCR of the battery set to be calibrated in a simple and rapid manner to obtain the calibrated second DCR.

Taking FIGs. 1 to 3 as an example, N battery clusters are assembled to form a battery product such as an electrical cabinet or a container, each of the N battery clusters includes M electrical boxes, and each of the M electrical boxes includes K battery cells. That is, each battery cluster includes M*K battery cells. During the determination of a calibration coefficient corresponding to the battery cluster, a mean value Rₘₑₐₙ of initial DCRs of the M*K battery cells in the battery cluster and the initial DCR of the standard battery cell need to be obtained. For example, if the initial DCR of the standard battery cell for establishing the DCR database is 0.7 mΩ, the calibration coefficient corresponding to the battery cluster may be set to be equal to Rₘₑₐₙ/0.7 mΩ.

During actual production, DCRs at different levels such as a battery cell level, an electrical box level, a battery cluster or electrical cabinet level, and a container level may all be recorded, thereby facilitating production management and control. The initial DCR of the battery cell is obtained using, for example, the DCR testing procedures shown in FIG. 7. Identification information corresponding to the battery cell, for example, a barcode, may be used as an identity tag thereof, and a corresponding initial DCR may be recorded in an MES system. During the assembly of a plurality of battery cells into an electrical box, if the electrical box is not used as an object of a DCR test, a DCR of the electrical box may be calculated based on initial DCRs of the plurality of battery cells in the electrical box during the generation of a barcode corresponding to the electrical box. Similarly, a DCR at the battery cluster or electrical cabinet level may be calculated based on DCRs of a plurality of electrical boxes included in a battery cluster or an electrical cabinet, and the calculated DCR of the electrical cabinet is stored in an SBMU corresponding to the electrical cabinet. A DCR at the container level may be calculated based on DCRs of a plurality of electrical cabinets included in the container, and the calculated DCR of the container is stored in an MBMU corresponding to the container. DCR values of the electrical cabinet or the container may all be stored in a local database or uploaded to a cloud server, and upon subsequently detecting the DCR of the electrical cabinet or the container online, DCR data in the local database or the cloud server may be updated.

During the assembly of a plurality of electrical boxes into a battery cluster, a code scanning device may automatically identify barcodes of the plurality of electrical boxes in the battery cluster. Through the MES system, the barcodes of the battery cells in each electrical box and the initial DCRs obtained after the battery cells are subjected to the DCR tests on the production line may be traced back, and a mean value of the initial DCRs of the battery cells in the battery cluster may be calculated.

The calibration coefficient corresponding to the battery cluster may be determined based on the mean value of the initial DCRs of the battery cells in the battery cluster and the initial DCR of the standard battery cell for establishing the DCR database. For example, the ratio of a mean value Rₘₐₓ of the initial DCRs of the battery cells in the battery cluster to the initial DCR of the standard battery cell may be used as the calibration coefficient. The calibration coefficient corresponding to the battery cluster may be stored in BMS software of the battery cluster. During subsequent use of the calibration coefficient, when needed, the calibration coefficient is read, and the first DCR, which is retrieved from the DCR database and corresponds to a state parameter set of the battery cluster, is multiplied by the calibration coefficient, to obtain the calibrated second DCR. The second DCR is then used as the actual DCR of the battery cluster under the state parameter set for subsequent operations, such as current imbalance determination.

When a plurality of battery sets are connected in parallel to a power grid, since the voltages of the plurality of battery sets are the same, based on Ohm's law, the DCR differences among the plurality of battery sets may cause the current differences among the battery sets. As a result, a current imbalance occurs among the plurality of battery sets, thereby affecting the capacity and state of charge of the entire battery set. Therefore, whether the current imbalance occurs among the plurality of battery sets can be determined based on second DCRs of the plurality of battery sets connected in parallel. That is, whether the current imbalance occurs among the plurality of battery sets is determined by detecting the second DCRs of the plurality of battery sets connected in parallel, thereby helping identify and prevent the current imbalance among the battery sets connected in parallel in time.

Optionally, whether the current imbalance occurs among the plurality of battery sets may be determined based on the differences in the second DCRs among the plurality of battery sets connected in parallel, for example, based on the difference between a second DCR of a first battery set in the battery sets and a second DCR of a second battery set in the battery sets. The first battery set is a battery set with the maximum second DCR in the plurality of battery sets, and the second battery set is a battery set with the minimum second DCR in the plurality of battery sets.

For example, the current imbalance among the plurality of battery sets may be determined in the case that the ratio of the second DCR of the first battery set in the plurality of battery sets to the second DCR of the second battery set in the plurality of battery sets is greater than a corresponding DCR threshold. For another example, the current imbalance among the plurality of battery sets may be determined in the case that the difference between the second DCR of the first battery set and the second DCR of the second battery set is greater than the corresponding DCR threshold.

In this way, based on the DCR difference between the battery set with the maximum DCR and the battery set with the minimum DCR in the plurality of battery sets, the current imbalance among the plurality of battery sets can be identified in time.

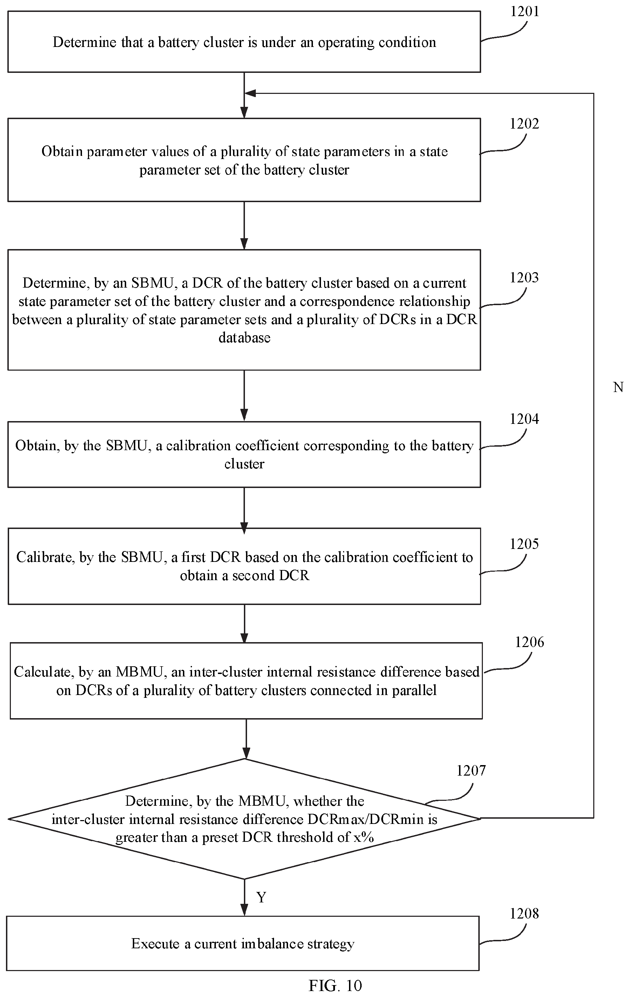

As an example, in the detection process of a DCR shown in FIG. 10, the battery set is exemplified by battery clusters. SBMUs of the battery clusters are responsible for managing corresponding battery clusters, and uploading related data to an MBMU. The MBMU is responsible for the operation management of the entire system composed of a plurality of battery clusters, and may interact with an external device.

As shown in FIG. 10, in step 1201, a battery cluster is determined to be under an operating condition; that is, the battery cluster is currently being charged or discharged.

In step 1202, parameter values of a plurality of state parameters in the state parameter set of the battery cluster are obtained.

For example, the state parameter set includes parameters such as the SOC, the temperature, the current, the charging and discharging direction, the charging and discharging time, and the SOH.

In step 1203, an SBMU determines a first DCR of the battery cluster based on a current state parameter set of the battery cluster and a correspondence relationship between a plurality of state parameter sets and a plurality of DCRs in a DCR database.

In step 1204, the SBMU obtains a calibration coefficient corresponding to the battery cluster.

In step 1205, the SBMU calibrates the first DCR based on the calibration coefficient to obtain a second DCR.

The SBMU may report the second DCR of a corresponding battery cluster to an MBMU.

In step 1206, the MBMU calculates an inter-cluster internal resistance difference based on DCRs of a plurality of battery clusters connected in parallel.

For example, the internal resistance difference may be represented by DCRmax/DCRmin, where DCRmax and DCRmin represent the maximum second DCR and the minimum second DCR in second DCRs of the plurality of battery clusters, respectively.

In step 1207, the MBMU determines whether the inter-cluster internal resistance difference DCRmax/DCRmin is greater than a preset DCR threshold. The DCR threshold is, for example, denoted as x%, where x is a preset value.

In the case that the inter-cluster internal resistance difference DCRmax/DCRmin is greater than the DCR threshold of x%, that is, in the case that DCRmax/DCRmin > x%, step 1208 is executed. In the case that the inter-cluster internal resistance difference DCRmax/DCRmin is less than or equal to the DCR threshold of x%, that is, in the case that DCRmax/DCRmin ≤ x%, the DCR of the battery cluster continues to be detected.

In step 1208, a current imbalance strategy is executed.

The current imbalance strategy may be, for example, built into BMS software, and is used to reduce a degree of current imbalance among a plurality of battery clusters connected in parallel. For example, currents of some or all battery clusters may be reduced based on a certain strategy.

The above DCR database may also be used to predict a DCR of the battery set. For example, in some embodiments, the state parameter set of the battery set at a target moment after the current moment may be obtained, and the DCR of the battery set at the target moment may be determined based on the state parameter set of the battery set at the target moment and a preset correspondence relationship between the plurality of state parameter sets and the plurality of DCRs.

By establishing the DCR database including the correspondence relationship between the state parameter sets of the battery set and the DCRs, the DCR of the battery set at the moment can be determined in the case that the state parameters of the battery set at any moment are known. For example, in the case that the state parameters of the battery set under future operating conditions are known, the DCR database can be used to predict the DCR of the battery set under the future operating conditions, and risk prediction can be performed based on the DCR. For example, whether a current imbalance may occur among the battery sets is determined in advance, an appropriate strategy is determined in time, and a corresponding response is made, thereby reducing the risk caused by an excessive difference in the DCRs among the battery sets.

The target moment of the battery set after the current moment may refer to any moment after the current moment at which the DCR of the battery set needs to be predicted. For example, in the case that the state parameters in the state parameter sets of the battery set change, the DCR of the battery set at the target moment after the current moment is predicted.

A temperature, an SOH, an SOC at the current moment, and the like of the battery set can be calculated by the BMS itself, and the probability that the temperature and the SOH of the battery set change in a short time is low. Therefore, the change in the state parameters mainly includes a change in the current of the battery set, including a change in parameters such as magnitude, a direction, and a duration of the current. In this case, in some embodiments, the EMS may send new current information to the BMS, and the BMS receives, from the EMS, the current information of the battery set at the target moment, such as the magnitude of the current, the duration of the current, and the direction of the current, and determines the SOC of the battery set at the target moment based on the current, the duration of the current, and the direction of the current of the battery set at the target moment, and the SOC of the battery set at the current moment.

For example, the charge and discharge capacity of the battery set from the current moment to the target moment may be determined based on the current, the duration of the current, and the direction of the current of the battery set at the target moment, and the SOC of the battery set at the target moment may be determined based on the SOC and the charge and discharge capacity of the battery set at the current moment.

That is, the SOC of the battery set at the target moment may be calculated based on the current, the direction of the current, and the charging and discharging time of the battery set at the target moment. The battery set receives, from the EMS, a new current I, a duration T of the current I, and a charging and discharging direction, i.e., the polarity of the current I. Assuming that the charging starts from the current moment at the new current I, the charge and discharge capacity ΔQ of the battery set based on the current I within the duration T is defined as ΔQ = I * T/Q, where T is the duration of the charging and discharging based on the current I between the current moment and the target moment, and Q is the capacity, such as a rated capacity or the maximum capacity, of the battery set. If the battery set is charged to the target moment, SOC2 = SOC1 + ΔQ = SOC1 + I * T/Q, where SOC1 is the SOC of the battery set at the current moment, and SOC2 is an SOC value of the battery set at the target moment. If the battery set is discharged to the target moment, SOC3 = SOC1 - ΔQ = SOC1 - I * T/Q, where SOC1 is the SOC of the battery set at the current moment, and SOC3 is an SOC value of the battery set at the target moment.

Then, based on the SOC2 or the SOC3 and other state parameters of the battery set at the target moment, such as the temperature and the SOH, a DCR corresponding to these state parameters is retrieved from the DCR database and is used as the DCR of the battery set at the target moment.

Optionally, the BMS may predict the DCR of the battery set under the changed state parameters upon determining that there is a change in the state parameters of the battery set, such as the parameters related to the current. For example, in the case that the current is known to be charged and discharged based on the new current I from the current moment and continues until the target moment, the BMS may determine the SOC of the battery set at the target moment based on the SOC and the parameters related to the current I of the battery set at the current moment, and predict the DCR of the battery set at the target moment in combination with other state parameters at the target moment. In other embodiments, the BMS may also predict, based on a certain period, the DCR of the battery set at the target moment.

It can be seen that the EMS sends operating condition information at the target moment in advance, which includes, for example, an updated current, and a duration and a direction of the updated current, such that the SOC of the battery set at the target moment can be determined based on the current SOC of the battery set and the updated current, and the duration and the direction of the updated current sent by the EMS. Then, the DCR of the battery set at the target moment is determined in the DCR database including the correspondence relationship between the plurality of state parameter sets and the plurality of DCRs in combination with values of other state parameters at the target moment.

When a plurality of battery sets are connected in parallel to a power grid, since the voltages of the plurality of battery sets are the same, based on Ohm's law, the DCR differences among the plurality of battery sets may cause the current differences among the battery sets. As a result, a current imbalance occurs among the plurality of battery sets, thereby affecting the capacity and state of charge of the battery clusters. Therefore, in some embodiments, the method 100 may further include: determining, based on the DCRs of the plurality of battery sets connected in parallel at the target moment, whether the current imbalance occurs among the plurality of battery sets. That is, whether the current imbalance may occur among the plurality of battery sets at the target moment is predicted by detecting the DCRs of the plurality of battery sets connected in parallel at the target time, thereby helping identify and prevent the current imbalance among the battery sets connected in parallel in time.

Optionally, whether the current imbalance occurs among the plurality of battery sets may be determined based on the differences in the DCRs among the plurality of battery sets connected in parallel at the target moment, for example, based on the difference between a DCR of the first battery set in the plurality of battery sets and a DCR of the second battery set in the plurality of battery sets. The first battery set is a battery set with the maximum DCR in the plurality of battery sets, and the second battery set is a battery set with the minimum DCR in the plurality of battery sets.

For example, the current imbalance among the plurality of battery sets may be determined in the case that the ratio of the DCR of the first battery set in the plurality of battery sets to the DCR of the second battery set in the plurality of battery sets is greater than a corresponding DCR threshold. For another example, the current imbalance among the plurality of battery sets may be determined in the case that the difference between the DCR of the first battery set and the DCR of the second battery set is greater than the corresponding DCR threshold.

In this way, based on the DCR difference between the battery set with the maximum DCR and the battery set with the minimum DCR in the plurality of battery sets, the current imbalance among the plurality of battery sets can be identified in time.

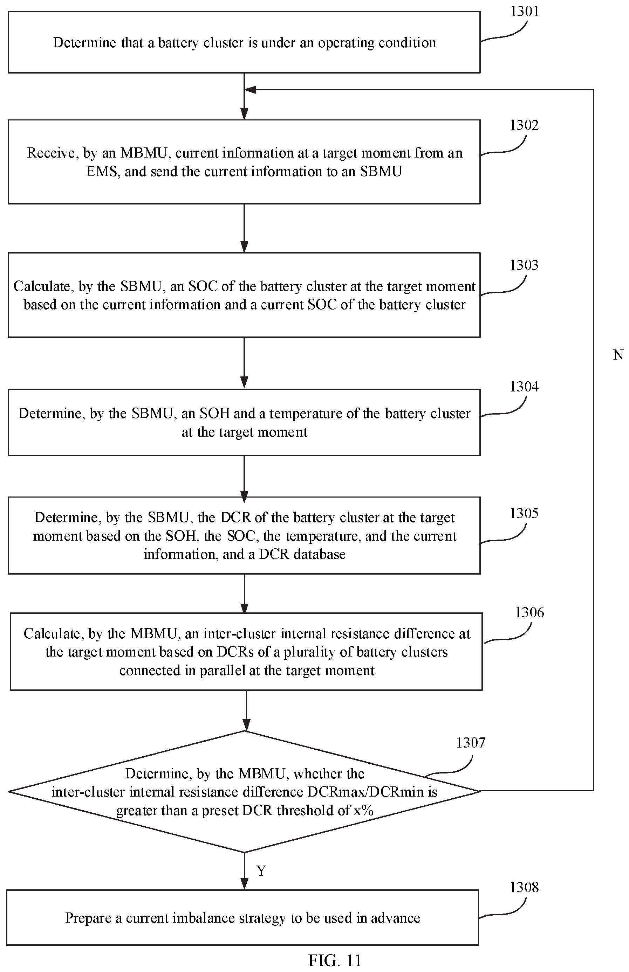

As an example, in the detection process of a DCR shown in FIG. 11, the battery set is exemplified by battery clusters. SBMUs of the battery clusters are responsible for managing corresponding battery clusters, and uploading related data to an MBMU. The MBMU is responsible for the operation management of the entire system composed of a plurality of battery clusters, and may interact with an external device.

As shown in FIG. 11, in step 1301, a battery cluster is determined to be under an operating condition; that is, the battery cluster is currently being charged or discharged.

In step 1302, an MBMU receives, from an EMS, current information at a target moment, which includes, for example, magnitude and a direction of a current I, and a duration T of the current I, and sends the current information to an SBMU.

In step 1303, the SBMU calculates an SOC of the battery cluster at the target moment based on the current information and a current SOC of the battery cluster.

In step 1304, the SBMU determines an SOH and a temperature of the battery cluster at the target moment.

In step 1305, the SBMU determines the actual DCR of the battery cluster at the target moment based on the SOH, the SOC, the temperature, and the current information, such as magnitude, a direction, and a duration of the current of the battery cluster at the target moment, and a DCR database.

For example, the DCR retrieved from the DCR database may be used as the actual DCR of the battery cluster at the target moment. Alternatively, in the case that a parameter value of a certain state parameter at the target moment is not included in the DCR database, values adjacent to the parameter value are selected from the DCR database, and the DCR corresponding to the parameter value is calculated using an interpolation algorithm, which is then used as the actual DCR of the battery cluster at the target moment.

The SBMU may report the DCR of a corresponding battery cluster at the target moment to the MBMU.

In step 1306, the MBMU calculates an inter-cluster internal resistance difference at the target moment based on DCRs of a plurality of battery clusters connected in parallel at the target moment.

For example, the internal resistance difference may be represented by DCRmax/DCRmin, where DCRmax and DCRmin represent the maximum DCR and the minimum DCR in the DCRs of the plurality of battery clusters at the target moment, respectively.

In step 1307, the MBMU determines whether the inter-cluster internal resistance difference DCRmax/DCRmin is greater than a preset DCR threshold. The DCR threshold is, for example, denoted as x%, where x is a preset value.

In the case that the inter-cluster internal resistance difference DCRmax/DCRmin is greater than the DCR threshold of x%, that is, in the case that DCRmax/DCRmin > x%, step 1308 is executed. In the case that the inter-cluster internal resistance difference DCRmax/DCRmin is less than or equal to the DCR threshold of x%, that is, in the case that DCRmax/DCRmin ≤ x%, the DCR of the battery cluster continues to be detected.

In step 1308, a current imbalance strategy to be used is prepared in advance.

The current imbalance strategy may be, for example, built into BMS software, and is used to reduce a degree of current imbalance among a plurality of battery clusters connected in parallel. For example, currents of some or all battery clusters may be reduced based on a certain strategy.

Based on the above description, it can be seen that, in approach 1, by establishing the database including the correspondence relationship between the state parameter sets of the battery set and the DCRs, the DCR of the battery set under the current state parameters is determined using the database. The state parameter set includes a plurality of state parameters that may affect the DCR of the battery set, and since the impact of different state parameters on the DCR of the battery set is fully considered, the accuracy of the DCR can be improved.

In addition, in the case that the state parameters of the battery set under future operating conditions are known, the DCR database can be used to predict the DCR of the battery set under the future operating conditions, and risk prediction can be performed based on the DCR. For example, whether a current imbalance may occur among the battery sets is determined in advance, an appropriate strategy is determined in time, and a response is made, thereby reducing the risk caused by an excessive difference in the DCRs among the battery sets.

Upon obtaining the DCR of the battery set, the DCR of the battery set may also be calibrated by an appropriate calibration coefficient. The calibration coefficient can mitigate the inconsistency in the initial DCRs among different battery cells in the battery set, thereby improving the accuracy of the DCRs.

### Approach 2

In approach 2, the voltage and/or the current of a battery set are detected, and a DCR of the battery set is determined based on information of the voltage and/or the current, thereby achieving the dynamic detection of the DCR.

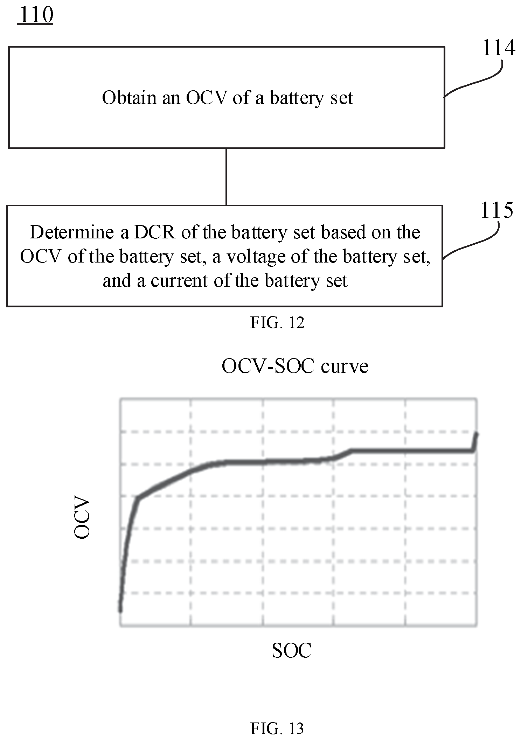

As an approach for dynamically detecting the DCR, for example, as shown in FIG. 12, step 110 may include step 114 and step 115.

In step 114, an open circuit voltage (OCV) of a battery set is obtained.

In step 115, a DCR of the battery set is determined based on the OCV of the battery set, the voltage of the battery set, and the current of the battery set.

The OCV of the battery set refers to the terminal voltage of the battery set in an open-circuit state, is a physical quantity of the battery under a static condition, and may be considered as the static voltage of the battery set.

The voltage and the current of the battery set refer to the voltage and the current of the battery set under actual operating conditions. The operating conditions include the charging or discharging of the battery set.

In the embodiments, the DCR of the battery set is obtained using the information of the current OCV, the voltage, and the current of the battery set. This method does not rely on the initial voltage of the battery set, and the detection result of the DCR is therefore unaffected by the instability of the initial voltage, resulting in high accuracy. In addition, it allows for a dynamic test on the DCR, such that the DCR of the battery set is obtained in a rapid and accurate manner.

In some embodiments, step 114 may further include: obtaining an SOC of the battery set; and determining an OCV of the battery set based on the SOC of the battery set and a preset correspondence relationship between the OCV and the SOC.

For example, the OCV corresponding to the SOC of the battery set is determined as the OCV of the battery set, and is used to determine the DCR of the battery set in the subsequent step 115.

The correspondence relationship between the OCV and the SOC may be achieved in various forms. For example, the correspondence relationship between the OCV and the SOC may be a table of mapping relationships between a plurality of OCV values and a plurality of SOC values, a curve or a formula used to indicate the correspondence relationship between the OCV and the SOC, or another form that can indicate the correspondence relationship between the OCV and the SOC of the battery set.

As an example, for the OCV-SOC curve of the battery shown in FIG. 13, the correspondence relationship between the SOC and the OCV of the battery is represented by the OCV-SOC curve. As shown in FIG. 13, during the charging and discharging of the battery, as the chemical reaction inside the battery continues to progress, the OCV of the battery will also change. Optionally, under the operating condition of the battery, the SOC of the battery may be adjusted at a certain interval, and after the battery is allowed to rest for a certain duration to eliminate polarization, the voltage of the battery is collected. For example, a suitable battery cell may be selected, and the battery cell is charged at a current of 0.05C. After every 5% increase in the SOC, the battery cell is allowed to be stationary for 2 hours or 3 hours to eliminate polarization, and the voltage of the battery cell is collected after the rest, thereby obtaining a plurality of corresponding SOCs and OCVs. By fitting the data of the plurality of corresponding SOCs and OCVs, an OCV-SOC curve, also referred to as a static OCV curve, can be plotted. Similarly, during the discharging, a corresponding OCV-SOC curve can also be obtained in the above manner.

The OCV-SOC curve of the battery set may be pre-built in the software of the BMS, thereby helping obtain the current OCV of the battery set. When the current DCR of the battery set is detected, the OCV corresponding to the current SOC of the battery set may be determined based on the current SOC of the battery set and the OCV-SOC curve, and the OCV is used as the current OCV of the battery set to calculate the DCR of the battery set.

In some embodiments, in step 115, the voltage difference between the voltage of the battery set and the OCV of the battery set may be determined, and the ratio of the voltage difference to the current of the battery set may be determined, thereby determining the ratio of the voltage difference to the current of the battery set as the DCR of the battery set.

Based on the electrochemical polarization principle of the battery, during the charging and discharging of the battery set, a dynamic voltage U of the battery is equal to the sum of the product of a real-time current I of the battery series and a dynamic polarization internal resistance R of the battery set and a static OCV of the battery set; that is, U = OCV + I * R.

Based on this, it can be obtained that R = (U - OCV)/I. Therefore, the DCR of the battery set can be calculated using the static voltage of the battery set, and the information of the voltage and the current collected in real time.

The DCR of the battery set = (U - OCV)/I, where U is a current voltage value of the battery set, I is a current current value of the battery set, and OCV is a static OCV value corresponding to a current SOC of the battery set and retrieved from an OCV-SOC curve based on the SOC.

It can be seen that the difference between the current voltage of the battery set and the OCV is calculated, and the ratio of the difference to the current current of the battery set is calculated, such that the ratio is used as the current DCR of the battery set. The method for calculating the DCR only uses the currently collected information of the voltage and the current of the battery set, as well as the static OCV corresponding to the current SOC of the battery set. This method does not rely on the initial voltage of the battery set, resulting in high accuracy. In addition, it allows for a dynamic test on the DCR.

When a plurality of battery sets are connected in parallel to a power grid, since the voltages of the plurality of battery sets are the same, based on Ohm's law, the DCR differences among the plurality of battery sets may cause the current differences among the battery sets. As a result, a current imbalance occurs among the plurality of battery sets, thereby affecting the capacity and state of charge of the entire battery set. Therefore, in some embodiments, the method 100 may further include: determining, based on the DCRs of the plurality of battery sets connected in parallel, whether the current imbalance occurs among the plurality of battery sets. That is, whether the current imbalance occurs among the plurality of battery sets is determined by detecting the DCRs of the plurality of battery sets connected in parallel, thereby helping identify and prevent the current imbalance among the battery sets connected in parallel in time.

Optionally, whether the current imbalance occurs among the plurality of battery sets may be determined based on the differences in the DCRs among the plurality of battery sets connected in parallel, for example, based on the difference between a DCR of the first battery set in the plurality of battery sets and a DCR of the second battery set in the plurality of battery sets. The first battery set is a battery set with the maximum DCR in the plurality of battery sets, and the second battery set is a battery set with the minimum DCR in the plurality of battery sets.

For example, the current imbalance among the plurality of battery sets may be determined in the case that the ratio of the DCR of the first battery set in the plurality of battery sets to the DCR of the second battery set in the plurality of battery sets is greater than a corresponding DCR threshold. For another example, the current imbalance among the plurality of battery sets may be determined in the case that the difference between the DCR of the first battery set and the DCR of the second battery set is greater than the corresponding DCR threshold.

In this way, based on the DCR difference between the battery set with the maximum DCR and the battery set with the minimum DCR in the plurality of battery sets, the current imbalance among the plurality of battery sets can be identified in time.

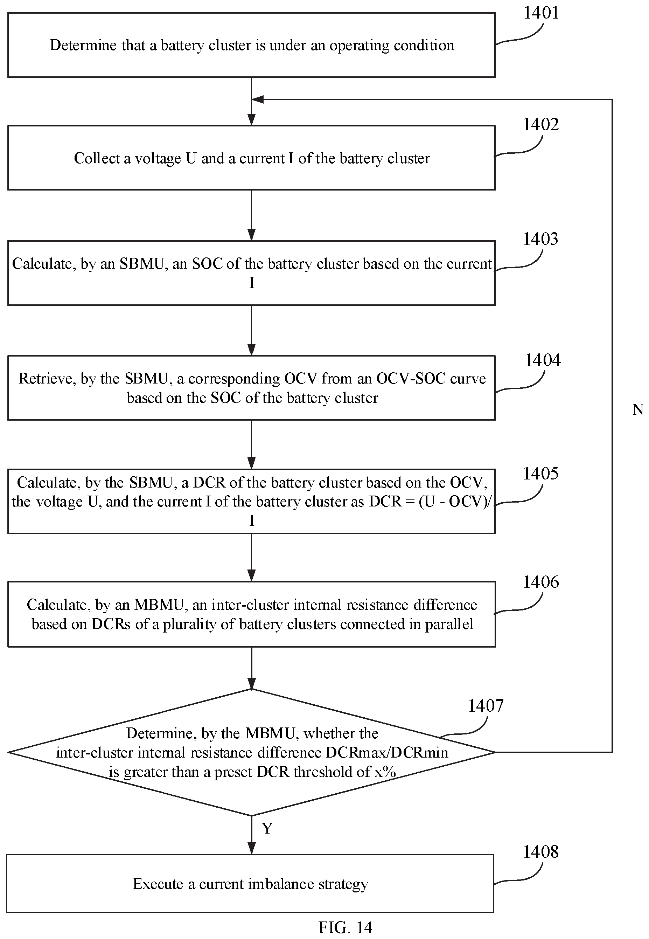

As an example, in the detection process of a DCR shown in FIG. 14, the battery set is exemplified by battery clusters. SBMUs of the battery clusters are responsible for managing corresponding battery clusters, and uploading related data to an MBMU. The MBMU is responsible for the operation management of the entire system composed of a plurality of battery clusters, and may interact with an external device.

As shown in FIG. 14, in step 1401, a battery cluster is determined to be under an operating condition; that is, the battery cluster is currently being charged or discharged.

In step 1402, a voltage U and a current I of the battery cluster are collected.

In step 1403, an SBMU calculates an SOC of the battery cluster based on the current I.

For example, the SOC of the battery cluster may be calculated based on the current, the charging and discharging time, and the charging and discharging direction of the battery cluster. For example, the SOC of the battery cluster = I * T/Q, where T is a charging time, and Q is a capacity of the battery cluster, for example, a rated capacity or the maximum capacity.

In step 1404, the SBMU retrieves a corresponding OCV from an OCV-SOC curve based on the SOC of the battery cluster.

In step 1405, the SBMU calculates a DCR of the battery cluster = (U - OCV)/I based on the OCV, the voltage U, and the current I of the battery cluster.

The SBMU may report the DCR of a corresponding battery cluster to an MBMU.

In step 1406, the MBMU calculates an inter-cluster internal resistance difference based on DCRs of a plurality of battery clusters connected in parallel.

For example, the internal resistance difference may be represented by DCRmax/DCRmin, where DCRmax and DCRmin represent the maximum DCR and the minimum DCR in the DCRs of the plurality of battery clusters, respectively.

In step 1407, the MBMU determines whether the inter-cluster internal resistance difference DCRmax/DCRmin is greater than a preset DCR threshold of x%.

In the case that the inter-cluster internal resistance difference DCRmax/DCRmin is greater than the DCR threshold of x%, that is, in the case that DCRmax/DCRmin > x%, step 1408 is executed. In the case that the inter-cluster internal resistance difference DCRmax/DCRmin is less than or equal to the DCR threshold of x%, that is, in the case that DCRmax/DCRmin ≤ x%, the DCR of the battery cluster continues to be detected.

In step 1408, a current imbalance strategy is executed.

The current imbalance strategy may be, for example, built into BMS software, and is used to reduce a degree of current imbalance among a plurality of battery clusters connected in parallel. For example, currents of some or all battery clusters may be reduced based on a certain strategy.

Based on the above description, it can be seen that the detection on the DCR of the battery set is achieved through the current OCV and the information of the voltage and the current of the battery set. This test process does not rely on the initial voltage of the battery set, and the detection result of the DCR is therefore unaffected by the instability of the initial voltage, resulting in high accuracy. In addition, it allows for a dynamic test on the DCR, such that the DCR of the battery set is obtained in a rapid and accurate manner.

As another approach for dynamically detecting the DCR, the detection of the DCR in step 110 may be achieved by an EMS and/or a BMS.

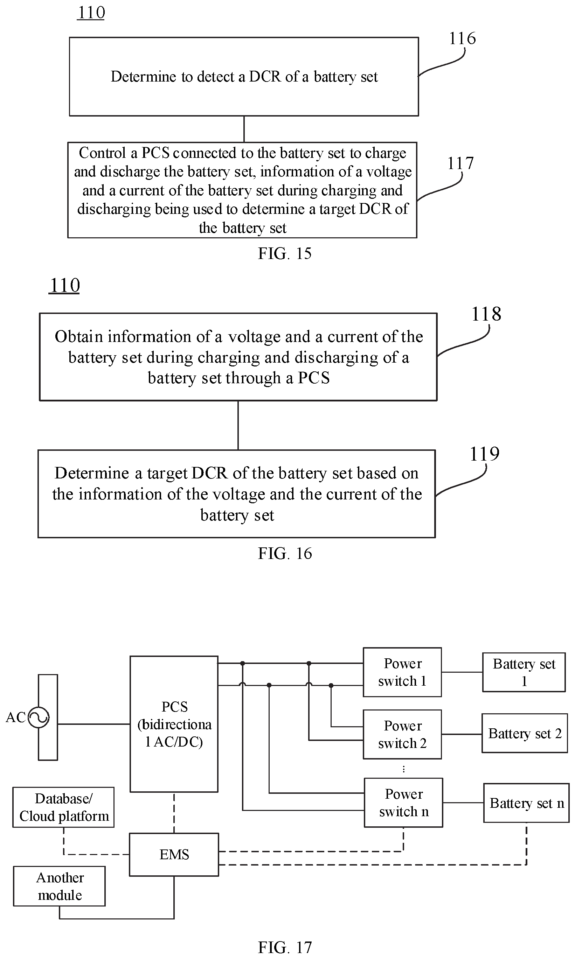

For example, as shown in FIGs. 15 and 16, the method for DCR detection shown in FIG. 15 may be executed by, for example, the EMS, and the method for DCR detection shown in FIG. 16 may be executed by, for example, the BMS or the like of the battery set. Certainly, in a possible implementation, the BMS may execute some of the following operations executed by the EMS, and the EMS may also execute some of the following operations executed by the BMS.

As shown in FIG. 15, the EMS may execute step 116 and step 117.

In step 116, it is determined that a DCR of a battery set is to be detected.

In step 117, a PCS connected to the battery set is controlled to charge and discharge the battery set.

The charging and discharging herein may indicate that a power grid charges the battery set through the PCS, or the battery set discharges to the power grid through the PCS.

For example, upon determining that the DCR of the battery set is to be detected, the EMS controls the PCS connected to the battery set to charge and discharge the battery set. The information of the voltage and the current of the battery set during charging and discharging is used to determine a target DCR of the battery set.

As shown in FIG. 16, the BMS may execute step 118 and step 119.

In step 118, information of the voltage and the current of a battery set are obtained during the charging and discharging of the battery set through a PCS.

In step 119, a target DCR of the battery set is determined based on the information of the voltage and the current of the battery set.

For example, during the charging and discharging of the battery set by the PCS, a BMS collects the information of the voltage and the current of the battery set, and determines the target DCR of the battery set based on the information of the voltage and the current of the battery set. Optionally, the EMS may instruct, by issuing an instruction, the BMS to collect the voltage and the current, and calculate the DCR.

In this way, the PCS is controlled to charge and discharge the battery set, and the DCR of the battery set can be dynamically obtained using the information of the voltage and the current of the battery set during the charging and discharging.

The PCS serves as a medium for connecting the alternating current (AC) side of the power grid and the direct current (DC) side of the battery set, and may include, for example, a bidirectional AC/DC converter. As an example, in the architecture of an energy storage system shown in FIG. 17, a battery set 1, a battery set 2, ..., and a battery set n are connected to the PCS through corresponding power unit 1, power unit 2, ..., and power unit n, respectively. The power unit includes, for example, switches or the like, to connect and disconnect the DC side, and mobilize and control energy of the entire system through the BMS, the PCS, and the EMS. In addition, another module such as a display module may be further configured to achieve a corresponding function. In the embodiments of the present application, by controlling the PCS to charge and discharge the battery set, that is, by charging and discharging the battery through the PCS during corresponding time periods in actual use of the battery set, such as idle time periods, and using the information of the voltage and the current of the battery set during charging and discharging, online detection of the DCR can be achieved. Optionally, the detection result of the DCR may also be uploaded to a local database or a cloud server in a communication manner such as WIFI, Bluetooth, 4G, or 5G, to store and update the DCR of the battery set.

In some embodiments, in step 119, the BMS may determine the target DCR of the battery set based on the current of the battery set and a change in the voltage of the battery set within a target duration. For example, the BMS may determine the ratio of the change in the voltage of the battery set within the target duration to the current of the battery set as the target DCR of the battery set.

The target duration is used to detect the DCR of the battery set, and may be, for example, a duration used by the PCS to charge and discharge the battery set. Within the target duration, by charging and discharging the battery set through the PCS, the DCR of the battery set can be effectively calculated based on the current of the battery set and the change in the voltage of the battery set within the target duration, to achieve an online test on the DCR of the battery set.

For example, as shown in FIG. 7, the EMS controls the PCS to charge or discharge the battery set. Taking the charging of the battery set as an example, the PCS charges the battery set at the current I to reach the target duration ΔT, the voltage of the battery set at a charging start moment is U0, the voltage of the battery set after the charging reaches the target duration ΔT is U, and a change ΔU in the voltage of the battery set within the target duration ΔT is defined as ΔU = U - U0. Based on the change ΔU in the voltage and the current I, it is determined that the target DCR of the battery set = ΔU/I = (U - U0)/I.

In the embodiments, since the battery set needs to be charged or discharged through the PCS for the target duration, in some embodiments, in step 117, the PCS needs to be controlled to charge or discharge the battery set in the case that the battery set is in a resting state.

The battery set is in the resting state, or in other words, in a resting operating condition; that is, there is no charging and discharging demand between the power grid and the battery set. In this case, the PCS is controlled to charge and discharge the battery set to detect the DCR. In this way, the normal charging and discharging of the battery set executed to meet the demand of the power grid is not affected, thereby reducing the impact of DCR detection on the charging and discharging currently being executed between the power grid and the battery set.

Optionally, in step 116, the EMS may determine whether the resting duration of the battery set, i.e., the duration for which the battery set is in the resting state, is greater than or equal to the target duration, and determine to detect the DCR of the battery set in the case that the duration for which the battery set is in the resting state is greater than or equal to the target duration.

That is, in step 117, in the case that the duration for which the battery set is in the resting state is greater than or equal to the target duration, the EMS controls the PCS to charge and discharge the battery set.

Since the change in the voltage of the battery set within the target duration needs to be used, a sufficient duration, i.e., the target duration, needs to be reserved to detect the DCR of the battery set. Therefore, before the DCR detection is performed, there is a need to determine whether the duration for which the battery set can be in the resting state is greater than or equal to the target duration, such that the PCS is used to detect the DCR of the battery set, thereby reducing interruption of the DCR detection caused by the charging and discharging that is suddenly started between the power grid and the battery set.

In some embodiments, the BMS may determine the target duration based on the state parameters of the battery set. The state parameters include, for example, at least one of an SOC, an SOH, and a temperature of the battery set. In this way, the DCR of the battery set under the state parameters can be detected more accurately, thereby improving the accuracy of the detection result.

Generally, the target duration may be set to, for example, less than one minute. Optionally, the target duration may be determined based on the SOC and the SOH of the battery set, the current temperature of the battery set, and the like. For example, for a battery set at 25 °C, with an SOC of 25%, and with a BCL SOH, the battery set is discharged for 30 seconds through the PCS, and a DCR of the battery set is determined based on the ratio of the change in the voltage of the battery set to the discharge current of the battery set within 30 seconds of discharging. For another example, for a battery set at 25 °C, with an SOC of 25%, and with an EOL SOH of 70%, the battery set is discharged for 30 seconds through the PCS, and a DCR of the battery set is determined based on the ratio of the change in the voltage of the battery set to the discharge current of the battery set within 30 seconds of discharging. Generally, a DCR of a battery set with a BOL SOH of 100% is less than a DCR of a battery set with an EOL SOH of 70%. For a battery set with the above state parameters, its DCR is on the order of milliohms.

Optionally, the BMS may determine the target duration in the case that the battery set is at rest, and send the target duration to the EMS. Correspondingly, the EMS receives the target duration sent by the BMS, determines whether the duration for which the battery set is in the resting state is greater than or equal to the target duration, and then determines whether to perform the DCR detection on the battery set.

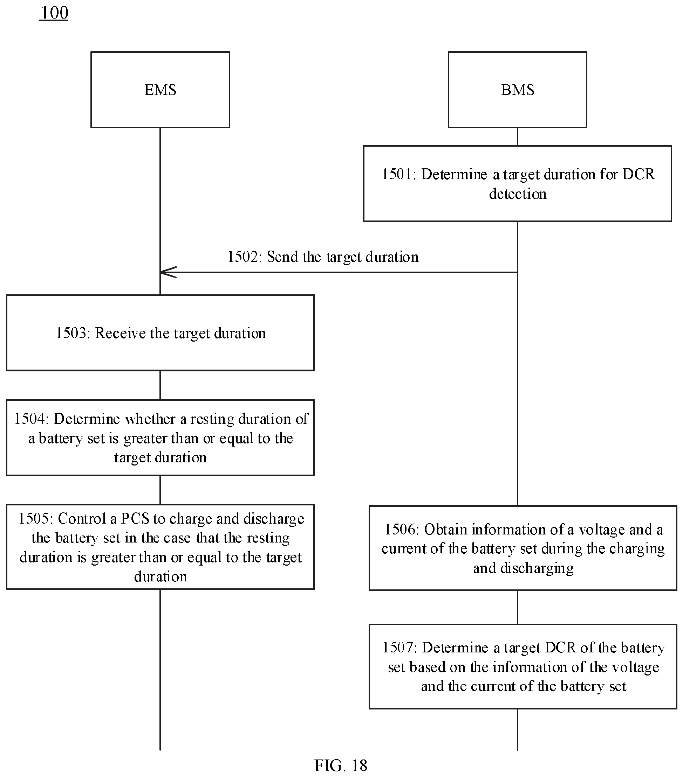

For example, as shown in FIG. 18, there is a flowchart of interaction between the EMS and the BMS.

In step 1501, a BMS determines a target duration for DCR detection.

For example, the target duration is determined based on the current state parameters of the battery set, such as an SOC, an SOH, and a temperature. Alternatively, a preset target duration is directly used.

In step 1502, the BMS sends the target duration to an EMS.

In step 1503, the EMS receives the target duration.

In step 1504, the EMS determines whether a duration for which the battery set is in a resting state is greater than or equal to the target duration.

In step 1505, in the case that the duration for which the battery set is in the resting state is greater than or equal to the target duration, the EMS controls a PCS to charge and discharge the battery set.

In step 1506, the BMS obtains information of the voltage and the current of the battery set during the charging and discharging of the battery set by the PCS.

In step 1507, the BMS determines a target DCR of the battery set based on the information of the voltage and the current of the battery set.

It can be understood that the EMS determines whether the duration for which the battery set is in the resting state is greater than or equal to the target duration, to ensure that the battery set can currently rest for a sufficient duration to detect the DCR. The sufficient duration should be greater than or equal to the target duration.

Specifically, in the case that the EMS determines that the battery set is in the resting state, the BMS determines the target duration required for detecting the DCR. The BMS sends the information of the target duration to the EMS, such that the EMS determines whether there is a charging and discharging demand of the power grid within the target duration. If the EMS determines or the user determines that there is no charging and discharging demand of the power grid within the target duration, the test condition is met, and the DCR of the battery set can be detected based on the above method. That is, it is first determined whether there is sufficient time to detect the DCR of the battery set, so as to reduce the occurrence of charging and discharging forced by the power grid during the DCR test. If there is sufficient time to test the DCR of the battery set, the DCR detection is performed within a predetermined time. In this case, the EMS may control the PCS to charge or discharge the battery set at a specific current. During this process, the BMS detects the change in the voltage of the battery set and the current of the battery set within the target duration, and calculates the DCR of the battery set based on the change in the voltage and the current.

In the embodiments, the EMS may determine, in the following two manners, whether the duration for which the battery set is in the resting state is greater than the target duration. In one aspect, the EMS may determine whether there is a charging and discharging demand of the power grid within the target duration. Alternatively, in another aspect, the EMS may provide the target duration to the user through, for example, a human-machine interaction system, for confirmation by the user. For example, the EMS may obtain a display interface, and determine, in response to an operation of the user on the display interface, whether the duration for which the battery set is in the resting state is greater than or equal to the target duration. The user may inform the EMS whether the battery set can currently rest for longer than the target duration by executing corresponding operations on the display interface, such as confirming or cancelling.

In some embodiments, the method 100 may further include: obtaining a historical DCR of the battery set; and calibrating the target DCR of the battery set obtained in the above steps based on the historical DCR of the battery set, to obtain a corrected DCR of the battery set.

That is, the DCR detected online may be calibrated in combination with historical DCR data of the battery set, thereby improving the accuracy of the DCR detection.

If the historical DCR of the battery set is not stored in the database or a cloud platform, the target DCR of the battery set may be used as the final detection result, for example, as a determination condition for a current imbalance and the like. If the historical DCR of the battery set is stored in the database or the cloud platform, corresponding data processing may be performed based on the data of the historical DCR and the target DCR to obtain an updated DCR as the final detection result, for example, as a determination condition for a current imbalance and the like.

In combination with the historical DCR, whether the target DCR obtained through online detection is an outlier can be effectively determined, such that the target DCR can be found in time when it deviates from a normal range due to factors such as the environment or forced charging and discharging of the power grid. Alternatively, the target DCR may be adjusted based on a change trend of the historical DCR, to compensate for the impact of factors such as the use and the environment of the battery set on the DCR.

The historical DCR includes the initial DCR of the battery set and/or a DCR of the battery set detected within a historical time. The DCR of the battery set detected within the historical time may be, for example, a target DCR of the battery set detected by charging and discharging the battery set using the PCS within the historical time. The initial DCR of the battery set may be, for example, calculated based on the initial DCRs of the battery cells in the battery set. The initial DCRs of the battery cells may be DCRs obtained after the battery cells are subjected to the DCR testing procedures on the production line.

As shown in the foregoing FIG. 9, the initial DCR of the battery cell may generally refer to the DCR obtained after the battery cell is subjected to the test on the production line. The battery cells on the production line generally undergo procedures such as formation, aging, room-temperature coefficient K measurement, DCR tests, capacity tests, and DCR grouping. During the procedure of the DCR test, a battery cell with a certain SOC may be charged for a certain duration. For example, the battery cell may be charged at a constant current for 30 s in the case that the battery cell has an SOC of 20%, and based on the principle similar to that of FIG. 5, the DCR of the battery cell is calculated, which may be used as the initial DCR of the battery cell.

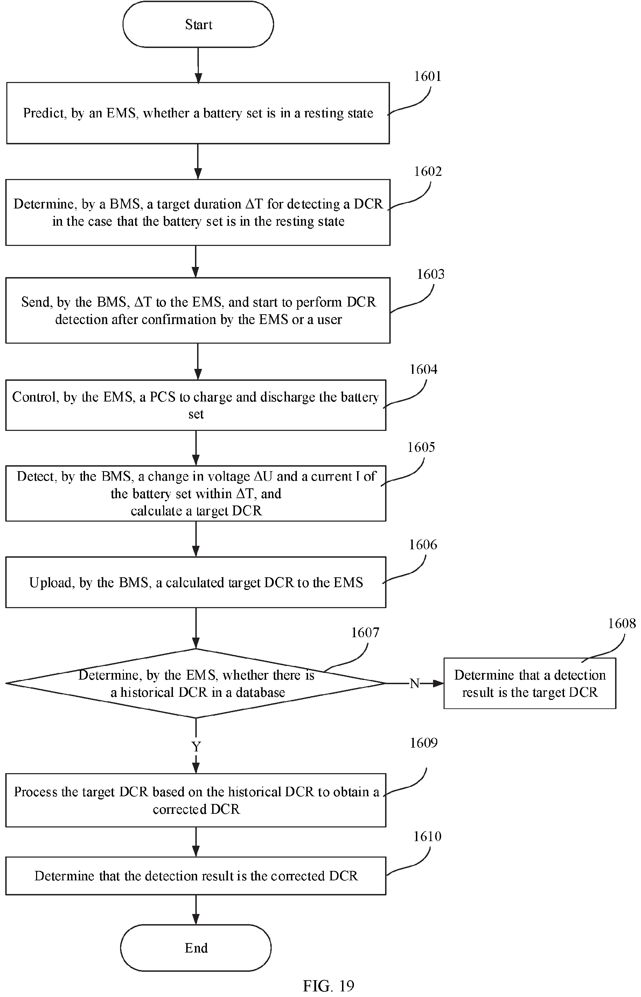

FIG. 19 is a possible specific implementation of a DCR control method according to an embodiment of the present application. The method shown in FIG. 8 may be executed by an EMS and a BMS.

As shown in FIG. 19, in step 1601, an EMS predicts whether a battery set is in a resting state.

In step 1602, the BMS determines a target duration ΔT for detecting a DCR in the case that the battery set is in the resting state.

In step 1603, the BMS sends the target duration ΔT to the EMS, and starts to perform DCR detection after the EMS or a user confirms that the duration for which the battery set is in the resting state is greater than the target duration.

In step 1604, the EMS controls a PCS to charge and discharge the battery set at a certain charge and discharge rate.

In step 1605, the BMS detects a change in voltage ΔU and current I of the battery set within a target duration ΔT, and calculates a target DCR.

For example, the target DCR = ΔU/I.

In step 1606, the BMS uploads the target DCR to the EMS.

In step 1607, the EMS determines whether there is a historical DCR of the battery set in a database.

If the target DCR of the battery set is not stored in the database, step 1608 is executed. If the target DCR of the battery set is stored in the database, step 1609 is executed.

In step 1608, a detection result is determined to be the target DCR.

The BMS may use the target DCR as the final detection result, for example, as a determination condition for a current imbalance and the like.

In step 1609, the target DCR is processed based on the historical DCR of the battery set to obtain a corrected DCR.

In step 1610, the EMS determines that the detection result is the corrected DCR, and may feed back the corrected DCR to the BMS.

The BMS may use the corrected DCR as the final detection result, for example, as a determination condition for a current imbalance and the like.

It can be seen that, during the actual application of the battery, in an idle time in which there is no charging and discharging demand of the power grid, the PCS is used to charge and discharge the battery set, the target DCR of the battery set is determined based on information of the voltage and the current of the battery set during charging and discharging, and the target DCR can be processed in combination with historical DCR data to obtain the corrected DCR, thereby accurately achieving the online detection of the DCR.

Based on the above description, it can be seen that in approach 2, the DCR of the battery set may be dynamically obtained based on the information of the voltage and/or the current of the battery set. For example, the DCR of the battery set is obtained using the information of the current OCV, the voltage, and the current of the battery set. This method does not rely on the initial voltage of the battery set, and the detection result of the DCR is therefore unaffected by the instability of the initial voltage, resulting in high accuracy. For another example, the battery set is charged and discharged by controlling the PCS, and the DCR of the battery set is obtained using the information of the voltage and the current of the battery set during charging and discharging, which does not affect the normal production operating condition of the battery set.

Upon obtaining the DCR of the battery set, whether a current imbalance may occur in the plurality of battery sets may be determined based on the DCRs of the plurality of battery sets connected in parallel. In the embodiments of the present application, the following three solutions are further provided, to resolve the overcurrent problem of the battery sets caused by a current imbalance.

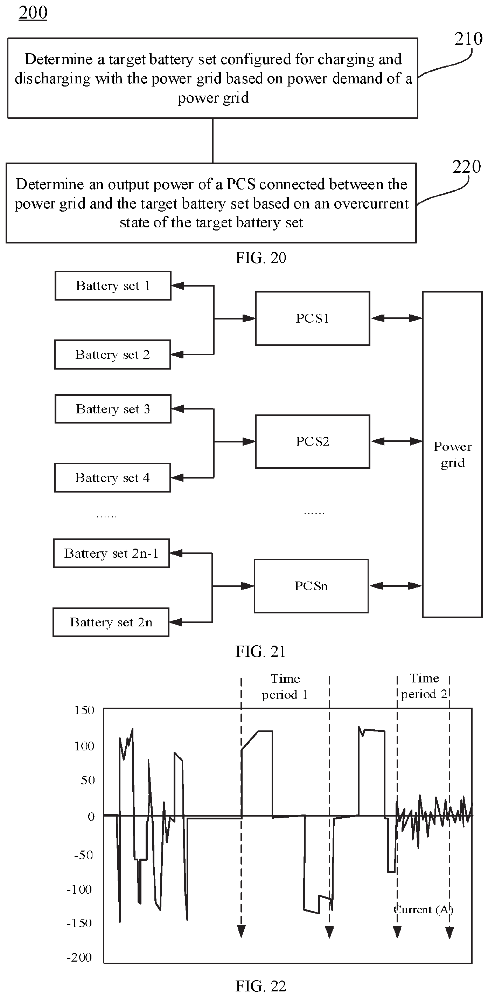

How to suppress the overcurrent of the battery sets connected in parallel is described in detail below with reference to FIGs. 20 to 29.

FIG. 20 is a power control method 200 according to an embodiment of the present application. The method 200 may be executed by, for example, an EMS. As shown in FIG. 20, the method 200 includes some or all of the following steps.

In step 210, based on power demand of a power grid, a target battery set configured for charging and discharging with the power grid is determined.

In step 220, based on an overcurrent state of the target battery set, an output power of a PCS connected to the target battery set is determined.

Referring to FIG. 21, the PCS is configured to achieve conversion between an alternating current signal of the power grid and a direct current signal of the energy storage system. Each PCS may be connected to one or a plurality of battery sets, and the plurality of battery sets are connected in parallel to the power grid through the PCS, thereby performing charging or discharging with the power grid. As shown in FIG. 21, an example in which each PCS is connected to two battery sets is used. The battery set may be, for example, a battery product such as an electrical cabinet or a container. The electrical cabinet may be considered as a battery product composed of a battery cluster. Therefore, the electrical cabinet shown in the embodiments may also be referred to as a battery cluster, and a plurality of electrical cabinets may be assembled to form a battery product such as a container. Each electrical cabinet includes a plurality of electrical boxes connected in series and/or in parallel, and each electrical box includes a plurality of battery cells connected in series and/or in parallel.

The DCR of a battery cell is affected by a plurality of factors during production, resulting in differences in the DCRs among different battery cells. Consequently, battery sets formed by assembling the battery cells, for example, products such as electrical cabinets or containers, have relatively large differences in DCRs. After the battery sets are connected to the power grid in parallel through the PCS, if each battery set is allocated the same power, current differences among branches are caused by differences in the DCRs among the battery sets in the parallel branches, thereby causing a current imbalance among a plurality of battery sets connected in parallel, and resulting in overcurrent of some battery sets.

In the method 200, based on the power demand of the power grid, the target battery set for charging and discharging with the power grid is determined, and the output power of the corresponding PCS is determined based on the overcurrent state of the target battery set, such that the charging and discharging power of the battery set under each PCS can be dynamically adjusted from the whole-station level, thereby reducing the probability of overcurrent in the battery set in the case that the demand of the power grid is met.

In some embodiments, in step 210, whether the target battery set includes all or a part of the plurality of battery sets may be determined based on the power demand of the power grid. The plurality of battery sets are connected in parallel to the power grid through a plurality of PCSs, respectively. Here, the battery set may be, for example, a battery product such as an electrical cabinet or a container. Correspondingly, the plurality of battery sets may be a plurality of electrical cabinet sets or a plurality of container sets. For example, each electrical cabinet set includes one or more electrical cabinets, and these electrical cabinets are connected in parallel to the power grid through the same PCS. For another example, each container set includes one or more containers, and these containers are connected in parallel to the power grid through the same PCS.

That is, it is determined whether all battery sets need to participate in charging and discharging currently to meet the power demand of the power grid, thereby reducing power waste and achieving an optimal configuration of resources while meeting the power demand of the power grid.

For example, in the case that the power demand of the power grid is high, such as higher than a threshold, it may be determined that the target battery set is all of the plurality of battery sets. In the case that the power demand of the power grid is low, such as lower than the threshold, it may be determined that the target battery set is a part of the plurality of battery sets.

Each battery set is connected to the power grid through a corresponding PCS. For example, as shown in FIG. 21, the energy storage system includes n PCSs, the energy storage system includes 2n battery sets, and each PCS is connected to two battery sets. A battery set 1 and a battery set 2 are used as a battery set, and are connected to the power grid through a PCS1; a battery set 3 and a battery set 4 are used as a battery set, and are connected to the power grid through a PCS2; ...; and a battery series 2n-1 and a battery set 2n are used as a battery set, and are connected to the power grid through a PCSn.

Taking FIG. 21 as an example, the target battery set may include all battery sets connected to PCS1 to PCSn, that is, the battery set 1 to the battery set 2n. Alternatively, the target battery set may include the battery sets connected to a part of PCSs in PCS1 to PCSn. The power demand of the power grid changes in different time periods. For example, FIG. 22 shows power changes of the power grid in different periods. The horizontal coordinate represents time, and the vertical coordinate represents power. In a time period 1, the power demand of the power grid is relatively high, and in a time period 2, the power demand of the power grid is relatively low. If each battery set is allocated the same power, current differences among branches may be caused by differences in the DCRs among the battery sets in the parallel branches, thereby causing a current imbalance in the parallel system. Therefore, optionally, based on the power demand of the power grid, full-load charging and discharging may be performed by all battery sets, i.e., the battery set 1 to the battery set 2n, within the time period 1. In addition, full-load charging and discharging are performed by only a part of the battery sets, for example, the battery set 1 and the battery set 2 corresponding to the PCS1, within the time period 2.

The following describes in detail a power distribution manner in the case that the target battery set includes all battery sets and a part of the battery sets.

### Case 1

The target battery set determined in step 210 for charging and discharging with the power grid includes all of the plurality of battery sets under the power grid.

In this case, in step 220, overcurrent states of the plurality of battery sets are determined in the case that output powers of a plurality of PCSs are full-load powers, and whether to adjust the output powers of the plurality of PCSs from the full-load powers to target powers is determined based on the overcurrent states of the plurality of battery sets.

The full-load power is, for example, a rated power or the maximum power. The target power is less than the full-load power. For example, the target power in the year is between 70% and 90%, such as 70%, 75%, 80%, 85%, 90%, or 95%.

In a time period when the power demand of the power grid is relatively high, for example, in the time period 1 shown in FIG. 22, all battery sets connected in parallel to the power grid need to participate in charging and discharging. In this case, the overcurrent states of these battery sets are determined in the case that the output powers of the PCSs are the full-load powers, and the output powers of the PCSs are determined based on the overcurrent states. In addition, the demand of the power grid and the overcurrent conditions of the battery sets are taken into consideration, thereby reducing the probability of overcurrent in the battery sets in the case that the power demand of the power grid is met.

The overcurrent state in the embodiments includes, for example, overcurrent and non-overcurrent. It should be understood that the overcurrent herein means that there is an overcurrent risk, and the non-overcurrent means that there is no overcurrent risk or there is a relatively low overcurrent risk. Optionally, whether the battery set has an overcurrent risk may be determined based on a DCR, a temperature, an SOC, and the like of the battery set. If there is no overcurrent risk or there is a relatively low overcurrent risk, it is considered that the overcurrent state of the battery set is non-overcurrent. If there is an overcurrent risk, it is considered that the overcurrent state of the battery set is overcurrent.

In an implementation, in step 220, in the case that no overcurrent occurs in the plurality of battery sets, the output powers of the plurality of PCSs are determined as the full-load powers. In this case, the plurality of battery sets respectively connected to the plurality of PCSs are all charged and discharged with the power grid based on the full-load powers, to meet a current high-power demand of the power grid.

In another implementation, in step 220, in the case that overcurrent occurs in at least one battery set of the plurality of battery sets, it is determined whether the power demand of the power grid is met in the case that the output powers of the plurality of PCSs are the target powers. In this case, in the case that the power demand of the power grid is met, the output power of the PCS may be considered to be reduced, to reduce the impact on the entire energy storage system caused by overcurrent of an individual battery set.

Further, if it is determined that the power demand of the power grid is met in the case that the output powers of the plurality of PCSs are the target powers, it is determined that the output powers of the plurality of PCSs are adjusted from the full-load powers to the target powers. That is, the output power of the PCS is reduced. In this way, the output power of the PCS can be reduced without greatly affecting the demand of the power grid, such that the plurality of battery sets can participate in the over-discharge process with the power grid, thereby meeting the high-power demand of the current power grid and reducing the impact on the entire energy storage system caused by the overcurrent of the individual battery set.

If it is determined that the power demand of the power grid cannot be met in the case that the output powers of the plurality of PCSs are the target powers, the output powers of the plurality of PCSs are determined as full-load powers. Since the power demand of the power grid cannot be met, the output powers of the plurality of PCSs should be maintained at the full-load powers. However, some battery sets have the overcurrent risk in the case that the output powers of the plurality of PCSs are still the full-load powers. Optionally, BMSs of these battery sets may execute a corresponding current limiting strategy inside the battery sets based on factors such as a degree of overcurrent of corresponding battery sets, to reduce the probability of overcurrent in these battery sets.

### Case 2

The target battery set used for charging and discharging with the power grid determined in step 210 includes a part of the plurality of battery sets under the power grid.

In this case, in step 220, the overcurrent states of the part of the battery sets may be determined in the case that the output powers of the PCSs connected to the part of the battery sets are the full-load powers, and the output powers of the PCSs connected to the part of the battery sets are determined based on the overcurrent states of the part of the battery sets.

In a time period when the power demand of the power grid is relatively low, for example, in the time period 2 shown in FIG. 22, only a part of the battery sets connected in parallel to the power grid need to participate in charging and discharging, to reduce power waste. In this case, the overcurrent states of the part of the battery sets are determined in the case that the output powers of the PCSs connected to the part of the battery sets are the full-load powers, and output powers of corresponding PCSs are determined based on the overcurrent states. In addition, the demand of the power grid and the overcurrent conditions of the battery sets are taken into consideration, thereby reducing the probability of overcurrent in the battery sets in the case that the power demand of the power grid is met.

In an implementation, in step 220, in the case that no overcurrent occurs in the part of the battery sets, the output power of the target PCS is determined as the full-load power. In this case, the part of the battery sets may be charged and discharged with the power grid based on the full-load powers to meet the power demand of the power grid, without concern for the overcurrent problem.

In another implementation, in step 220, in the case that overcurrent occurs in at least one battery set of the part of the battery sets, the output powers of the PCSs connected to the part of the battery sets are determined to be 0. Here, the output power of the PCS being 0 may mean that the battery set corresponding to the PCS may not be currently used, for example, the branch corresponding to the PCS may be disconnected. In this case, to reduce the impact on the entire energy storage system caused by the overcurrent of individual battery sets, the output powers of the PCSs corresponding to the part of the battery sets may be adjusted to 0. That is, in this period of time, the part of the battery sets are not used for charging and discharging with the power grid. In this case, optionally, a battery set used for charging and discharging with the power grid may be determined from the other battery sets among the plurality of battery sets, excluding the part of the battery sets.

Taking FIG. 21 as an example, if the battery set 1 and the battery set 2 corresponding to the PCS1 are first selected as the target battery sets for charging and discharging with the battery sets in the current time period, but the battery set 1 and the battery set 2 may have an overcurrent risk at the full-load power, battery sets corresponding to other PCSs may be sequentially selected as the target battery sets and whether the target battery sets have an overcurrent risk may be determined until a battery set having no overcurrent risk is selected for charging and discharging with the battery sets in the current time period. For example, the battery set 3 and the battery set 4 corresponding to the PCS2 may continue to be selected in a polling manner. If the battery set 3 and the battery set 4 have no overcurrent risk, the battery set 3 and the battery set 4 perform charging and discharging with the battery set based on the full-load power in the current time period, to meet the power demand of the power grid.

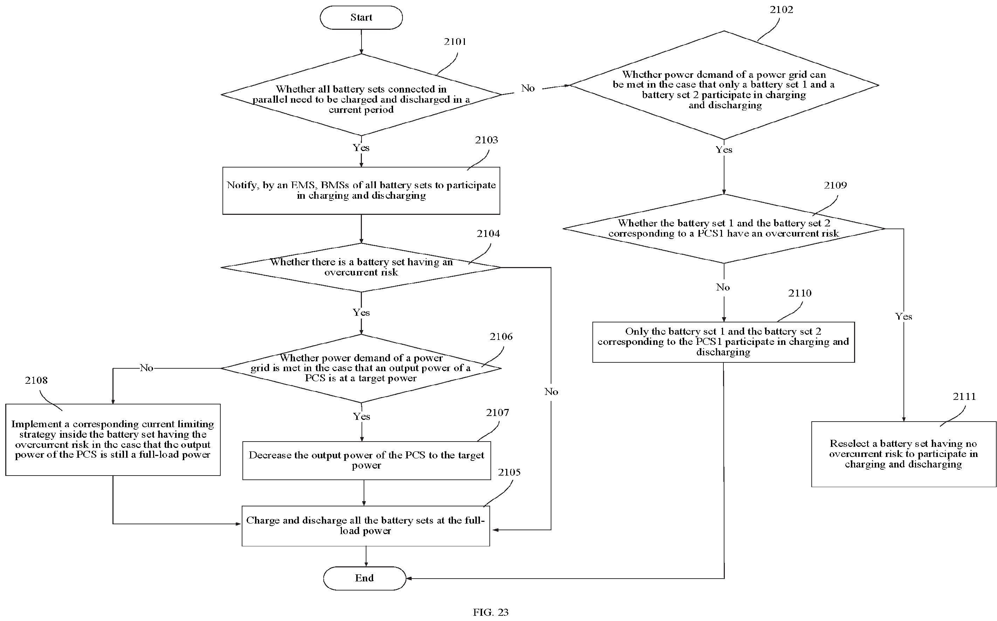

FIG. 23 is a schematic flowchart of a possible specific implementation of the method 200. The process shown in FIG. 23 may be executed by, for example, the EMS.

As shown in FIG. 6, in step 2101, an EMS determines whether all battery sets connected in parallel need to be charged and discharged in the current time period.

Taking the architectures and scenarios shown in FIGs. 21 and 22 as an example, if the current time period is the time period 1 shown in FIG. 22, and the power demand of the power grid is relatively high, in step 2101, the EMS determines that all battery sets currently need to be charged and discharged, and step 2103 is executed. If the current time period is the time period 2 shown in FIG. 22, in step 2101, the EMS determines that a part of the battery sets currently participate in charging and discharging, and step 2102 is executed.

In one case, step 2103 to step 2108 are executed.

In step 2103, the EMS notifies BMSs of all battery sets to participate in charging and discharging.

In step 2104, the EMS determines whether there is a battery set having an overcurrent risk.

That is, overcurrent states of the battery sets are determined in the case that charging and discharging are performed at a full-load power. If all battery sets have no overcurrent risk in the case that charging and discharging are performed at the full-load power, step 2105 is executed. If a part of the battery sets may have an overcurrent risk in the case that charging and discharging are performed at the full-load power, step 2106 is executed.

In step 2105, the EMS determines that all the battery sets are charged and discharged at the full-load power.

In step 2106, the EMS determines whether the power demand of a power grid is met in the case that output powers of PCSs are reduced to a target power.

The target power is less than the full-load power, and may be, for example, 90% of a rated power.

If the power demand of the power grid can be met upon reducing the output power of the PCS, step 2107 is executed. If the power demand of the power grid cannot be met upon reducing the output power of the PCS, step 2108 is executed.

In step 2107, the EMS controls the output power of the PCS to be reduced to the target power.

In step 2108, the EMS controls the output power of the PCS to be the full-load power, and executes a corresponding current limiting strategy inside the battery set having the overcurrent risk.

Certainly, times of power reduction are not limited in the embodiments of the present application. For example, if the power demand of the power grid can still be met in the case that the output power of the PCS is reduced to another power less than the target power, the output power of the PCS may continue to be reduced to the other power, to reduce the degree of overcurrent of the battery set.

In another case, step 2102, step 2109, step 2121, and step 2111 are executed.

In step 2102, the EMS determines whether the power demand of the power grid can be met in the case that only the battery set 1 and the battery set 2 corresponding to the PCS1 participate in charging and discharging.

In step 2109, the EMS determines whether the battery set 1 and the battery set 2 corresponding to the PCS1 have an overcurrent risk.

That is, overcurrent states of the battery set 1 and the battery set 2 are determined in the case that charging and discharging are performed at the full-load power. If the battery set 1 and the battery set 2 have no overcurrent risk in the case of being charged and discharged at the full-load power, step 2105 is executed. If the battery set 1 and the battery set 2 have an overcurrent risk in the case of being charged and discharged at the full-load power, step 2106 is executed.

In step 2110, the EMS determines that the battery set 1 and the battery set 2 corresponding to the PCS1 participate in charging and discharging.

In step 2111, the EMS reselects a battery set having no overcurrent risk to participate in charging and discharging.

It can be seen that, based on the process shown in FIG. 23, the EMS may dynamically adjust the output powers of the PCSs, to reduce the probability of a current imbalance among a plurality of battery sets connected in parallel in the case that the demand of the power grid is met, thereby further reducing the probability of overcurrent in the battery sets.

In the embodiments of the present application, in addition to executing the foregoing power control method 200 to control the power of the battery set from a perspective of the entire station to mitigate the overcurrent of the battery set, the following two current limiting strategies may also be used to resolve the overcurrent problem of the battery set. The following two solutions are both corresponding current limiting strategies executed inside the battery set.

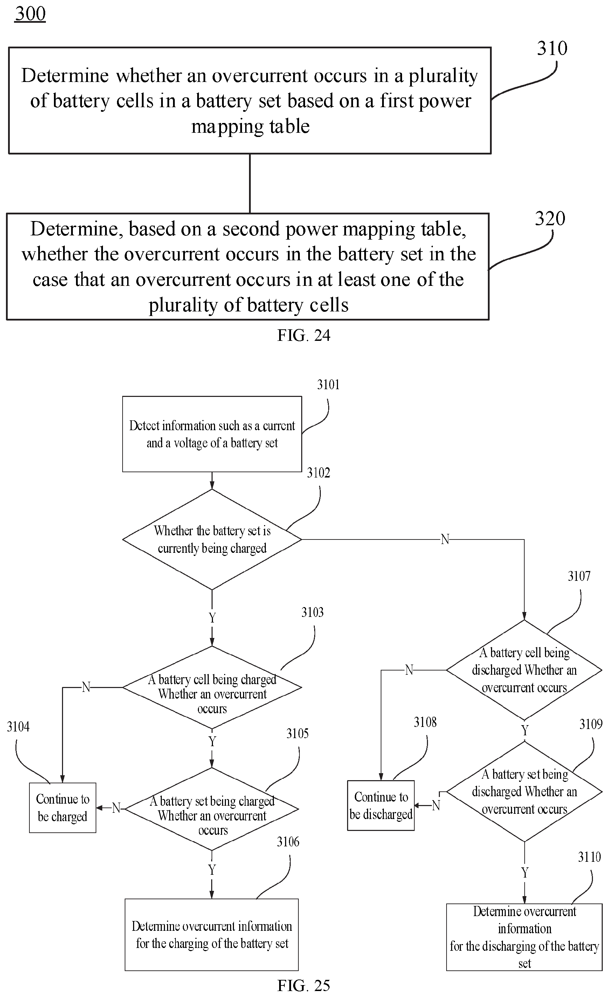

Before the two current limiting strategies are described, an overcurrent determining method 300 according to the embodiments of the present application is first described with reference to FIGs. 24 and 25. The method 300 may be executed by, for example, the BMS to determine whether an overcurrent occurs in the battery set. In the case that the overcurrent occurs in the battery set, the BMS of the battery set executes a corresponding current limiting strategy for the battery set.

In some embodiments, the method 300 further includes: determining whether an overcurrent occurs in a plurality of batteries in the battery set, and determining whether the overcurrent occurs in the battery set in the case that the overcurrent occurs in at least one of the plurality of batteries. In this case, in the case that it is determined that the overcurrent occurs in the battery set, in step 310, the BMS determines overcurrent information of the battery set, such as an overcurrent level, based on a difference between an actual current of the battery set and an allowable current thereof.

That is, whether an overcurrent occurs in the plurality of batteries in the battery set may be preferentially determined, and whether an overcurrent occurs in the battery set is determined in the case that an overcurrent occurs in at least one of the batteries, such that the overcurrent information of the battery set is determined in the case that the overcurrent occurs in the battery set. The battery may be, for example, a battery cell.

For example, as shown in FIG. 24, the method 300 may include some or all of the following steps.

In step 310, a BMS determines, based on a first power mapping table, whether an overcurrent occurs in a plurality of batteries in a battery set.

In step 320, the BMS determines, based on a second power mapping table, whether the overcurrent occurs in the battery set in the case that an overcurrent occurs in at least one of the plurality of batteries.

In this case, in the case that the overcurrent occurs in the battery set, the BMS executes a corresponding current limiting strategy on the battery set based on a difference between an actual current of the battery set and an allowable current thereof. The allowable current of the battery set may be, for example, an allowable current or a rated current of the battery set.

The first power mapping table includes allowable power values of the battery cells with different SOCs and at different temperatures, and the second power mapping table includes allowable power values of the battery set with different SOCs and at different temperatures.

With the first power mapping table, it can be determined whether an overcurrent occurs in a battery in the battery set. In the case that a degree of overcurrent of a certain battery in the battery set is significantly higher than a degree of overcurrent of another battery, it may be considered whether the battery is faulty, so as to find out a cause of the overcurrent in time.

In the case that it is determined, based on the first power mapping table, that the overcurrent occurs in the battery set, since automatic current balancing may be achieved among batteries connected in parallel, the overcurrent may not occur in the battery set. In this case, it is further necessary to determine, based on the second power mapping table, whether the overcurrent occurs in the battery set.

It can be seen that with the first power mapping table and the second power mapping table, the overcurrent condition of the battery set can be determined in a simple and efficient manner. The first power mapping table includes allowable power values of the batteries with different SOCs and at different temperatures. If the actual power of the battery exceeds the allowable power value in the first power mapping table that corresponds to the current SOC and temperature, it is considered that an overcurrent occurs in the battery. The second power mapping table includes allowable power values of the battery sets with different SOCs and at different temperatures. If the actual power of the battery set exceeds an allowable power value in the second power mapping table that corresponds to the current SOC and temperature, it is considered that an overcurrent occurs in the battery set. A power mapping table used for overcurrent determination during charging and a power mapping table used for overcurrent determination during discharging may be set separately.

Taking a certain battery cell in the battery set as an example, assuming that the current temperature of the battery cell is 25 °C and the SOC is 95%, the first power value corresponding to 25 °C and 95% SOC can be obtained based on the first power mapping table. If the actual power value calculated based on the current current and voltage of the battery cell is greater than the first power value, it is considered that an overcurrent occurs in the battery cell.

If the number of the battery cells in the battery set in which the overcurrent occurs reaches a certain threshold, which may be one or more, whether the overcurrent occurs in the battery set is determined based on the second power mapping table. Assuming that the current temperature of the battery set is 25 °C and the SOC is 90%, the second power value corresponding to 25 °C and 90% SOC can be obtained based on the second power mapping table. If the actual power value calculated based on the current current and voltage of the battery set is greater than the second power value, it is considered that the overcurrent occurs in the battery set.

In the case that it is determined that the overcurrent has occurred in the battery set, a corresponding current limiting strategy is executed on the battery set based on the difference between the actual current of the battery set and the allowable current thereof.

FIG. 25 shows a possible specific implementation of determining whether an overcurrent occurs in a battery set. The approach shown in FIG. 25 may be executed by a BMS of the battery set. The battery set is charged or discharged with the power grid based on the demand of an EMS.

As shown in FIG. 25, in step 3101, the BMS detects information such as the current and the voltage of the battery set.

In step 3102, the BMS determines whether the battery set is currently being charged or discharged based on the current.

For example, whether the battery set is being charged or discharged may be determined based on a direction of the current, i.e., the positive or negative sign of the current.

If the battery set is being charged, step 3103 to step 3106 are executed. If the battery set is being discharged, step 3107 to step 3131 are executed.

In step 3103, it is determined, based on a first power mapping table corresponding to a charging process, whether an overcurrent occurs in a battery cell in the battery set.

If the overcurrent occurs in at least one battery cell in the battery set, step 3105 and step 3106 are executed; otherwise, step 3104 is executed.

In step 3104, the battery set continues to be charged.

In step 3105, it is determined, based on a second power mapping table corresponding to the charging process, whether the overcurrent occurs in the battery set.

If no overcurrent occurs in the battery set, step 3104 is executed. If the overcurrent occurs in the battery set, step 3106 is executed.

In step 3106, an overcurrent level for the charging of the battery set is determined.

In step 3107, it is determined, based on a first power mapping table corresponding to a discharging process, whether an overcurrent occurs in a battery cell in the battery set.

If the overcurrent occurs in at least one battery cell in the battery set, step 3109 is executed; otherwise, step 3108 is executed.

In step 3108, the battery set continues to be discharged.

In step 3109, it is determined, based on a second power mapping table corresponding to the discharging process, whether the overcurrent occurs in the battery set.

If no overcurrent occurs in the battery set, step 3108 is executed. If the overcurrent occurs in the battery set, step 3110 is executed.

In step 3110, an overcurrent level for the discharging of the battery set is determined.

After it is determined that the overcurrent has occurred in the battery set, current limiting may be performed on the battery set.

Two approaches for performing current limiting on a battery set according to the embodiments of the present application are separately described below, which are separately described below.

### Approach 1

A BMS determines a corresponding overcurrent level based on a degree of overcurrent of a battery set, and reports the overcurrent level to an EMS. The EMS determines, based on the current operating condition, whether to perform current limiting on the battery set. In this way, the overcurrent condition of the battery set can be mitigated while ensuring that the current operating condition is not affected.

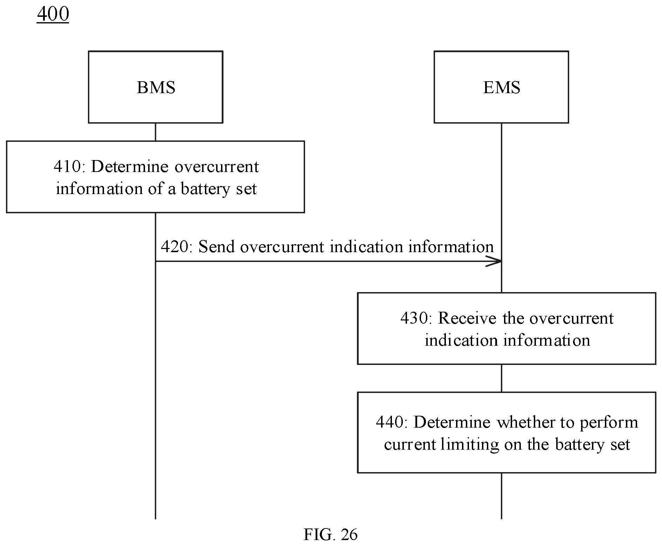

FIG. 26 shows an overcurrent control method 400 according to an embodiment of the present application. The method 400 may be executed by, for example, an EMS and/or a BMS. Certainly, in a possible implementation, the BMS may execute some of the following operations executed by the EMS, and the EMS may also execute some of the following operations executed by the BMS.

As shown in FIG. 26, the method 400 includes some or all of the following steps.

In step 410, a BMS determines overcurrent information of a battery set.

In step 420, the BMS sends overcurrent indication information to an EMS.

The overcurrent indication information includes the overcurrent information of the battery set, and the overcurrent indication information is used to request the EMS to determine whether to perform current limiting on the battery set.

In step 430, the EMS receives the overcurrent indication information sent by the BMS.

In step 440, the EMS determines, based on the overcurrent indication information, whether to perform current limiting on the battery set.

Here, the current limiting refers to, for example, limiting the allowable current of the battery set, that is, reducing the allowable current of the battery set.

The overcurrent information may be, for example, information used to represent a degree of overcurrent of the battery set, such as an overcurrent level or an overcurrent value of the battery set.

The overcurrent level is used to indicate a degree at which the current current of the battery set exceeds the allowable current of the battery set. The overcurrent value may be a current difference between the current current of the battery set and the allowable current thereof, the ratio of the current current of the battery set to the allowable current thereof, or the like. The BMS determines the overcurrent information of the battery set, and reports the overcurrent indication information carrying the overcurrent information to the EMS. The EMS determines, based on the overcurrent indication information in combination with the current operating condition, whether to perform current limiting on the battery set. In this way, the overcurrent condition of the battery set can be mitigated while ensuring that the current operating condition is not affected.

The overcurrent control method according to the embodiments of the present application is described in detail below using an example in which the overcurrent information is used to indicate the overcurrent level of the battery set. The overcurrent level may be replaced with another overcurrent information such as an overcurrent value.

In some embodiments, in step 410, the BMS may determine the overcurrent level of the battery set based on an overcurrent ratio of the battery set. The overcurrent ratio is the ratio of the current of the battery set to the allowable current thereof.

The overcurrent level of the battery set is associated with a degree at which the current of the battery set exceeds the allowable current of the battery set. Therefore, the overcurrent level of the battery set may be determined based on the overcurrent ratio of the battery set, which is relatively intuitive. It is assumed that the current current of the battery set is Ir, and the allowable current of the battery set is Ia. In the case that the overcurrent occurs in the battery set, Ir > Ia. In the case, the overcurrent ratio of the battery set is the ratio of the current Ir to the current Ia, i.e., Ir/Ia.

Certainly, the overcurrent level of the battery set may also be determined based on the value of a difference |Ir - Ia| between Ir and Ia. This is not limited in the present application.

A plurality of overcurrent levels correspond to a plurality of overcurrent ratios, respectively. As an example, the overcurrent levels of the battery set may be set from high to low to include a first overcurrent level, a second overcurrent level, a third overcurrent level, and a fourth overcurrent level in sequence. It is assumed that a higher overcurrent level corresponds to a higher overcurrent ratio. That is, the overcurrent ratio corresponding to the first overcurrent level is greater than the overcurrent ratio corresponding to the second overcurrent level, the overcurrent ratio corresponding to the second overcurrent level is greater than the overcurrent ratio corresponding to the third overcurrent level, and the overcurrent ratio corresponding to the third overcurrent level is greater than the overcurrent ratio corresponding to the fourth overcurrent level.

It is assumed that overcurrent ratio thresholds corresponding to the first overcurrent level, the second overcurrent level, the third overcurrent level, and the fourth overcurrent level are x1%, x2%, x3%, and x4%, respectively. In the case that Ir/Ia > x4%, it can be considered that the overcurrent level of the battery set reaches the fourth overcurrent level; in the case that Ir/Ia > x4%, it can be considered that the overcurrent level of the battery set reaches the third overcurrent level; in the case that Ir/Ia > x2%, it can be considered that the overcurrent level of the battery set reaches the second overcurrent level; in the case that Ir/Ia > x1%, it can be considered that the overcurrent level of the battery set reaches the first overcurrent level, where x4 < x3 < x2 < x1.

It can be understood that the overcurrent information according to the embodiments of the present application may be identification information used to indicate the overcurrent level of the battery set, or may be an overcurrent ratio threshold corresponding to the overcurrent level, for example, a first overcurrent threshold, a second overcurrent threshold, a third overcurrent threshold, or a fourth overcurrent threshold described above, or may be another information that can indicate the overcurrent level.

Further, optionally, the overcurrent level may also be determined in combination with an overcurrent duration. That is, the overcurrent level of the battery set is determined based on the overcurrent ratio and the overcurrent duration of the battery set.

For example, in the case that the overcurrent ratio of the battery set reaches the overcurrent ratio corresponding to the first overcurrent level and the condition lasts for a duration T1, or in the case that a duration of the battery set at the second overcurrent level reaches a duration T2, the overcurrent level of the battery set is determined as the first overcurrent level.

For another example, in the case that the overcurrent ratio of the battery set reaches the overcurrent ratio corresponding to the second overcurrent level and the condition lasts for a duration T3, or in the case that a duration of the battery set at the third overcurrent level reaches a duration T4, the overcurrent level of the battery set is determined as the second overcurrent level.

For another example, in the case that the overcurrent ratio of the battery set reaches the overcurrent ratio corresponding to the third overcurrent level and the condition lasts for a duration T5, or in the case that a duration of the battery set at the fourth overcurrent level reaches a duration T6, the overcurrent level of the battery set is determined as the third overcurrent level.

For another example, in the case that the overcurrent ratio of the battery set reaches the overcurrent ratio corresponding to the fourth overcurrent level and the condition lasts for a duration T7, the overcurrent level of the battery set is determined as the fourth overcurrent level.

The duration T1, the duration T2, the duration T3, the duration T4, the duration T5, the duration T6, and the duration T7 may be at least partially the same or all different. Optionally, T1 < T2, T3 < T4, and T5 < T6 may be set.

In this way, not only the degree of overcurrent of the current of the battery set relative to the allowable current but also the overcurrent duration is considered, such that the overcurrent level is determined more in line with actual situations.

As an example, Table 5 shows a correspondence relationship between overcurrent levels and overcurrent ratios corresponding to the overcurrent levels. The overcurrent condition corresponding to each overcurrent level includes information such as an overcurrent ratio and an overcurrent duration. 10A in the overcurrent condition is determined based on the minimum detection precision of the current. Here, 10A is used as an example, and may also be replaced with another current value during actual applications.

**Table 5**

| Overcurrent level | Overcurrent condition | Current limiting information | Overcurrent cancellation condition |
|---|---|---|---|
| First overcurrent level | Ir > max(Ia * x1%, 10A) for T1; or a second overcurrent level for T2 | Current being limited to y1 * Ia | Ir < Ia for T0 |
| Second overcurrent level | Ir > max(Ia * x2%, 10A) for T3; or a third overcurrent level for T4 | Current being limited to y2 * Ia | Ir < Ia for T0 |
| Third overcurrent level | Ir > max(Ia * x3%, 10A) for T5; or a fourth overcurrent level for T6 | Current being limited to y3 * Ia | Ir < Ia for T0 |
| Fourth overcurrent level | Ir > max(Ia * x4%, 10A) for T7 | Current being limited to y4 * Ia | Ir < Ia for T0 |

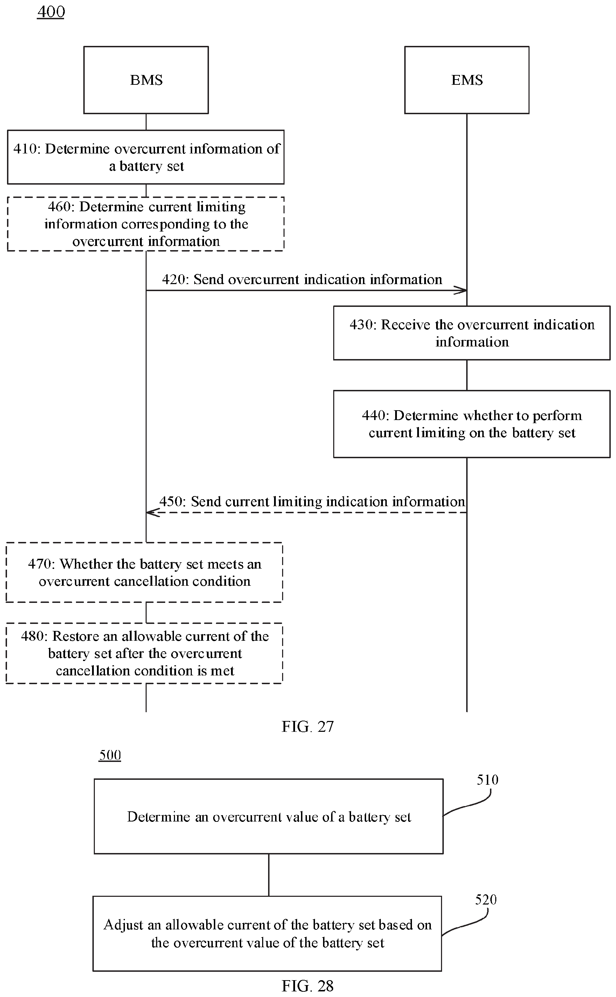

In some embodiments, as shown in FIG. 27, the method 400 may further include step 460.

In step 460, the BMS determines, based on the overcurrent level of the battery set, current limiting information corresponding to the overcurrent level. The overcurrent indication information further includes the current limiting information corresponding to the overcurrent level.

The current limiting information is information used in the case that current limiting is performed on the battery set, and includes, for example, information such as a desired target value of the adjusted allowable current.

In this case, the EMS may consider the current limiting information corresponding to the overcurrent level of the battery set carried in the overcurrent indication information, to determine whether to perform current limiting on the battery set based on the current limiting information corresponding to the overcurrent level.

Desired current limiting information respectively corresponding to the plurality of overcurrent levels may be set, the BMS may determine the desired current limiting information of the battery set based on the overcurrent level of the battery set. The current limiting information may be carried in the overcurrent indication information to serve as a reference for the EMS to determine whether to reduce the power of the battery set.

In some embodiments, the current limiting information includes a target value of the allowable current of the battery set. The BMS may determine the target value based on an initial value of the allowable current of the battery set and a current adjustment ratio corresponding to the overcurrent level of the battery set, for example, by multiplying the initial value by a current adjustment ratio to obtain the target value. The current adjustment ratio may be the ratio of a preset target value to which the allowable current is expected to be adjusted to the initial value of the allowable current.

For example, as shown in Table 5, current adjustment ratios corresponding to the first overcurrent level, the second overcurrent level, the third overcurrent level, and the fourth overcurrent level are y1, y2, y3, and y4, respectively. In the case that the overcurrent level of the battery set reaches the fourth overcurrent level, the allowable current of the battery set may be limited to a target value y4 * Ia, and in the case that y4 = 1, the allowable current of the battery set may not be limited; that is, the current adjustment ratio is 1. In the case that the overcurrent level of the battery set reaches the third overcurrent level, the allowable current of the battery set may be limited to a target value y3 * Ia. In the case that the overcurrent level of the battery set reaches the second overcurrent level, the allowable current of the battery set may be limited to a target value y2 * Ia. In the case that the overcurrent level of the battery set reaches the first overcurrent level, other risks may be caused, such that the allowable current of the battery set can be limited to a target value y1 * Ia, and in the case that y1 = 0, the current adjustment ratio is 0, and the BMS may request to power down the high voltage. In this case, the overcurrent level may be cleared. y1 < y2 < y3 < y4 < Ia.

Corresponding current adjustment ratios may be set for different overcurrent levels, to determine the target value of the allowable current based on the initial value of the allowable current of the battery set and the corresponding current adjustment ratio. As a result, the current limiting performed on the battery set matches the overcurrent level of the battery set, thereby improving the effect of the current limiting.

It can be understood that the target value of the allowable current in the current limiting information is the allowable current value that the BMS desires the battery set to reach. That is, the battery set is expected to reach the allowable current value matching the current overcurrent level, thereby mitigating the overcurrent condition of the battery set. However, whether the battery set can actually limit the allowable current to the target value also needs to be considered by the EMS in combination with various factors.

The overcurrent indication information sent by the BMS to the EMS may carry the overcurrent level and the current limiting information corresponding to the overcurrent level, i.e., the target value. Upon receiving the overcurrent indication information, the EMS may determine, based on the information carried in the overcurrent indication information, whether to perform current limiting on the battery set, that is, whether to allow the allowable current of the battery set to be limited to the target value. The EMS needs to determine whether the battery set is allowed to limit the allowable current and to what extent the allowable current can be reduced based on the information carried in the overcurrent indication information reported by the battery set, such as the overcurrent level and/or the corresponding current limiting information, and in combination with factors such as the current power demand of the power grid and/or the current balance conditions among the plurality of battery sets connected in parallel.

How the EMS determines whether to reduce the power of the battery set is not specifically limited in the embodiments of the present application. The EMS needs to determine, in combination with current actual operating conditions, whether to respond to the overcurrent indication information reported by the battery set. For example, in the case that the power demand of the power grid is relatively high, the EMS may select, based on the overcurrent level of the battery set, not to limit the allowable current of the battery set as appropriate, or limit the allowable current of the battery set without limiting the allowable current to be equal to the target value carried in the overcurrent indication information. In the case that the power demand of the power grid is not high, the EMS may allow, based on the overcurrent level of the battery set, to limit the allowable current of the battery set as appropriate. Specifically, the allowable current may be limited to be equal to the target value carried in the overcurrent indication information or another current value.

Optionally, the EMS may also consider current balance conditions among the plurality of battery sets connected in parallel. If the charging and discharging power reduced by the battery set can be compensated by other battery sets connected in parallel upon limiting the allowable current of the battery set, the EMS may allow the battery set to limit the allowable current, to mitigate the overcurrent condition of the battery set. If the overcurrent of the battery set can enable a current balance between the battery set and the other battery sets connected in parallel, the EMS may also not allow the battery set to limit the allowable current.

It can be understood that, in step 440, the EMS determines whether to perform current limiting on the battery set. The current limiting information herein may refer to the current limiting information carried in the overcurrent indication information, such as the target value, or the current limiting information may also be another current limiting information determined by the EMS for the BMS, such as another current value.

In the case of determining not to perform current limiting on the battery set, the EMS may not respond to the overcurrent indication information sent by the BMS. In the case of determining to perform current limiting on the battery set, optionally, the EMS may send the current limiting indication information. The current limiting indication information is used to indicate to perform current limiting on the battery set based on corresponding current limiting information.

It can be understood that since the current of the battery set is generally controlled by the PCS connected between the battery set and the power grid, the EMS may send the current limiting indication information to the BMS, and the BMS controls, based on the current limiting indication information, the PCS to perform current limiting on the battery set based on the current limiting information corresponding to the current overcurrent level. Alternatively, the EMS may directly send the current limiting indication information to the PCS to control the PCS to perform current limiting on the battery set based on the current limiting information corresponding to the current overcurrent level. Upon receiving the current limiting indication information from the BMS or the EMS, the PCS limits the allowable current of the battery set to be equal to the target value or another current value allowed by the EMS.

For example, as shown in FIG. 26, in step 450, the EMS sends the current limiting indication information.

The current limiting indication information is used to indicate whether to perform current limiting on the battery set based on the current limiting information corresponding to the overcurrent level of the battery set. If the EMS determines to perform current limiting on the battery set without allowing the current limiting on the battery set to be performed based on the current limiting information corresponding to the battery set, the current limiting indication information may also carry another current value to indicate that the allowable current of the battery set needs to be limited to the other current value.

In some embodiments, as shown in FIG. 27, the method 400 further includes step 470 and step 480.

In step 470, the BMS determines whether the battery set meets an overcurrent cancellation condition.

In step 480, the BMS restores the allowable current of the battery set to the initial value in the case that the battery set meets the overcurrent cancellation condition.

For example, in the case that the battery set meets the overcurrent cancellation condition, the BMS may instruct the PCS to restore the allowable current of the battery set to the initial value.

In this way, in the case that the current of the battery meets the overcurrent cancellation condition, the allowable current of the battery can be restored, allowing the battery set to resume normal charging and discharging currents.

Optionally, the overcurrent cancellation condition includes: the current Ir of the battery set being less than or equal to an initial value Ia of the allowable current; or the current Ir of the battery set being less than or equal to the initial value Ia and a difference |Ir - Ia| between the current of the battery set and the initial value Ia being less than a preset value; or the overcurrent level being cleared.

As an example, as shown in Table 5, in the case that Ir < Ia and the condition lasts for a certain duration, such as T0, the allowable current of the battery set is restored from the corresponding target value to the initial value Ia. Alternatively, in the case that the overcurrent level is cleared after the battery set is powered down, the allowable current of the battery set is restored from the corresponding target value to the initial value Ia.

In some embodiments, in step 420, the BMS may send the overcurrent indication information to the EMS and the condition lasts for a preset duration. In this case, in step 470, the BMS determines whether the battery set meets the overcurrent cancellation condition after the preset duration.

That is, the BMS may continuously send the overcurrent indication information to the EMS within the preset duration, and determine whether the overcurrent cancellation condition is met after the preset duration. If the EMS does not respond to the overcurrent indication information from the BMS, the BMS continues to monitor the current of the battery set until reaching the highest overcurrent level, such as the first overcurrent level in Table 5, and then being powered down. If the EMS responds to the overcurrent indication information from the BMS but the battery set still meets the overcurrent cancellation condition, the BMS may continue to send the overcurrent indication information.

If the EMS responds to the overcurrent indication information reported by the battery set, that is, if the EMS allows to limit the allowable current of the battery set, the EMS may control the PCS to limit the allowable current of the battery set by sending the current limiting indication information to the BMS or sending the current limiting indication information to the PCS connected between the battery set and the power grid, thereby reducing the charging and discharging power of the battery set. However, even if the allowable current of the battery set is limited, the overcurrent condition of the battery set may not be significantly mitigated, and the BMS still needs to determine whether the overcurrent cancellation condition is met by detecting the current in real time. If the overcurrent cancellation condition is not met, the BMS may continuously report the overcurrent indication information until the overcurrent cancellation condition is met, after which the allowable current is restored. If the battery set continuously fails to meet the overcurrent cancellation condition, the battery set is powered down after the highest overcurrent level, such as the first overcurrent level in Table 5, is reached, to reduce unnecessary risks caused by the overcurrent of the battery set.

### Approach 2

The BMS limits the allowable current of the battery set to a corresponding extent based on the degree of overcurrent of the battery set, thereby mitigating the overcurrent condition of the battery set.

FIG. 28 shows another overcurrent control method 500 according to an embodiment of the present application. The method 500 may be executed by, for example, a BMS. As shown in FIG. 28, the method 500 includes some or all of the following steps.

In step 510, an overcurrent value of a battery set is determined.

The overcurrent value includes a current difference between a current of the battery set and an allowable current thereof and/or a current ratio of the current of the battery set to the allowable current thereof. Assuming that the current current of the battery set is Ir, and the allowable current of the battery set is Ia, the overcurrent value of the battery set may be |Ir - Ia| and/or Ir/Ia.

In step 520, the allowable current of the battery set is adjusted based on the overcurrent value of the battery set.

In the embodiments of the present application, the battery sets may be, for example, an electrical box, an electrical cabinet, or a container, or may be other parallel units connected in parallel to the power grid through the PCS. These parallel units may all be subjected to overcurrent control using the method 500 according to the embodiments of the present application, to mitigate the overcurrent condition.

Generally, for a plurality of battery sets connected in parallel to the power grid, if an overcurrent occurs in one or some of the battery sets, an allowable current of all the battery sets connected in parallel is limited. In this way, the current of the battery set in which no overcurrent occurs also decreases, thereby affecting the charging and discharging of the entire system. However, in the embodiments of the present application, overcurrent control is performed on a single battery set, and an allowable current of the battery set is adjusted based on an overcurrent value of the battery set, and a current of another battery set connected in parallel with the battery set will not be affected, thereby reducing the impact on the charging and discharging process of the entire system. In addition, since the adjustment of the allowable current is adapted to the overcurrent value of the battery set, the impact on the charging and discharging process of the battery set itself is further reduced, thereby achieving the adaptive current reduction of a single battery set.

In some embodiments, a condition for adjusting the allowable current may be set. For example, in step 520, the allowable current of the battery set is adjusted in the case that a current difference between an actual current of the battery set and the allowable current is greater than or equal to a first threshold, and/or a current ratio of the actual current of the battery set to the allowable current is greater than or equal to a second threshold.

That is, the allowable current of the battery set is adjusted only in the case that a degree of overcurrent is large enough, that is, in the case that the current difference between the actual current of the battery set and the allowable current is greater than or equal to the first threshold, and/or the current ratio of the actual current of the battery set to the allowable current is greater than or equal to the second threshold.

The first threshold and the second threshold may be set based on actual operating conditions. For example, the first threshold may be set to 1A, and the second threshold may be set to 105%.

It is assumed that the current current of the battery set is Ir, and the allowable current of the battery set is Ia. In the case that the overcurrent occurs in the battery set, Ir > Ia. In this case, the current difference between the actual current of the battery set and the allowable current is |Ir - Ia|, or the current ratio of the actual current of the battery set to the allowable current is Ir/Ia. In the case that |Ir - Ia| is greater than or equal to the first threshold, for example, |Ir - Ia| ≥ 1A, and Ir/Ia is greater than or equal to the second threshold, for example, Ir/Ia ≥ 105%, the BMS adjusts the allowable current of the battery set based on the overcurrent value.

In some embodiments, step 520 may include: calculating a first product of an allowable current value of a battery set with the minimum allowable current among N battery sets connected in parallel and N; calculating a second product of the current difference of the battery set and a preset coefficient; calculating a difference between the first product and the second product; and determining the adjusted allowable current of the battery set, the adjusted allowable current being equal to the ratio of the difference to N.

The N battery sets include battery sets that currently require current limiting, where N is a positive integer.

The preset coefficient is used to adjust a degree of current limiting of the battery set, and the preset coefficient may be set to be equal to 1 or not equal to 1.

In other words, since the plurality of battery sets are connected in parallel to the power grid, in step 121 to step 124, the minimum value among the allowable currents corresponding to the plurality of parallel branches is multiplied by the number N of parallel branches to obtain the first product, an overcurrent value of a single branch, such as a current difference D, is multiplied by the preset coefficient to obtain the second product, and the difference between the first product and the second product is divided by the number N of the parallel branches to obtain the adjusted allowable current value of the single branch.

The adjusted allowable current value of the battery set may be calculated using a formula *I*ₐ^{'} =(*I*ₘᵢₙ **N*-*D***k*)/*N*, where Ia' is the adjusted allowable current value of the battery set, Iₘᵢₙ is the allowable current value of the battery set with the minimum allowable current among the plurality of battery sets connected in parallel including the battery set, N is the number of the plurality of battery sets connected in parallel, D is the current difference between the actual current of the battery set and the allowable current of the battery set, and k is the preset coefficient.

It can be seen that the larger D is, the smaller Ia^{'} is. That is, the larger the overcurrent value is, the smaller the allowable current value needs to be adjusted to. Since the adjustment of the allowable current is adapted to the overcurrent value of the battery set, the impact on the charging and discharging process of the battery set is further reduced, thereby achieving the adaptive current reduction of a single battery set.

Since the adjusted allowable current value Ia^{'} of the battery set is calculated based on the current difference D between the actual current of the single battery set and the allowable current thereof, and the allowable current of the battery set is adjusted based on the Ia^{'}, the allowable current of another battery set connected in parallel with the battery set is not affected, thereby reducing the impact on the charging and discharging process of the entire system.

In some embodiments, the method 500 further includes determining whether the battery set meets the overcurrent cancellation condition, and restoring the allowable current of the battery set to the initial value in the case that the battery set meets the overcurrent cancellation condition.

For example, the overcurrent cancellation condition may include that the current Ir of the battery set is less than or equal to the initial value Ia of the allowable current; that is, Ir ≤ Ia. For another example, the overcurrent cancellation condition may include that the current Ir of the battery set is less than or equal to the initial value Ia, and the difference |Ia - Ir| between the current Ir of the battery set and the initial value Ia is less than a preset value; that is, Ir ≤ Ia - b, where b is the preset value.

The preset value may be set based on actual operating conditions. For example, the preset value may be set to 10A. In this way, in the case that the current Ir of the battery set satisfies Ir ≤ Ia - 10A, the allowable current value of the battery set is restored to the initial value Ia.

In the embodiments, the BMS adjusts the allowable current of the battery set. For example, the BMS may adjust the allowable current of the battery set by controlling the PCS. In the case that current limiting is needed, the BMS may instruct the PCS to adjust the allowable current of the battery set from the initial value Ia to Ia', where Ia' < Ia; in the case that the battery set meets the overcurrent cancellation condition, the BMS may instruct the PCS to restore the allowable current of the battery set to the initial value Ia.

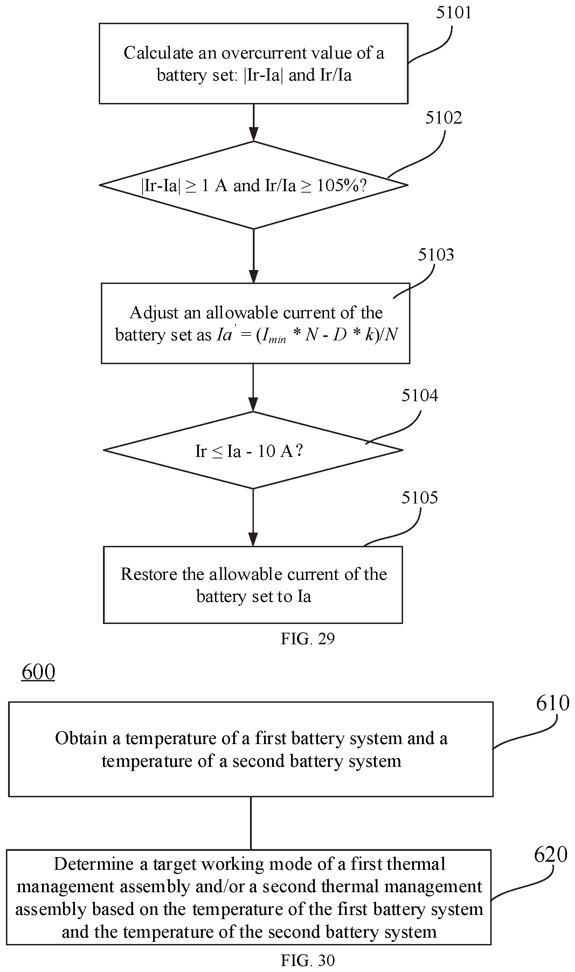

FIG. 29 shows a flowchart of a possible specific implementation of the method 500. A plurality of battery sets are connected in parallel to the power grid through a PCS and are charged or discharged with the power grid. The approach shown in FIG. 29 may be executed by a BMS corresponding to each battery set.

As shown in FIG. 29, in step 5101, an overcurrent value of a corresponding battery set is calculated.

For example, the overcurrent value refers to a current difference |Ir - Ia| between an actual current Ir of the battery set and an allowable current Ia and a current ratio Ir/Ia of the actual current of the battery set to the allowable current.

In step 5102, it is determined whether an allowable current of the battery set needs to be adjusted.

In the case that |Ir - Ia| ≥ 1A and Ir/Ia ≥ 105%, step 5103 and step 5104 are executed; otherwise, the allowable current of the battery set is not adjusted, and the initial value Ia is maintained.

In step 5103, the allowable current of the battery set is adjusted to Ia',
where *I*ₐ^{'}*=*(*I*ₘᵢₙ**N-D***k*)/*N*.

In step 5104, it is determined whether the battery set meets an overcurrent cancellation condition.

The overcurrent cancellation condition is Ir ≤ Ia - 10A.

Upon limiting the allowable current of the battery set to Ia', if the overcurrent of the battery set is mitigated and the overcurrent cancellation condition is met, step 5105 is executed; if the overcurrent cancellation condition is still not met, the current of the battery set continues to be monitored.

In step 5105, the allowable current of the battery set is restored to an initial value Ia.

Based on the above process, actual battery sets are tested. For example, a plurality of parallel battery sets shown in Tables 6 to 8, that is, the battery set 1, the battery set 2, the battery set 3, the battery set 4, and the battery set 5, are tested.

Table 6 shows an actual current Ir and an allowable current Ia of each battery set. The actual current and the allowable current of the battery set 1 are -141.4 and -132.7, respectively; the actual current and the allowable current of the battery set 2 are -141.5 and -132.4, respectively; the actual current and the allowable current of the battery set 3 are -141.0 and -132.3, respectively; the actual current and the allowable current of the battery set 4 are -141.9 and -132.6, respectively; the actual current and the allowable current of the battery set 5 are -142.0 and -132.2, respectively.

**Table 6**

| Battery set number | Actual current Ir | Allowable current Ia |
|---|---|---|
| 1 | -141.4 | -132.7 |
| 2 | -141.5 | -132.4 |
| 3 | -141.0 | -132.3 |
| 4 | -141.9 | -132.6 |
| 5 | -142.0 | -132.2 |

As shown in Table 7, taking the first threshold being 1A, the second threshold being 105%, and the preset coefficient being equal to 1 as an example, a current difference |Ir - Ia| between an actual current of each battery set and an allowable current, a ratio relationship Ir/Ia between the actual current and the allowable current, and an adjusted allowable current value Ia^{'} are shown, respectively.

A current difference between the actual current of the battery set 1 and the allowable current is |(-141.4) - (-132.7)| = 8.7 > 1A, and the actual current exceeds 105% of the allowable current value; that is, |-141.4| > |(-132.7) * 105%| = |-139.9|. Therefore, the allowable current of the battery set 1 may be adjusted to [(-132.2) * 5 - (-8.7) * 1]/20 = -130.5.

A current difference between the actual current of the battery set 2 and the allowable current is |(-141.5) - (-132.4)| = 9.1 > 1A, and the actual current exceeds 105% of the allowable current value; that is, |-141.5| > |(-132.4) * 105%| = |-139.0|. Therefore, the allowable current of the battery set 2 may be adjusted to [(-132.2) * 5 - (-9.1) * 1]/20 = -130.4.

A current difference between the actual current of the battery set 3 and the allowable current is |(-141.0) - (-132.3)| = 8.7 > 1A, and the actual current exceeds 105% of the allowable current value; that is, |-141.0| > |(-132.3) * 105%| = |-138.9|. Therefore, the allowable current of the battery set 3 may be adjusted to [(-132.2) * 5 - (-8.7) * 1]/20 = -130.5.

A current difference between the actual current of the battery set 4 and the allowable current is |(-141.9) - (-132.6)| = 9.3 > 1A, and the actual current exceeds 105% of the allowable current value; that is, |-141.9| > |(-132.6) * 105%| = |-139.2|. Therefore, the allowable current of the battery set 4 may be adjusted to [(-132.2) * 5 - (-9.3) * 1]/20 = -130.3.

A current difference between the actual current of the battery set 5 and the allowable current is |(-142.0) - (-132.2)| = 9.8 > 1A, and the actual current exceeds 105% of the allowable current value; that is, |-142.0| > |(-132.2) * 105%| = |-138.8|. Therefore, the allowable current of the battery set 5 may be adjusted to [(-132.2) * 5 - (-9.8) * 1]/20 = -130.2.

**Table 7**

| Battery set number | \|Ir-Ia\|≥1A | Ir≥Ia*105% | Ia^{'} |
|---|---|---|---|
| 1 | 8.7 | -139.3 | -130.5 |
| 2 | 9.1 | -139.0 | -130.4 |
| 3 | 8.7 | -138.9 | -130.5 |
| 4 | 9.3 | -139.2 | -130.3 |
| 5 | 9.8 | -138.8 | -130.2 |

Current limiting is performed on the battery set based on the adjusted allowable current value Ia^{'} shown in Table 7, and the result shown in Table 8 may be obtained. Table 8 shows the actual current Ir of the battery set after current limiting and the overcurrent cancellation condition. Herein, the overcurrent cancellation condition being Ir ≤ Ia - 10A is used as an example.

As shown in Table 8, the current value of the battery set 1 is -122.4, which is less than - 132.7 - (-10) = -122.7; the current value of the battery set 2 is -122.4, which is equal to -132.4 - (-10) = -122.4; the current value of the battery set 3 is -122.1, which is less than -132.3 - (-10) = - 122.3; the current value of the battery set 4 is -122.4, which is less than -132.6 - (-10) = -122.6; the current value of the battery set 5 is -122.0, which is less than -132.2 - (-10) = -122.2.

**Table 8**

| Battery set number | Actual current Ir | Allowable current Ia - 10A |
|---|---|---|
| 1 | -122.4 | -122.7 |
| 2 | -122.4 | -122.4 |
| 3 | -122.1 | -122.3 |
| 4 | -122.4 | -122.6 |
| 5 | -122.0 | -122.2 |

It can be seen from Tables 6 to 8 that, with overcurrent control solutions according to the embodiments of the present application, the overcurrent condition of the battery set can be effectively mitigated.

It can be understood that by performing current limiting on the battery set, that is, by reducing the allowable current value of the battery set, the EMS is thereby informed that an overcurrent has occurred in the battery set. In this way, the EMS can, based on the current operating conditions, such as the power demand of the power grid, the current balance conditions among the plurality of battery sets, and the degree of overcurrent of the battery set, adjust the power allocated to each battery set in the branches, thereby mitigating the overcurrent condition of the battery set.

Through the overcurrent control method according to the approach 1 and the approach 2 described above, the overcurrent condition of the battery set can be mitigated in the case that the overcurrent of the battery set is caused by a current imbalance among the plurality of battery sets connected in parallel.

As described above, the DCR of the battery set is affected by the temperature. Therefore, it is necessary to control the temperature of the battery set.

FIG. 30 shows a temperature control method 600 according to an embodiment of the present application. The method 600 may be executed by a BMS, another control module, or the like. As shown in FIG. 30, the method 600 includes some or all of the following steps.

In step 610, a temperature of a first battery system and a temperature of a second battery system are obtained.

In step 620, a target working mode of a first thermal management assembly and/or a second thermal management assembly is determined based on the temperature of the first battery system and the temperature of the second battery system.

The first thermal management assembly is configured to control the temperature of the first battery system, and the second thermal management assembly is configured to control the temperature of the second battery system.

The first battery system includes at least one battery cluster, and the second battery system includes at least one battery cluster. As an example, in the case that the foregoing battery set is an electrical cabinet or a battery cluster, the battery system may include at least one electrical cabinet or battery cluster. In the case that the foregoing discharging battery set is a container, the battery system may include at least a part of electrical cabinets or battery clusters in the container.

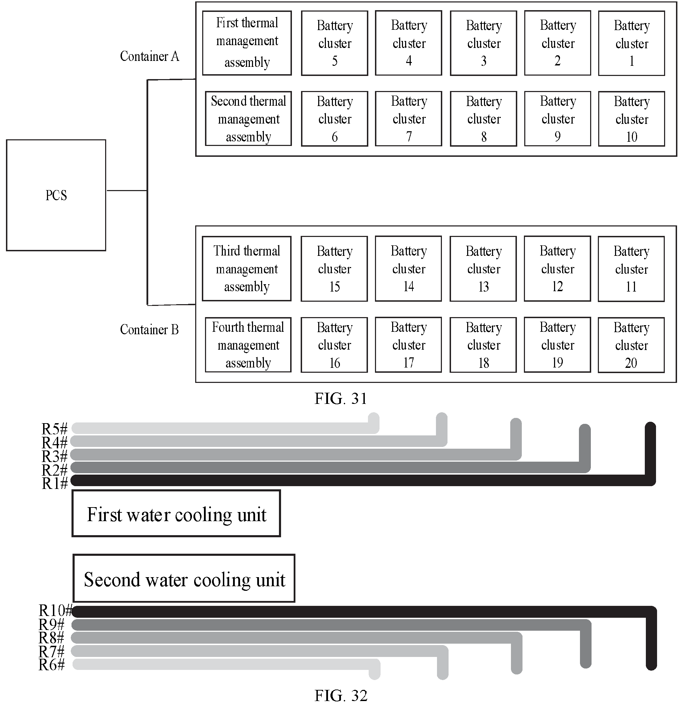

As an example, FIG. 31 shows a one-to-two architecture; that is, each PCS is connected to two containers, which are container A and container B, respectively. The container A includes two battery systems and the container B includes two battery systems. The first battery system and the second battery system may be two containers in different containers, or may be two containers in the same container. FIG. 31 shows an example in which the first battery system and the second battery system are two battery systems arranged in parallel in the container A. The first battery system includes five battery clusters connected in parallel, which are a battery cluster 1 to a battery cluster 5, respectively. The second battery system includes five battery clusters connected in parallel, which are a battery cluster 6 to a battery cluster 10, respectively.

As shown in FIG. 31, temperature management is performed on the first battery system and the second battery system through a first thermal management assembly and a second thermal management assembly in the container A, respectively. The first thermal management assembly is configured to control the temperature of the first battery system, and the second thermal management assembly is configured to control the temperature of the second battery system.

Optionally, the first thermal management assembly and the second thermal management assembly in the embodiments of the present application may be liquid cooling assemblies, such as water cooling units. Compared with an air cooling assembly, the liquid cooling assembly achieves more uniform temperature control, so that the battery system is easier to be at an appropriate temperature, thereby helping improve the service life of the battery product.

Based on the architecture shown in FIG. 31, an example is used in which the first thermal management assembly and the second thermal management assembly are water cooling units. As shown in FIG. 32, each water cooling unit includes five water pumps, each water pump corresponds to one water cooling pipe, each water cooling pipe is connected to a corresponding battery cluster shown in FIG. 31, and each battery cluster is provided with an independent inlet/outlet pipe. The five water pumps in the first water cooling unit are respectively connected to water cooling pipes R1#, R2#, R3#, R4#, and R5#. The water cooling pipes R1#, R2#, R3#, R4#, and R5# are respectively connected to the battery cluster 1, the battery cluster 2, the battery cluster 3, the battery cluster 4, and the battery cluster 5 shown in FIG. 31. The five water pumps in the second water cooling unit are respectively connected to water cooling pipes R6#, R7#, R8#, R9#, and R10#. The water cooling pipes R6#, R7#, R8#, R9#, and R10# are respectively connected to the battery cluster 6, the battery cluster 7, the battery cluster 8, the battery cluster 9, and the battery cluster 10 shown in FIG. 31. Each water cooling unit further includes a temperature management system (TMS), configured to control working modes of the five water cooling pipes in the water cooling unit.

Similarly, the temperature of the second battery system may be determined, for example, based on temperatures of a plurality of battery clusters in the second battery system. For example, the average value of the temperatures of the plurality of battery clusters in the second battery system is used as the temperature of the second battery system. The temperature of each battery cluster may be determined based on temperatures of a plurality of battery cells in the battery cluster. For example, the average value of the temperatures of the plurality of battery cells in the battery cluster is used as the temperature of the battery cluster.

Optionally, in step 610, in addition to obtaining the temperature of the first battery system and the temperature of the second battery system, the highest temperature and/or the lowest temperature of the plurality of battery clusters in the first battery system may be further obtained. The highest temperature and/or the lowest temperature of the plurality of battery clusters in the first battery system may be used to determine whether there is a battery cluster with an outlier temperature in the first battery system, and further determine whether a temperature change in the first battery system is caused by the battery cluster, thereby better controlling the temperature of the first battery system.

Similarly, in step 610, in addition to obtaining the temperature of the second battery system and the temperature of the second battery system, the highest temperature and/or the lowest temperature of the plurality of battery clusters in the second battery system may be further obtained. The highest temperature and/or the lowest temperature of the plurality of battery clusters in the second battery system may be used to determine whether there is a battery cluster with an outlier temperature in the second battery system, and further determine whether a temperature change in the second battery system is caused by the battery cluster, thereby better controlling the temperature of the second battery system.

The working modes of the first thermal management assembly and the second thermal management assembly include, for example, a cooling mode, a heating mode, a self-circulation mode, or a deactivated mode. The cooling mode is used to reduce the temperature of the battery system, the heating mode is used to increase the temperature of the battery system, and the self-circulation mode may also be considered as a heat preservation mode or a self-heat dissipation mode. Switching between different modes requires a transition. For example, switching from the heating mode to the cooling mode requires switching from the heating mode to the self-circulation mode and switching from the self-circulation mode to the cooling mode, and switching from the cooling mode to the heating mode requires switching from the cooling mode to the self-circulation mode and switching from the self-circulation mode to the heating mode.

The first battery system and the second battery system may be any two battery systems in a plurality of battery systems connected to the PCS, for example, two battery systems arranged in parallel in the plurality of battery systems. The two battery systems may be arranged adjacent to each other or may not be arranged adjacent to each other. Two corresponding sets of thermal management assemblies, namely, the first thermal management assembly and the second thermal management assembly, are respectively provided for the first battery system and the second battery system, to respectively control the temperatures of the first battery system and the second battery system. That is, the method 600 in this embodiment may resolve the problem of temperature uniformity in the battery systems caused by different thermal management assemblies.

The BMS determines the working modes of the first thermal management assembly and the second thermal management assembly based on the temperature difference between the temperature of the first battery system and the second battery system. As a result, the temperatures of the first battery system and the second battery system are respectively controlled through the first thermal management assembly and the second thermal management assembly, to improve the temperature uniformity between the first battery system and the second battery system, and resolve the problem of imbalance of impedance, current, and the like of the battery system caused by relatively poor temperature uniformity, thereby reducing the probability of large-current battery systems being fully charged or discharged in advance, and improving the RTE of the battery product.

In some embodiments, in step 620, the target working mode of the first thermal management assembly and/or the second thermal management assembly may be determined based on the temperature of the first battery system and the temperature of the second battery system in the case that the initial working modes of the first thermal management assembly and the second thermal management assembly are different.

That is, it may be determined whether the initial working modes of the first thermal management assembly and the second thermal management assembly are the same. Since the different initial working modes of the first thermal management assembly and the second thermal management assembly indicate the problem of temperature non-uniformity between the first battery system and the second battery system, in this case, the target working mode of the first thermal management assembly and/or the second thermal management assembly may be determined based on the temperature of the first battery system and the temperature of the second battery system, thereby adjusting the first thermal management assembly and/or the second thermal management assembly from the initial working mode to the target working mode.

In the case that the initial working modes of the first thermal management assembly and the second thermal management assembly are the same, it indicates that the temperature difference between the first battery system and the second battery system is not significant. Therefore, optionally, the working modes of the first thermal management assembly and the second thermal management assembly may not be adjusted, and the first thermal management assembly and the second thermal management assembly may maintain their respective initial working modes.

The initial working mode of the first thermal management assembly may be, for example, determined based on temperatures of a plurality of battery clusters in the first battery system. The initial working mode of the second thermal management assembly may be, for example, determined based on temperatures of a plurality of battery clusters in the second battery system. The temperature of each battery cluster in the first battery system and the second battery system may be determined based on temperatures of a plurality of battery cells in the battery cluster. For example, the average value of the temperatures of the plurality of battery cells in the battery cluster is used as the temperature of the battery cluster.

Here, the initial working modes of the first thermal management assembly and the second thermal management assembly are working modes used before the first thermal management assembly and the second thermal management assembly are adjusted to the target working modes. For example, after the initial working modes of the first thermal management assembly and the second thermal management assembly are determined, in the case that the initial working modes of the first thermal management assembly and the second thermal management assembly are different, whether the initial working modes need to be adjusted is determined with reference to the temperature of the first battery system and the temperature of the second battery system.

In some embodiments, in step 620, the target working mode of the first thermal management assembly and/or the second thermal management assembly may be determined based on the temperature difference between the temperature of the first battery system and the temperature of the second battery system.

For example, a first temperature threshold may be set. In the case that the temperature difference between the temperature of the first battery system and the temperature of the second battery system is greater than or equal to the first temperature threshold, the target working mode of the first thermal management assembly and/or the second thermal management assembly is determined.

The first temperature threshold may be set based on actual situations. For example, the first temperature threshold may be between 1 °C and 3 °C, such as 1 °C, 2 °C, or 3 °C.

The first battery system and the second battery system shown in FIGs. 31 and 32 are taken as an example. It is assumed that temperatures of the battery cluster 1, the battery cluster 2, the battery cluster 3, the battery cluster 4, and the battery cluster 5 in the first battery system are respectively T1, T2, T3, T4, and T5, and temperatures of the battery cluster 6, the battery cluster 7, the battery cluster 8, the battery cluster 9, and the battery cluster 10 in the second battery system are respectively T6, T7, T8, T9, and T10. In this case, the average temperature T_{A} of the plurality of battery clusters in the first battery system is defined as T_{A} = (T1 + T2 + T3 + T4 + T5)/20, the average temperature T_{B} of the plurality of battery clusters in the second battery system is defined as T_{B} = (T6 + T7 + T8 + T9 + T10)/20, and the temperature difference ΔT between the temperature of the first battery system and the temperature of the second battery system is defined as ΔT = |T_{A} - T_{B}|. In the case that the temperature difference ΔT is greater than or equal to the preset first temperature threshold, the working mode of the first thermal management assembly and/or the second thermal management assembly may be adjusted to reduce the temperature difference ΔT. For example, the working mode of the thermal management assembly of the battery system with a high temperature is adjusted to the cooling mode or self-circulation, and/or the working mode of the thermal management assembly of the battery system with a low temperature is adjusted to the heating mode or the self-circulation mode.

The temperature of the battery system is associated with the state of the battery system. Therefore, when the target working mode of the first thermal management assembly and/or the second thermal management assembly is determined, the current state of the battery system may also be considered. The state of the battery system includes, for example, a resting state and a charging and discharging state, where the charging and discharging state includes a charging state and a discharging state.

In some embodiments, in step 620, in the case that the temperature difference between the temperature of the first battery system and the temperature of the second battery system is greater than the first temperature threshold, the target working mode of the first thermal management assembly and/or the second thermal management assembly may be determined based on the states of the first battery system and the second battery system.

In one case, when the first battery system and the second battery system are in a resting state, the target working mode of the thermal management assembly of the battery system with a high temperature in the first battery system and the second battery system may be determined as the cooling mode.

Specifically, in most cases, the working mode of the thermal management assembly in the resting state is the self-circulation mode, and the self-circulation mode leads to high-temperature outliers in most cases. Since heat preservation of the battery system is easy in the resting state, while heat dissipation can basically only rely on the cooling of the thermal management assembly, the target working mode of the thermal management assembly of the battery system with a high temperature in the first battery system and the second battery system may be adjusted to the cooling mode to reduce the temperature of the battery system with a high temperature as soon as possible.

In this case, the working mode of the thermal management assembly of the battery system with a low temperature in the first battery system and the second battery system may remain unchanged; that is, the target working mode of the thermal management assembly of the battery system with a low temperature remains the same as the initial working mode thereof.

It can be understood that since not all the thermal management assemblies in the resting state are in a resting mode, it is still necessary to add the above steps; that is, based on whether the initial working modes of the first thermal management assembly and the second thermal management assembly are the same, it is determined whether to adjust the working mode of the first thermal management assembly and/or the second thermal management assembly.

For example, the first battery system and the second battery system are in the resting state. Assuming that the temperature difference ΔT between the temperature of the first battery system and the temperature of the second battery system is greater than the first temperature threshold, and the temperature T_{A} of the first battery system is lower than the temperature T_{B} of the second battery system, i.e., T_{A} < T_{B}, the target working mode of the second thermal management assembly may be selected as the cooling mode, so that the second battery system is continuously subjected to forced cooling.

Certainly, in the case that the first battery system and the second battery system are in the resting state, the target working mode of the first thermal management assembly and/or the second thermal management assembly may also be adjusted to another working mode that can reduce the temperature difference between the first battery system and the second battery system. For example, the target working mode of the thermal management assembly of the battery system with a low temperature in the first battery system and the second battery system is adjusted to the heating mode; or the target working mode of the thermal management assembly of the battery system with a high temperature in the first battery system and the second battery system is simultaneously adjusted to the cooling mode, and the target working mode of the thermal management assembly of the battery system with a low temperature is adjusted to the heating mode, thereby more quickly reducing the temperature difference between the two battery systems. However, since most of the battery systems in the resting state need to rely on the thermal management assembly for cooling to reduce temperature, adjusting the working mode of the thermal management assembly of the battery system with a high temperature to the cooling mode for continuous cooling or forced cooling can effectively reduce the temperature of the high-temperature battery system and reduce unnecessary system power consumption, which better aligns with actual application situations.

In another case, when the first battery system and the second battery system are in a charging and discharging state, it may be determined that the thermal management assembly of the battery system with a low temperature in the first battery system and the second battery system stops working.

Specifically, in the case that the first battery system and the second battery system are in the charging and discharging state, the battery systems themselves also heat up. Therefore, the thermal management assembly of the battery system with a low temperature in the first battery system and the second battery system may be turned off; for example, a stop instruction is sent to the TMS of the thermal management assembly of the battery system with the low temperature, instructing the TMS to turn off. As a result, the battery system with the low temperature increases its own temperature based on the charging and discharging process.

In this case, the working mode of the thermal management assembly of the battery system with a high temperature in the first battery system and the second battery system may remain unchanged; that is, the target working mode of the thermal management assembly of the battery system with a high temperature remains the same as the initial working mode thereof.

For example, the first battery system and the second battery system are in the charging and discharging state. Assuming that the temperature difference ΔT between the temperature of the first battery system and the temperature of the second battery system is greater than the first temperature threshold, and the temperature T_{A} of the first battery system is lower than the temperature T_{B} of the second battery system, i.e., T_{A} < T_{B}, the first thermal management assembly may be turned off, so that the first battery system can increase its own temperature based on the charging and discharging process.

Certainly, in the case that the first battery system and the second battery system are in the charging and discharging state, the target working mode of the first thermal management assembly and/or the second thermal management assembly may also be adjusted to another working mode that can reduce the temperature difference between the first battery system and the second battery system. For example, the target working mode of the thermal management assembly of the battery system with a high temperature in the first battery system and the second battery system is adjusted to the cooling mode; or the thermal management assembly of the battery system with a low temperature in the first battery system and the second battery system is simultaneously adjusted to be turned off, and the target working mode of the thermal management assembly of the battery system with a high temperature is adjusted to the cooling mode, thereby more quickly reducing the temperature difference between the two battery systems. However, since the battery system with a low temperature in the charging and discharging state can achieve self-heating through the charging and discharging process, turning off the thermal management assembly of the battery system can effectively increase the temperature of the low-temperature battery system and reduce unnecessary system power consumption, which better aligns with actual application situations.

In some embodiments, in the case that the temperature difference between the temperature of the first battery system and the temperature of the second battery system is less than or equal to a preset second temperature threshold, it is determined that the first thermal management assembly and the second thermal management assembly are adjusted to the same working mode, thereby maintaining temperature uniformity.

The second temperature threshold may be the same as or different from the first temperature threshold. The second temperature threshold may be set based on actual situations. For example, the second temperature threshold may be between 1 °C and 3 °C, such as 1 °C, 2 °C, or 3 °C.

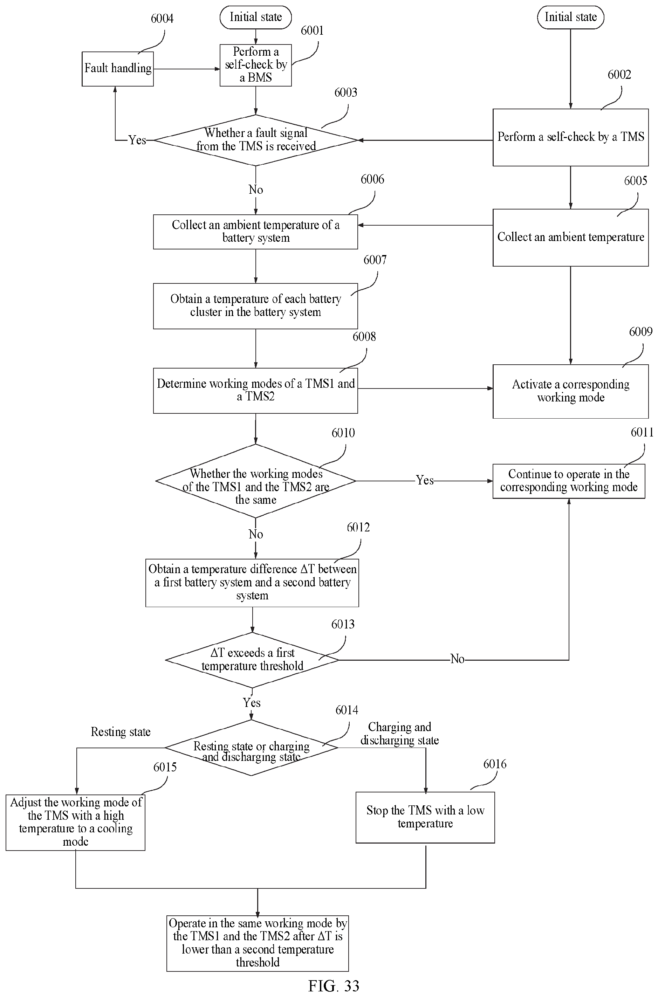

FIG. 33 shows a flowchart of a possible specific implementation of the method 600. As shown in FIG. 33, the process may be executed by the BMS and the TMS. It can be understood that, for both the TMS1 of the first thermal management assembly and the TMS2 of the second thermal management assembly, reference may be made to the steps executed by the TMS shown in FIG. 33.

In step 6001, the BMS performs a self-check.

If the BMS determines that the BMS is normal after the self-check, step 6003 is executed.

In step 6002, TMS1 and TMS2 perform self-checks.

If the self-check results in a fault, a fault signal is sent to the BMS.

In step 6003, the BMS detects whether the fault signal is received.

If the BMS receives the fault signal, step 6004 is executed; if the BMS does not receive the fault signal, step 6005 is executed.

In step 6004, the fault is handled.

For example, the fault signal is reported, and whether to control the shutdown of the thermal management assembly is determined based on a fault level.

In step 6005, the TMS1 and the TMS2 collect the ambient temperature and send the ambient temperature to the BMS.

In step 6006, the BMS collects the ambient temperatures of the first battery system and the second battery system.

In step 6007, the BMS obtains temperatures of a plurality of battery clusters in the first battery system and temperatures of a plurality of battery clusters in the second battery system.

In addition, the BMS may further obtain the highest temperature and/or the lowest temperature of the plurality of battery cells in each battery cluster.

In step 6008, the BMS determines the working modes of the TMS1 and the TMS2 based on the temperature information obtained in step 6007.

For example, based on the temperature of each battery cluster in each battery system and a related temperature threshold, it may be determined whether the working mode of the thermal management assembly of the battery system is a self-circulation mode, a cooling mode, or a heating mode, and the working mode is indicated to the TMS of the thermal management assembly.

In step 6009, a corresponding working mode is activated based on the indication of the BMS.

In step 6010, the BMS determines whether the working modes of the TMS1 and the TMS2 are the same.

If the working modes of the TMS1 and the TMS2 are the same, step 6011 is executed; if the working modes of the TMS1 and the TMS2 are different, step 6012 is executed.

In step 6011, the TMS1 and the TMS2 continue to operate in the working modes from step 6009.

In step 6012, the BMS obtains the temperature difference ΔT between the first battery system and the second battery system.

In step 6013, it is determined whether ΔT exceeds a first temperature threshold.

If ΔT does not exceed the first temperature threshold, step 6011 is executed; if ΔT exceeds the first temperature threshold, step 6014 is executed.

In step 6014, the BMS determines whether the battery system is in a resting state or a charging and discharging state.

If the battery system is in the resting state, step 6015 is executed; if the battery system is in the charging and discharging state, step 6016 is executed.

In step 6015, it is determined that the working mode of the thermal management assembly of the battery system with a high temperature is adjusted to the cooling mode.

In step 6016, it is determined that the thermal management assembly of the battery system with a low temperature stops working.

In step 6017, in the case that the temperature difference ΔT between the first battery system and the second battery system is less than a second temperature threshold, it is determined that the first thermal management assembly and the second thermal management assembly operate in the same working mode.

It can be seen that based on the relationship between the temperatures of the first battery system and the second battery system, adjusting the working modes of the first thermal management assembly and the second thermal management assembly can effectively improve the temperature uniformity between the first battery system and the second battery system.

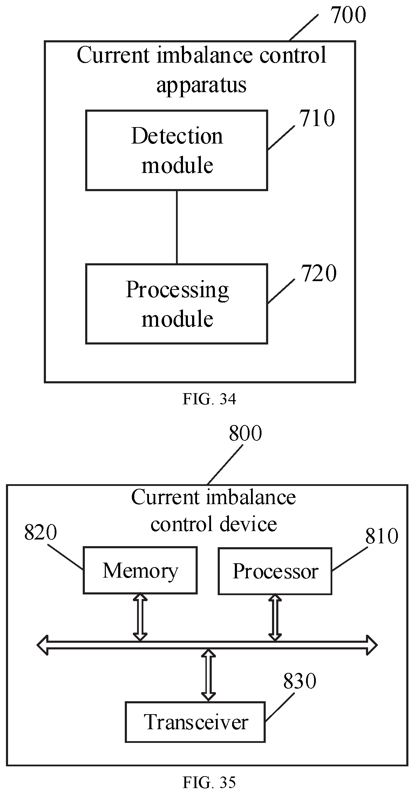

The current imbalance control method according to the embodiments of the present application is described in detail above, which includes, for example, the DCR control method, the current imbalance determining method, the overcurrent determining method, and the current limiting method. The following describes in detail a current imbalance control apparatus according to the embodiments of the present application with reference to FIGs. 34 and 35. Technical features described in the method embodiments are applicable to the following apparatus embodiments.

FIG. 34 is a schematic block diagram of a current imbalance control apparatus according to an embodiment of the present application. As shown in FIG. 34, the control apparatus 700 includes a detection module 710 and a processing module 720.

The detection module 710 is configured to obtain the direct current resistance of a battery set. The processing module 720 is configured to determine, based on direct current resistances of a plurality of battery sets, whether a current imbalance occurs among the plurality of battery sets.

In some embodiments, the detection module 710 is specifically configured to obtain the state parameter set of the battery set, the state parameter set including at least two state parameters of the battery set; determine the first direct current resistance of the battery set based on the state parameter set of the battery set and a preset correspondence relationship between a plurality of state parameter sets and a plurality of direct current resistances; and determine the second direct current resistance of the battery set based on the first direct current resistance of the battery set.

In some embodiments, the state parameter set includes at least two of the following state parameters: the state of charge of the battery set, the temperature of the battery set, the current of the battery set, the charging and discharging direction of the battery set, the charging and discharging time of the battery set, and the state of health of the battery set.

In some embodiments, the detection module 710 is specifically configured to determine the first direct current resistance as the second direct current resistance; or calibrate the first direct current resistance based on a preset calibration coefficient to obtain the calibrated second direct current resistance of the battery set.

In some embodiments, the detection module 710 is further configured to obtain a state parameter set of the battery set at a target moment after the current moment; and determine the direct current resistance of the battery set at the target moment based on the state parameter set of the battery set at the target moment and the correspondence relationship.

In some embodiments, the detection module 710 is specifically configured to obtain the information of the voltage and/or the current of the battery set; and determine the direct current resistance of the battery set based on the information of the voltage and/or the current.

In some embodiments, the detection module 710 is specifically configured to obtain the open-circuit voltage of the battery set. Determining the direct current resistance of the battery set based on the information of the voltage and/or the current includes: determining the direct current resistance of the battery set based on the open-circuit voltage of the battery set, the voltage of the battery set, and the current of the battery set.

In some embodiments, the detection module 710 is specifically configured to obtain the state of charge of the battery set; and determine the open-circuit voltage of the battery set based on the state of charge of the battery set and a preset correspondence relationship between the open-circuit voltage and the state of charge.

In some embodiments, the detection module 710 is specifically configured to determine the voltage difference between the voltage of the battery set and the open-circuit voltage of the battery set; determine the ratio of the voltage difference to the current of the battery set; and determine the ratio as the direct current resistance of the battery set.

In some embodiments, the detection module 710 is specifically configured to control the PCS connected to the battery set to charge and discharge the battery set; obtain the information of the voltage and the current of the battery set during the charging and discharging; and determine the target direct current resistance of the battery set based on the current of the battery set and the change in the voltage of the battery set within a target duration.

In some embodiments, the detection module 710 is specifically configured to determine the ratio of the change in the voltage of the battery set within the target duration to the current of the battery set as the target direct current resistance of the battery set.

In some embodiments, the processing module 720 is specifically configured to, in the case that the ratio of the direct current resistance of a first battery set to the direct current resistance of a second battery set in the plurality of battery sets is greater than a preset direct current resistance threshold, determine that the current imbalance occurs among the plurality of battery sets, where the first battery set is a battery set with the maximum direct current resistance in the plurality of battery sets, and the second battery set is a battery set with the minimum direct current resistance in the plurality of battery sets.

In some embodiments, the processing module 720 is further configured to obtain the temperature of a first battery system and the temperature of a second battery system in a plurality of battery systems; and determine the target working mode of a first thermal management assembly and/or a second thermal management assembly based on the temperature of the first battery system and the temperature of the second battery system, where the first thermal management assembly is configured to control the temperature of the first battery system, and the second thermal management assembly is configured to control the temperature of the second battery system.

In some embodiments, the processing module 720 is further configured to determine whether an overcurrent occurs in the battery set; and perform current limiting on the battery set based on the degree of overcurrent of the battery set in the case that the overcurrent occurs in the battery set.

In some embodiments, the processing module 720 is specifically configured to determine the overcurrent value of the battery set, the overcurrent value including a current difference between the current of the battery set and the allowable current thereof and/or a current ratio of the current of the battery set to the allowable current thereof; and adjust the allowable current of the battery set based on the overcurrent value.

In some embodiments, the processing module 720 is specifically configured to adjust the allowable current of the battery set in the case that the current difference is greater than or equal to a first threshold, and/or the current ratio is greater than or equal to a second threshold.

In some embodiments, the processing module 720 is specifically configured to calculate the first product of the allowable current value of a battery set with the minimum allowable current among N battery sets connected in parallel and N, where the N battery sets include the battery set, N being a positive integer; calculate the second product of the current difference and a preset coefficient; calculate a difference between the first product and the second product; and determine the adjusted allowable current of the battery set, the adjusted allowable current being equal to the ratio of the difference to N.

In some embodiments, the processing module 720 is specifically configured to determine the overcurrent information of the battery set; and send overcurrent indication information to an energy management system, where the overcurrent indication information includes the overcurrent information, and the overcurrent indication information is used to request the energy management system to determine whether to perform the current limiting on the battery set.

In some embodiments, the overcurrent information is used to indicate the overcurrent level of the battery set, and the processing module 720 is specifically configured to determine the overcurrent level of the battery set based on the overcurrent ratio of the battery set; or determine the overcurrent level based on the overcurrent ratio and the overcurrent duration of the battery set, where the overcurrent ratio is the ratio of the current of the battery set to the allowable current thereof.

In some embodiments, the processing module 720 is specifically configured to determine current limiting information corresponding to the overcurrent level based on the overcurrent level, where the overcurrent indication information further includes the current limiting information corresponding to the overcurrent level.

In some embodiments, the processing module 720 is specifically configured to determine the target value based on the initial value of the allowable current and a current adjustment ratio corresponding to the overcurrent level, where the current adjustment ratio is the ratio of the target value to the initial value of the allowable current.

In some embodiments, the processing module 720 is further configured to determine whether an overcurrent occurs in a plurality of batteries in the battery set; and determine whether the overcurrent occurs in the battery set in the case that the overcurrent occurs in at least one of the plurality of batteries.

In some embodiments, the control apparatus 700 further includes a control module, configured to determine, based on the power demand of a power grid, a target battery set configured for charging and discharging with the power grid; and determine, based on the overcurrent state of the target battery set, the output power of a power control system connected between the power grid and the target battery set.

In some embodiments, the control module is specifically configured to determine, based on the power demand of the power grid, that the target battery set includes all or a part of a plurality of battery sets, where the plurality of battery sets are connected in parallel to the power grid through a plurality of power control systems, respectively.

In some embodiments, the battery set is a battery cluster or an electrical cabinet, or the battery set is a container, where the container includes a plurality of electrical cabinets connected in series and/or in parallel, the battery cluster or the electrical cabinet includes a plurality of electrical boxes connected in series and/or in parallel, and the electrical box includes a plurality of battery cells connected in series and/or in parallel.

It should be understood that, for a specific implementation in which the control apparatus 700 performs temperature control and beneficial effects generated by the control apparatus, reference may be made to related descriptions in the method embodiments. For brevity, details are not described herein again.

An embodiment of the present application further provides a computer-readable storage medium, configured to store a computer program. When the computer program is executed by a computing device, the computing device is enabled to implement the temperature control method 600 according to any one of the above embodiments. Optionally, the computer program may be a computer program in the BMS.

An embodiment of the present application further provides a current imbalance control device 800. The control device 800 may include, for example, a BMS and/or an EMS. As shown in FIG. 35, the control device 800 includes a processor 810 and a memory 820, where the memory 820 is configured to store instructions, and the processor 810 is configured to read the instructions and execute the method according to the foregoing embodiments of the present application based on the instructions. The memory 820 may be a separate device independent of the processor 810, or may be integrated into the processor 810.

Optionally, as shown in FIG. 35, the temperature control device 800 may further include a transceiver 830, and the processor 810 may control the transceiver 830 to communicate with another device. For example, the transceiver may send information, data, or an instruction to another device, or receive information, data, or an instruction sent by another device.

The present application further provides an energy storage system. The energy storage system includes a plurality of battery sets and the current imbalance control device according to any one of the foregoing embodiments, and the plurality of battery sets may be connected in parallel, for example.

It should be understood that the processor according to the embodiments of the present application may be an integrated circuit chip with a signal processing capability. During the implementation process, the steps in the above method embodiments may be implemented via an integrated logic circuit of hardware in the processor, or via an instruction in the form of software. The above processors may be general-purpose processors, digital signal processors (DSPs), application specific integrated circuits (ASICs), field-programmable gate arrays (FPGAs) or other programmable logic devices, discrete gate or transistor logic devices, discrete hardware components, or the like. The processor can implement or execute the methods, steps, and logic block diagrams disclosed in the embodiments of the present application. The general-purpose processor may be a microprocessor or any conventional processor. The steps of the methods disclosed in the embodiments of the present application may be directly executed by a hardware-based decoding processor, or may be executed by a combination of hardware and software modules in the decoding processor. The software module may be located in a mature storage medium in the art, such as a random access memory, a flash memory, a read-only memory, a programmable read-only memory, an electrically erasable programmable memory, and a register. The storage medium resides in the memory. The processor reads information in the memory and completes the steps in the above methods in combination with the hardware thereof.

It can be understood that the memory in the embodiments of the present application may be a volatile memory or a non-volatile memory, or may include both volatile and non-volatile memories. The non-volatile memory may be a read-only memory (ROM), a programmable ROM (PROM), an erasable PROM (EPROM), an electrically EPROM (EEPROM), or a flash memory. The volatile memory may be a random access memory (RAM) that serves as an external cache. By way of example but not limitation, many forms of RAMs are available, for example, a static RAM (SRAM), a dynamic RAM (DRAM), a synchronous DRAM (SDRAM), a double data rate SDRAM (DDR SDRAM), an enhanced SDRAM (ESDRAM), a synchlink DRAM (SLDRAM), and a direct rambus RAM (DR RAM). It should be noted that the memory of the systems and methods described herein is intended to include, but is not limited to these and any other suitable types of memory.

It is to be noted that the various embodiments and/or the technical features of the embodiments described in the present application may be arbitrarily combined without conflict, and the combined technical solutions also fall within the protection scope of the present application.

In the embodiments of the present application, the numerical order of the steps does not imply the sequence of execution. The execution order of the steps should be determined by their functions and internal logic, and should not impose any limitation on the implementation of the embodiments of the present application.

Those of ordinary skill in the art will recognize that the units and algorithm steps of various examples described in conjunction with the embodiments disclosed herein can be implemented in electronic hardware, or a combination of computer software and electronic hardware. Whether these functions are performed in hardware or software depends on the particular application and design constraints of the technical solutions. Those skilled in the art may implement the described functions in varying ways for each particular application, but such implementation should not be interpreted as departing from the scope of the present application.

In the several embodiments provided in the present application, it should be understood that the disclosed systems, apparatuses, and methods may be implemented in other ways. For example, the above-described apparatus embodiments are merely illustrative. For example, the division of the units is only a division based on logical function, and it can be implemented in other ways in actual situations. For example, multiple units or components may be combined or integrated into another system, or some features may be omitted or not executed. In addition, the coupling, direct coupling, or communication connection between each other that is shown or discussed may be indirect coupling or communication connection through some interfaces, apparatuses, or units, and it may be in electrical, mechanical, or other forms.

The units described as separate components may or may not be physically separate, and components displayed as units may or may not be physical units; that is, they may be located in one place or distributed across a plurality of network units. Some or all of the units may be selected according to actual needs to achieve the purpose of the solutions of the embodiments of the present application.

Although the present application has been described with reference to preferred embodiments, various modifications can be made and components can be replaced with equivalents without departing from the scope of the present application. In particular, the technical features mentioned in the embodiments can be combined in any manner, provided that there is no structural conflict. The present application is not limited to the specific embodiments disclosed herein, but encompasses all technical solutions falling within the scope of the claims.

## Claims

1. A current imbalance control method, comprising:
obtaining a direct current resistance of a battery set; and
determining, based on direct current resistances of a plurality of battery sets, whether a current imbalance occurs among the plurality of battery sets.

2. The control method according to claim 1, wherein said obtaining the direct current resistance of the battery set comprises:
obtaining a state parameter set of the battery set, the state parameter set comprising at least two state parameters of the battery set;
determining a first direct current resistance of the battery set based on the state parameter set of the battery set and a preset correspondence relationship between a plurality of state parameter sets and a plurality of direct current resistances; and
determining a second direct current resistance of the battery set based on the first direct current resistance of the battery set.

3. The control method according to claim 2, wherein the state parameter set comprises at least two of the following state parameters:
a state of charge of the battery set, a temperature of the battery set, a current of the battery set, a charging and discharging direction of the battery set, a charging and discharging time of the battery set, and a state of health of the battery set.

4. The control method according to claim 2 or 3, wherein said determining the second direct current resistance of the battery set based on the first direct current resistance of the battery set comprises:
determining the first direct current resistance as the second direct current resistance; or
calibrating the first direct current resistance based on a preset calibration coefficient to obtain a calibrated second direct current resistance of the battery set.

5. The control method according to any one of claims 2 to 4, further comprising:
obtaining a state parameter set of the battery set at a target moment after a current moment; and
determining a direct current resistance of the battery set at the target moment based on the state parameter set of the battery set at the target moment and the correspondence relationship.

6. The control method according to claim 1, wherein said obtaining the direct current resistance of the battery set comprises:
obtaining information of a voltage and/or a current of the battery set; and
determining the direct current resistance of the battery set based on the information of the voltage and/or the current.

7. The control method according to claim 6, wherein:
said obtaining the information of the voltage and/or the current of the battery set comprises:
obtaining an open-circuit voltage of the battery set; and
said determining the direct current resistance of the battery set based on the information of the voltage and/or the current comprises:
determining the direct current resistance of the battery set based on the open-circuit voltage of the battery set, the voltage of the battery set, and the current of the battery set.

8. The control method according to claim 7, wherein said obtaining the open-circuit voltage of the battery set comprises:
obtaining a state of charge of the battery set; and
determining the open-circuit voltage of the battery set based on the state of charge of the battery set and a preset correspondence relationship between the open-circuit voltage and the state of charge.

9. The control method according to claim 7 or 8, wherein said determining the direct current resistance of the battery set based on the open-circuit voltage of the battery set, the voltage of the battery set, and the current of the battery set comprises:
determining a voltage difference between the voltage of the battery set and the open-circuit voltage of the battery set;
determining a ratio of the voltage difference to the current of the battery set; and
determining the ratio as the direct current resistance of the battery set.

10. The control method according to claim 6, wherein:
said obtaining the information of the voltage and/or the current of the battery set comprises:
controlling a power conversion system connected to the battery set to charge and discharge the battery set; and
obtaining the information of the voltage and the current of the battery set during the charging and discharging; and
said determining the direct current resistance of the battery set based on the information of the voltage and/or the current comprises:
determining a target direct current resistance of the battery set based on the current of the battery set and a change in the voltage of the battery set within a target duration.

11. The control method according to claim 10, wherein said determining the target direct current resistance of the battery set based on the current of the battery set and the change in the voltage of the battery set within the target duration comprises:
determining a ratio of the change in the voltage of the battery set within the target duration to the current of the battery set as the target direct current resistance of the battery set.

12. The control method according to any one of claims 1 to 11, wherein said determining, based on the differences in the direct current resistances among the plurality of battery sets, whether the current imbalance occurs among the plurality of battery sets comprises:
in a case that a ratio of a direct current resistance of a first battery set to a direct current resistance of a second battery set in the plurality of battery sets is greater than a preset direct current resistance threshold, determining that the current imbalance occurs among the plurality of battery sets, wherein the first battery set is a battery set with a maximum direct current resistance in the plurality of battery sets, and the second battery set is a battery set with a minimum direct current resistance in the plurality of battery sets.

13. The control method according to any one of claims 1 to 12, further comprising:
determining whether an overcurrent occurs in the battery set; and
performing current limiting on the battery set based on a degree of overcurrent of the battery set in a case that the overcurrent occurs in the battery set.

14. The control method according to claim 13, wherein said performing the current limiting on the battery set comprises:
determining an overcurrent value of the battery set, the overcurrent value comprising a current difference between the current of the battery set and an allowable current thereof and/or a current ratio of the current of the battery set to the allowable current thereof; and
adjusting the allowable current of the battery set based on the overcurrent value.

15. The control method according to claim 14, wherein said adjusting the allowable current of the battery set based on the overcurrent value comprises:
adjusting the allowable current of the battery set in a case that the current difference is greater than or equal to a first threshold, and/or the current ratio is greater than or equal to a second threshold.

16. The control method according to claim 15, wherein said adjusting the allowable current of the battery set comprises:
calculating a first product of an allowable current value of a battery set with a minimum allowable current among N battery sets connected in parallel and N, wherein the N battery sets comprise the battery set, N being a positive integer;
calculating a second product of the current difference and a preset coefficient;
calculating a difference between the first product and the second product; and
determining an adjusted allowable current of the battery set, the adjusted allowable current being equal to a ratio of the difference to N.

17. The control method according to any one of claims 13 to 16, wherein said performing the current limiting on the battery set comprises:
determining overcurrent information of the battery set; and
sending overcurrent indication information to an energy management system, wherein the overcurrent indication information comprises the overcurrent information, and the overcurrent indication information is used to request the energy management system to determine whether to perform the current limiting on the battery set.

18. The control method according to claim 17, wherein the overcurrent information is used to indicate an overcurrent level of the battery set, and said determining the overcurrent information of the battery set comprises:
determining the overcurrent level of the battery set based on an overcurrent ratio of the battery set; or
determining the overcurrent level based on the overcurrent ratio and an overcurrent duration of the battery set,
wherein the overcurrent ratio is a ratio of the current of the battery set to the allowable current thereof.

19. The control method according to claim 18, wherein said performing the current limiting on the battery set comprises:
determining current limiting information corresponding to the overcurrent level based on the overcurrent level, wherein the overcurrent indication information further comprises the current limiting information corresponding to the overcurrent level.

20. The control method according to claim 19, wherein the current limiting information comprises a target value of the allowable current of the battery set, and said determining the current limiting information corresponding to the overcurrent level based on the overcurrent level comprises:
determining the target value based on an initial value of the allowable current and a current adjustment ratio corresponding to the overcurrent level, wherein the current adjustment ratio is a ratio of the target value to the initial value of the allowable current.

21. The control method according to any one of claims 13 to 20, wherein said determining whether the overcurrent occurs in the battery set comprises:
determining whether an overcurrent occurs in a plurality of batteries in the battery set; and
determining whether the overcurrent occurs in the battery set in a case that the overcurrent occurs in at least one of the plurality of batteries.

22. The control method according to any one of claims 1 to 21, further comprising:
determining, based on power demand of a power grid, a target battery set configured for charging and discharging with the power grid; and
determining, based on an overcurrent state of the target battery set, an output power of a power control system connected between the power grid and the target battery set.

23. The control method according to claim 22, wherein said determining, based on the power demand of the power grid, the target battery set configured for the charging and discharging with the power grid comprises:
determining, based on the power demand of the power grid, that the target battery set comprises all or a part of a plurality of battery sets, wherein the plurality of battery sets are connected in parallel to the power grid through a plurality of power control systems, respectively.

24. The control method according to any one of claims 1 to 23, further comprising:
obtaining a temperature of a first battery system and a temperature of a second battery system in a plurality of battery systems, wherein the first battery system comprises at least one battery cluster, and the second battery system comprises at least one battery cluster; and
determining a target working mode of a first thermal management assembly and/or a second thermal management assembly based on the temperature of the first battery system and the temperature of the second battery system, wherein the first thermal management assembly is configured to control the temperature of the first battery system, and the second thermal management assembly is configured to control the temperature of the second battery system.

25. The control method according to any one of claims 1 to 24, wherein the battery set is a battery cluster or an electrical cabinet, or the battery set is a container, wherein:
the container comprises a plurality of electrical cabinets connected in series and/or in parallel; and
the battery cluster or the electrical cabinet comprises a plurality of electrical boxes connected in series and/or in parallel, and the electrical box comprises a plurality of battery cells connected in series and/or in parallel.

26. A current imbalance control apparatus, comprising:
a detection module, configured to obtain a direct current resistance of a battery set; and
a processing module, configured to determine, based on direct current resistances of a plurality of battery sets, whether a current imbalance occurs among the plurality of battery sets.

27. A current imbalance control device, comprising a processor and a memory, wherein the memory is configured to store instructions, and the processor is configured to execute the instructions to implement the current imbalance control method according to any one of claims 1 to 25.

28. An energy storage system, comprising:
a plurality of battery sets connected in parallel; and
the current imbalance control device according to claim 27.
